# EUROPEAN PATENT APPLICATION

(11) **EP 4 783 797 A1**
(43) Date of publication of application: **29.07.2026**
(21) Application number: 26150679.4
(22) Date of filing: 07.01.2026
(51) Int. Cl.: H10K 50/11, H10K 50/19, H10K 59/32

(54) **LIGHT-EMITTING DEVICE, DISPLAY DEVICE, AND ELECTRONIC DEVICE**

(30) Priority: 24.01.2025 KR 20250011886
(71) Applicant: Samsung Display Co., Ltd., Yongin-si, Gyeonggi-do 17113 (KR)
(72) Inventor: HAN, Minju, 17113 Yongin-si (KR); CHU, Changwoong, 17113 Yongin-si (KR); LEE, Dongchan, 17113 Yongin-si (KR); JUNG, Jinsoo, 17113 Yongin-si (KR); HUR, Jaeweon, 17113 Yongin-si (KR)
(74) Representative: Marks & Clerk LLP

(57) **Abstract**

A light-emitting device includes a first electrode, a second electrode facing the first electrode, and an interlayer between the first electrode and the second electrode, wherein the interlayer includes a first stack, a second stack, and a charge-generation layer between the first stack and the second stack, the first stack includes a first emission layer and a first hole transport region, the second stack includes a second emission layer and a second hole transport region, the first emission layer includes a first hole-transporting host, a first electron-transporting host, a first sensitizer, and a first thermally activated delayed fluorescence emitter, the second emission layer includes a second hole-transporting host, a second electron-transporting host, a second sensitizer, and a second thermally activated delayed fluorescence emitter, and the light-emitting device satisfies at least one of Condition 1 and Condition 2. Descriptions of Condition 1 and Condition 2 are provided in the detailed description.

## Description

### BACKGROUND

### 1. Field

One or more embodiments of the present disclosure relate to a light-emitting device, a display device including the light-emitting device, and an electronic device including the display device.

### 2. Description of the Related Art

Among various types of light-emitting devices, self-emissive devices-such as organic light-emitting devices (OLEDs)-are notable for their relatively wide viewing angles, high contrast ratios, fast response times, and/or favorable characteristics in terms of luminance, driving voltage, and/or response speed.

A light-emitting device may include a first electrode, followed sequentially by a hole transport region, an emission layer, an electron transport region, and a second electrode. Holes injected from the first electrode may move toward the emission layer through the hole transport region, while electrons injected from the second electrode may move toward the emission layer through the electron transport region. These carriers, namely the holes and electrons, may recombine in the emission layer to produce excitons. When these excitons decay (transition) from an excited state to a ground state, light may be generated.

### SUMMARY

One or more aspects of embodiments of the present disclosure are directed toward a light-emitting device that has low driving voltage, high luminescence efficiency, high power efficiency and/or long lifespan, and a high-quality display device and/or electronic device using the same.

Additional aspects will be set forth in part in the description which follows and, in part, will be apparent from the description, or may be learned by practice of the presented embodiments of the disclosure.

According to one or more embodiments of the present disclosure, a light-emitting device includes
a first electrode,
a second electrode opposite to (e.g., facing) the first electrode, and
an interlayer between the first electrode and the second electrode, wherein
the interlayer includes a first stack, a second stack, and a charge-generation layer,
the charge-generation layer is positioned between the first stack and the second stack,
the first stack includes a first emission layer and a first hole transport region,
the first hole transport region is arranged between the first emission layer and the first electrode,
the second stack includes a second emission layer and a second hole transport region,
the second emission layer is positioned between the second hole transport region and the second electrode,
the first emission layer includes a first hole-transporting host, a first electron-transporting host, a first sensitizer, and a first thermally activated delayed fluorescence emitter,
the second emission layer includes a second hole-transporting host, a second electron-transporting host, a second sensitizer, and a second thermally activated delayed fluorescence emitter, and
at least one of Condition 1 and Condition 2 is satisfied:

### Condition 1

In the first emission layer, a weight of the first hole-transporting host is greater than a weight of the first electron-transporting host,
the first hole transport region includes a first hole transport layer in direct contact with the first emission layer,
the first hole transport layer includes a first hole-transporting (HT) material,
the first HT material is different from the first hole-transporting host, and
an absolute value of a difference between a highest occupied molecular orbital (HOMO) energy level of the first HT material and a HOMO energy level of the first hole-transporting host is about 0.1 eV to about 0.35 eV;

### Condition 2

In the second emission layer, a weight of the second hole-transporting host is greater than a weight of the second electron-transporting host,
the second hole transport region includes a second hole transport layer in direct contact with the second emission layer,
the second hole transport layer includes a second HT material,
the second HT material is different from the second hole-transporting host, and
an absolute value of a difference between a HOMO energy level of the second HT material and a HOMO energy level of the second hole-transporting host is about 0.1 eV to about 0.35 eV.

According to one or more embodiments of the present disclosure, a display device comprises:
a substrate having a first region, a second region, and a third region which are spaced from one another;
a first light-emitting device comprising a first-1 electrode positioned on the substrate in the first region, a first-2 electrode opposite to the first-1 electrode, and a first interlayer between the first-1 electrode and the first-2 electrode;
a second light-emitting device comprising a second-1 electrode positioned on the substrate in the second region, a second-2 electrode opposite to the second-1 electrode, and a second interlayer between the second-1 electrode and the second-2 electrode; and
a third light-emitting device comprising a third-1 electrode positioned on the substrate in the third region, a third-2 electrode opposite to the third-1 electrode, and a third interlayer between the third-1 electrode and the third-2 electrode, wherein,
the first interlayer comprises a first-1 stack, a first-2 stack, and a first charge-generation layer,
the second interlayer comprises a second-1 stack, a second-2 stack, and a second charge-generation layer,
the third interlayer comprises a third-1 stack, a third-2 stack, and a third charge-generation layer,
the third charge-generation layer is between the third-1 stack and the third-2 stack,
the third-1 stack comprises a third-1 emission layer and a third-1 hole transport region,
the third-1 hole transport region is between the third-1 emission layer and the third-1 electrode,
the third-2 stack comprises a third-2 emission layer and a third-2 hole transport region,
the third-2 emission layer is between the third-2 hole transport region and the third-2 electrode,
the third-1 emission layer comprises a third-1 hole-transporting host, a third-1 electron-transporting host, a third-1 sensitizer, and a third-1 thermally activated delayed fluorescence emitter,
the third-2 emission layer comprises a third-2 hole-transporting host, a third-2 electron-transporting host, a third-2 sensitizer, and a third-2 thermally activated delayed fluorescence emitter, and
the display device satisfies at least one selected from among Condition 3-1 and Condition 3-2:
   Condition 3-1
      in the third-1 emission layer, a weight of a third-1 hole-transporting host is greater than a weight of the third-1 electron-transporting host,
      the third-1 hole transport region comprises a third-1 hole transport layer that is in direct contact with the third-1 emission layer,
      the third-1 hole transport layer comprises a third-1 HT material,
      the third-1 HT material is different from the third-1 hole-transporting host, and
      an absolute value of a difference between a highest occupied molecular orbital (HOMO) energy level of the third-1 HT material and a HOMO energy level of the third-1 hole-transporting host is 0.1 eV to 0.35 eV; and
   Condition 3-2
      in the third-2 emission layer, a weight of the third-2 hole-transporting host is greater than a weight of the third-2 electron-transporting host,
      the third-2 hole transport region comprises a third-2 hole transport layer in direct contact with the third-2 emission layer,
      the third-2 hole transport layer comprises a third-2 HT material,
      the third-2 HT material is different from the third-2 hole-transporting host, and
      an absolute value of a difference between a HOMO energy level of the third-2 HT material and a HOMO energy level of the third-2 hole-transporting host is 0.1 eV to 0.35 eV.

According to one or more embodiments of the present disclosure, an electronic device includes the light-emitting device, and a processor configured to transmit a signal to the light-emitting device.

At least some of the above and other features of the invention are set out in the claims.

For example, the described light-emitting device architecture, which includes a multi-stack emission structure with a charge-generation layer and engineered hole transport and emission layers, is designed to improve charge balance and exciton formation efficiency. By enhancing the energy level alignment and material composition-particularly through the utilization of distinct hole-transporting materials in a hole-transporting layer and hole-transporting hosts in an emission layer with controlled HOMO energy level differences-these embodiments aim to achieve enhanced device performance. This includes reduced driving voltage, improved power and/or luminous efficiency, and/or extended operational lifetime (also referred to as lifetime). Such advancements contribute to the development of high-quality display devices and electronic devices that demand both visual excellence and long-term reliability.

### BRIEF DESCRIPTION OF DRAWINGS

The accompanying drawings are included to provide a further understanding of the present disclosure and are incorporated in and constitute a part of the present disclosure. The drawings illustrate embodiments of the present disclosure and, together with the description, serve to explain principles of the present disclosure. The above and other aspects, features, and advantages of certain embodiments of the disclosure will be more apparent from the following description taken in conjunction with the accompanying drawings, in which:
FIG. 1 is a schematic view of a light-emitting device according to one or more embodiments of the present disclosure;
FIG. 2 is a diagram showing an example of an interlayer included in the light-emitting device of FIG. 1 according to one or more embodiments of the present disclosure;
FIG. 3 is a diagram showing another example of an interlayer included in the light-emitting device of FIG. 1 according to one or more embodiments of the present disclosure;
FIG. 4 is a diagram showing another example of an interlayer included in the light-emitting device of FIG. 1 according to one or more embodiments of the present disclosure;
FIG. 5 is a schematic diagram illustrating a plurality of light-emitting devices included in a display device according to one or more embodiments of the present disclosure;
FIG. 6 is a cross-sectional view schematically showing a display device according to one or more embodiments of the present disclosure;
FIG. 7 is a cross-sectional view schematically showing a display device according to one or more embodiments of the present disclosure;
FIG. 8 is a block diagram illustrating an electronic device including a display device according to one or more embodiments of the present disclosure;
FIG. 9 is a schematic diagram showing an electronic device according to various embodiments of the present disclosure;
FIG. 10 is a perspective view schematically illustrating an electronic device including a light-emitting device according to one or more embodiments of the present disclosure;
FIG. 11 is a schematic diagram of an exterior of a vehicle as an electronic device including a light-emitting device according to one or more embodiments of the present disclosure; and
FIGS.12A - 12C are each a schematic diagram showing an interior of the vehicle of FIG. 11 according to one or more embodiments of the present disclosure.

### DETAILED DESCRIPTION

Reference will now be made in more detail to one or more embodiments, examples of which are illustrated in the accompanying drawings, wherein like reference numerals refer to like elements throughout the disclosure, and duplicative descriptions thereof may not be provided. In this regard, the presented embodiments may have different forms and should not be construed as being limited to the descriptions set forth herein. Accordingly, the embodiments are merely described in more detail, by referring to the drawings, to explain aspects of the present disclosure. As used herein, the term "and/or" or "or" may include any and all combinations of one or more of the associated listed items. Throughout the disclosure, the expressions such as "at least one of," "one of," and "selected from," when preceding a list of elements, modify the entire list of elements and do not modify the individual elements of the list. For example, "at least one of a, b, and c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof.

In the present disclosure, when it is stated that a certain component (or region, layer, part, and/or the like) is "on," "connected to," or "coupled to" another component (or region, layer, part, and/or the like), such terminology shall be interpreted to refer to that the component (or region, layer, part, and/or the like) may be directly placed, connected, or coupled on another component (or region, layer, part, and/or the like), or alternatively, one or more intermediate components (or region, layer, part, and/or the like) may be arranged between them. In contrast, "directly on," "directly connected to," or "directly coupled to" may refer to that there are no additional layers, films, regions, plates, etc., between a layer, a film, a region, a plate, etc. and the other part. For example, "directly on" may refer to two layers or two members are disposed without utilizing an additional member such as an adhesive member therebetween.

Identical drawing symbols indicate identical or like components. Additionally, in the drawings, proportion, and dimensions (for example, the thickness) of the components may be exaggerated for effective explanation of the technical contents.

"And/or" may include any combination of one or more of the associated constructs that can be defined.

Terms such as "first" and "second" may be employed to describe one or more suitable components; however, such terminology shall not be construed as limiting the components to any particular order, sequence, or hierarchy based solely on the use of these terms. The above terms are used solely to distinguish one component from another. For example, without departing from the scope of the disclosure, the first component could be named the second component, and similarly, the second component could also be named the first component. Singular expressions include plural expressions unless the context clearly indicates otherwise. For example, the singular forms "a," "an," "one," and "the" are intended to include the plural forms as well, unless the context clearly indicates otherwise. Further, the use of "may" when describing embodiments of the present disclosure refers to "one or more embodiments of the present disclosure".

Terms such as "below," "under," "above," "on," and "upper side" are utilized to describe the relational positioning of components depicted in the drawings. The above terms are relative concepts and are explained based on the directions indicated in the drawings.

Unless otherwise defined, all terms used in the present disclosure, including technical and scientific terms, shall have the same meaning as commonly understood by those skilled in the art to which the disclosure pertains. Furthermore, terms that are identical to those commonly defined in standard dictionaries shall be interpreted as having meanings consistent with the context of the relevant technical field and shall not be construed in an overly idealized or excessively (or substantially) formal sense unless expressly defined otherwise in the present disclosure.

The terms "include(s)/including," "comprise(s)/comprising," or "has(have)/having," as used in the disclosure, are intended to indicate the presence of features, numbers, steps, operations, components, parts, or combinations thereof as described in the disclosure. These terms shall be understood not to preclude the possibility of the presence or addition of one or more other features, numbers, steps, operations, components, parts, or combinations thereof. Additionally, the terms "include(s)/including," "comprise(s)/comprising," "have/has/having", or other similar terms include or support the terms "consisting of" and "consisting essentially of," indicating the presence of stated features, numbers, steps, operations, elements, parts, components, and/or groups thereof, without or essentially without the presence of other features, integers, steps, operations, elements, parts, components, and/or groups thereof.

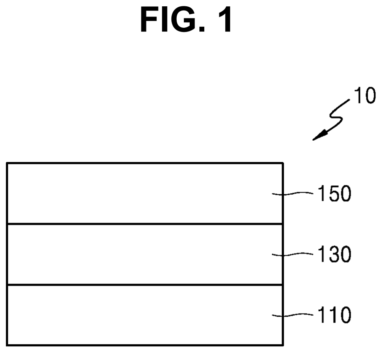

### Description of FIG. 1

FIG. 1 is a schematic view schematically showing a light-emitting device 10 according to one or more embodiments of the present disclosure.

Referring to FIG. 1, the light-emitting device 10 includes a first electrode 110, a second electrode 150 opposite to (e.g., facing) the first electrode 110, and an interlayer 130 between the first electrode 110 and the second electrode 150. The term "interlayer 130" in this disclosure refers to a single and/or multiple layers positioned between a first electrode 110 and a second electrode 150 in a light-emitting device 10.

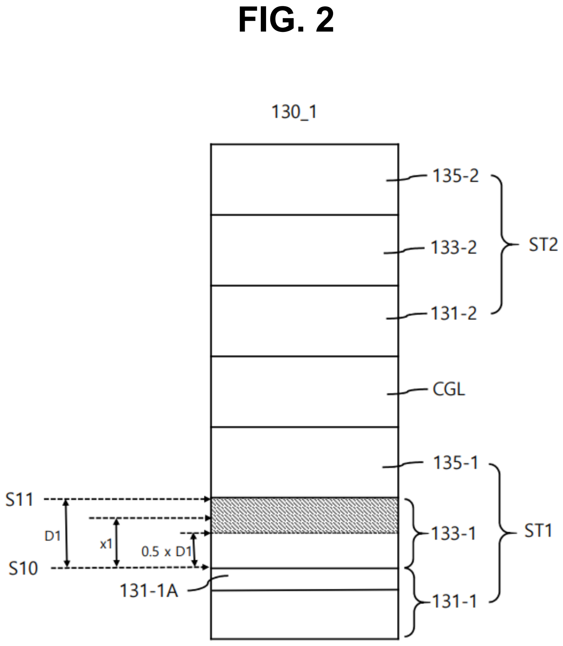

### Description of FIG. 2

FIG. 2 is a diagram schematically showing an interlayer 130_1, which is an example of the interlayer 130 included in the light-emitting device 10 of Fig. 1 according to one or more embodiments, and the interlayer 130_1 satisfies Condition 1.

The interlayer 130_1 includes a first stack ST1, a second stack ST2, and a charge-generation layer CGL. The charge-generation layer CGL is positioned between the first stack ST1 and the second stack ST2.

The charge-generation layer CGL may generate electrons and holes and provide the electrons and the holes to the first stack ST1 and the second stack ST2, respectively, and may include an n-type (kind) charge-generation layer and a p-type (kind) charge-generation layer sequentially arranged from the first electrode 110 (e.g., in the stated order). The light-emitting device 10 including the first stack ST1 and the second stack ST2 may be a tandem light-emitting device.

The first stack ST1 may include a first emission layer 133-1, a first hole transport region 131-1, and a first electron transport region 135-1.

The first hole transport region 131-1 is positioned between the first emission layer 133-1 and the first electrode 110. The first emission layer 133-1 may be positioned between the first electron transport region 135-1 and the first hole transport region 131-1. For example, in one or more embodiments, the first stack ST1 may include the first hole transport region 131-1, the first emission layer 133-1, and the first electron transport region 135-1 which are sequentially stacked from the first electrode 110 in the stated order.

The second stack ST2 may include a second emission layer 133-2, a second hole transport region 131-2, and a second electron transport region 135-2.

The second emission layer 133-2 is positioned between the second hole transport region 131-2 and the second electrode 150. The second electron transport region 135-2 may be positioned between the second emission layer 133-2 and the second electrode 150. For example, in one or more embodiments, the second stack ST2 may include the second hole transport region 131-2, the second emission layer 133-2, and the second electron transport region 135-2 which are sequentially stacked from the first electrode 110 in the stated order.

The first emission layer 133-1 includes a first hole-transporting host, a first electron-transporting host, a first sensitizer, and a first thermally activated delayed fluorescence emitter, and the second emission layer 133-2 includes a second hole-transporting host, a second electron-transporting host, a second sensitizer, and a second thermally activated delayed fluorescence emitter. Formulae of the compounds included in each of the first emission layer 133-1 and the second emission layer 133-2 will be described later.

The first hole-transporting host and the second hole-transporting host may be the same as or different from each other.

The first electron-transporting host and the second electron-transporting host may be the same as or different from each other.

The first sensitizer and the second sensitizer may be the same as or different from each other.

The first thermally activated delayed fluorescence emitter and the second thermally activated delayed fluorescence emitter may be the same as or different from each other.

The interlayer 130_1 satisfies Condition 1:
**Condition 1**
in the first emission layer 133-1, a weight of the first hole-transporting host is greater than a weight of the first electron-transporting host,
the first hole transport region 131-1 includes a first hole transport layer 131-1A that is in direct contact with the first emission layer 133-1,
the first hole transport layer 131-1A includes a first HT material,
the first HT material is different from the first hole-transporting host, and
an absolute value of a difference between a HOMO energy level of the first HT material and a HOMO energy level of the first hole-transporting host is about 0.1 eV to about 0.35 eV.

As in Condition 1, because the first hole transport layer 131-1A including the first HT material is in direct contact with the first emission layer 133-1, the light-emitting device 10 may have excellent or suitable power efficiency and excellent or suitable lifespan characteristics.

In addition, as in Condition 1, because the weight of the first hole-transporting host in the first emission layer 133-1 is greater than the weight of the first electron-transporting host, an emission zone in the first emission layer 133-1 may be formed closer to the first electron transport region 135-1 than to the first hole transport region 131-1. For example, the first emission layer 133-1 may have an exciton concentration profile represented by C1(x1), which is the exciton concentration at a position spaced apart by x1 Angstroms (Å) from an interface S10 between the first emission layer 133-1 and the first hole transport layer 131-1A in the first emission layer 133-1. x1 is a variable satisfying the condition of 0 Å ≤ x1 Å ≤ D1 Å, and D1 is a thickness of the first emission layer 133-1. Therefore, C1(0) is the exciton concentration at an interface S10 between the first emission layer 133-1 and the first hole transport layer 131-1A, and C1(D1) is the exciton concentration at a first surface S11 spaced apart from the interface S10 by the thickness D1 of the first emission layer 133-1 in the first emission layer 133-1. As in Condition 1, because in the first emission layer 133-1, the weight of the first hole-transporting host is greater than the weight of the first electron-transporting host, a maximum value of C1(x1) of the first emission layer 133-1 may exist in a region where x1 satisfies the condition of 0.5 x D1 Å ≤ x1 Å ≤ D1 A in the exciton concentration profile, for example, in the hatched region of the first emission layer 133-1 in FIG. 2. As a result, the emission zone of the first emission layer 133-1 may be formed closer to the first electron transport region 135-1 than to the first hole transport region 131-1. Accordingly, as in Condition 1, even if the first hole transport layer 131-1A including the first HT material is in direct contact with the first emission layer 133-1, the decrease in luminescence efficiency due to exciton quenching in the first emission layer 133-1 may be substantially prevented or reduced, so that the light-emitting device 10 may have an excellent or suitable driving voltage and excellent or suitable luminescence efficiency.

A thickness of the first emission layer 133-1 may be about 250 Å to about 500 Å, or about 300 Å to about 450 Å. When the thickness of the first emission layer 133-1 satisfies the ranges described above, the light-emitting device 10 with improved lifespan characteristics may be manufactured without a substantial increase in driving voltage.

A thickness of the second emission layer 133-2 may be about 250 Å to about 500 Å, or about 300 Å to about 450 Å. When the thickness of the second emission layer 133-2 satisfies the ranges described above, the light-emitting device 10 with improved lifespan characteristics may be manufactured without a substantial increase in driving voltage.

In one or more embodiments, the thickness of the second emission layer 133-2 may be the same as the thickness of the first emission layer 133-1.

In one or more embodiments, the thickness of the second emission layer 133-2 may be greater than the thickness of the first emission layer 133-1. For example, in one or more embodiments, the thickness of the second emission layer 133-2 may be greater than the thickness of the first emission layer 133-1, and a difference between the thickness of the second emission layer 133-2 and the thickness of the first emission layer 133-1 may be 150 Å or less.

The weight of the first hole-transporting host in the first emission layer 133-1 may be about 60 wt% to about 90 wt%, about 65 wt% to about 85 wt%, about 65 wt% to about 80 wt%, or about 65 wt% to about 75 wt%, based on 100 wt% of the sum of the weight of the first hole-transporting host and the weight of the first electron-transporting host.

The weight of the first hole-transporting host in the first emission layer 133-1 may be about 30 wt% to about 80 wt% or about 30 wt% to about 74 wt% based on 100 wt% of the total weight of the first emission layer 133-1, and the weight of the first electron-transporting host in the first emission layer 133-1 may be about 20 wt% to about 60 wt% based on 100 wt% of the total weight of the first emission layer 133-1.

A weight of the first sensitizer in the first emission layer 133-1 may be, based on 100 wt% of the total weight of the first emission layer 133-1, about 5 wt% to about 30 wt%, about 5 wt% to about 25 wt%, about 5 wt% to about 20 wt%, about 5 wt% to about 15 wt%, about 5 wt% to about 13 wt%, about 7 wt% to about 30 wt%, about 7 wt% to about 25 wt%, about 7 wt% to about 20 wt%, about 7 wt% to about 15 wt%, about 7 wt% to about 13 wt%, about 10 wt% to about 30 wt%, about 10 wt% to about 25 wt%, about 10 wt% to about 20 wt%, about 10 wt% to about 15 wt%, about 10 wt% to about 13 wt%, about 13 wt% to about 15 wt%, or about 11 wt% to about 14 wt%.

A weight of the first thermally activated delayed fluorescence emitter in the first emission layer 133-1 may be, based on 100 wt% of the total weight of the first emission layer 133-1, about 0.5 wt% to about 10 wt%, about 0.5 wt% to about 5 wt%, about 0.5 wt% to about 3 wt%, about 0.5 wt% to about 1.5 wt%, about 1.0 wt% to about 10 wt%, about 1.0 wt% to about 5 wt%, about 1.0 wt% to about 3 wt%, about 1.0 wt% to about 1.5 wt%, about 1.5 wt% to about 3 wt%, or about 1.2 wt% to about 1.7 wt%.

A weight of the second hole-transporting host in the second emission layer 133-2 may be about 60 wt% to about 90 wt%, about 65 wt% to about 85 wt%, about 65 wt% to about 80 wt%, or about 65 wt% to about 75 wt%, based on 100 wt% of the sum of the weight of the second hole-transporting host and a weight of the second electron-transporting host.

The weight of the second hole-transporting host in the second emission layer 133-2 may be about 30 wt% to about 80 wt% based on 100 wt% of the total weight of the second emission layer 133-2, and the weight of the second electron-transporting host in the second emission layer 133-2 may be about 20 wt% to about 60 wt% based on 100 wt% of the total weight of the second emission layer 133-2.

A weight of the second sensitizer in the second emission layer 133-2 is, based on 100 wt% of the total weight of the second emission layer 133-2, about 5 wt% to about 30 wt%, about 5 wt% to about 25 wt%, about 5 wt% to about 20 wt%, about 5 wt% to about 15 wt%, about 5 wt% to about 13 wt%, about 7 wt% to about 30 wt%, about 7 wt% to about 25 wt%, about 7 wt% to about 20 wt%, about 7 wt% to about 15 wt%, about 7 wt% to about 13 wt%, about 10 wt% to about 30 wt%, about 10 wt% to about 25 wt%, about 10 wt% to about 20 wt%, about 10 wt% to about 15 wt%, about 10 wt% to about 13 wt%, about 13 wt% to about 15 wt%, or about 11 wt% to about 14 wt%.

A weight of the second thermally activated delayed fluorescence emitter in the second emission layer 133-2 may be, based on 100 wt% of the total weight of the second emission layer 133-2, about 0.5 wt% to about 10 wt%, about 0.5 wt% to about 5 wt%, about 0.5 wt% to about 3 wt%, about 0.5 wt% to about 1.5 wt%, about 1.0 wt% to about 10 wt%, about 1.0 wt% to about 5 wt%, about 1.0 wt% to about 3 wt%, about 1.0 wt% to about 1.5 wt%, about 1.5 wt% to about 3 wt%, or about 1.2 wt% to about 1.7 wt%.

In one or more embodiments, each of the first hole-transporting host of the first emission layer 133-1 and the second hole-transporting host of the second emission layer 133-2 may be an amine-free compound.

The first hole-transporting host of the first emission layer 133-1 and the first HT material of the first hole transport layer 131-1A may be selected from among compounds that satisfy the absolute value range of the HOMO energy level difference in Condition 1. For example, in one or more embodiments, the first hole-transporting host of the first emission layer 133-1 and the first HT material of the first hole transport layer 131-1A may be selected from among compounds that satisfy the absolute value range of the HOMO energy level difference in Condition 1, wherein the first hole-transporting host is an amine-free compound, and the first HT material is an amine-containing compound (for example, selected from among a compound represented by Formula 201, a compound represented by Formula 202, Compounds HT1 to HT46, 4,4',4"-[tris(3-methylphenyl)phenylamino] triphenylamine (m-MTDATA), 4,4',4"-tris(N,N-diphenylamino)triphenylamine (TDATA), 4,4',4"-tris[N-(2-naphthyl)-N-phenylamino]-triphenylamine (2-TNATA), N,N'-di(naphthalen-1-yl)-N,N'-diphenyl-benzidine (NPB(NPD)), β-NPB, N,N'-bis(3-methylphenyl)-N,N'-diphenyl-[1,1'-biphenyl]-4,4'-diamine (TPD), Spiro-TPD, Spiro-NPB, methylated-NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), and/or the like, which are all described herein).

According to one or more embodiments, the absolute value of the difference between the HOMO energy level of the first HT material and the HOMO energy level of the first hole-transporting host in Condition 1 is about 0.1 eV to about 0.35 eV, for example, about 0.1 eV to about 0.30 eV, about 0.1 eV to about 0.25 eV, about 0.1 eV to about 0.20 eV, about 0.15 eV to about 0.35 eV, about 0.15 eV to about 0.30 eV, about 0.15 eV to about 0.25 eV, or about 0.15 eV to about 0.20 eV.

In one or more embodiments, the HOMO energy level of the first HT material in the Condition 1 may be greater than the HOMO energy level of the first hole-transporting host.

In one or more embodiments, the HOMO energy level of the first HT material in Condition 1 may be about -4.9 eV to about -5.5 eV, about -4.9 eV to about -5.3 eV, about -5.1 eV to about -5.5 eV, or about -5.1 eV to about -5.3 eV.

In one or more embodiments, the HOMO energy level of the first hole-transporting host may be about -5.1 eV to about -5.7 eV, or about -5.3 eV to about -5.7 eV.

Each of the first sensitizer of the first emission layer 133-1 and the second sensitizer of the second emission layer 133-2 may be an organometallic compound including platinum. For example, in one or more embodiments, each of the first sensitizer and the second sensitizer may be an organometallic compound including platinum and a tetradentate ligand bonded to the platinum, and the tetradentate ligand may include a carbene moiety bonded to the platinum.

Each of the first thermally activated delayed fluorescence emitter of the first emission layer 133-1 and the second thermally activated delayed fluorescence emitter of the second emission layer 133-2 may be a multiple resonance thermally activated delayed fluorescence emitter containing at least one boron.

A description of each layer of the first stack ST1 and the second stack ST2 will be provided later.

Each of a first light emitted from the first emission layer 133-1 of the first stack ST1 and a second light emitted from the second emission layer 133-2 of the second stack ST2 may be blue light, for example, blue light having an emission peak wavelength range of about 440 nm to about 490 nm.

In one or more embodiments, an absolute value of a difference between the emission peak wavelength of the first light emitted from the first emission layer 133-1 of the first stack ST1 and the emission peak wavelength of the second light emitted from the second emission layer 133-2 of the second stack ST2 may be about 0 nm to about 20 nm.

In one or more embodiments, the mixed light of the first light and the second light may not be white light.

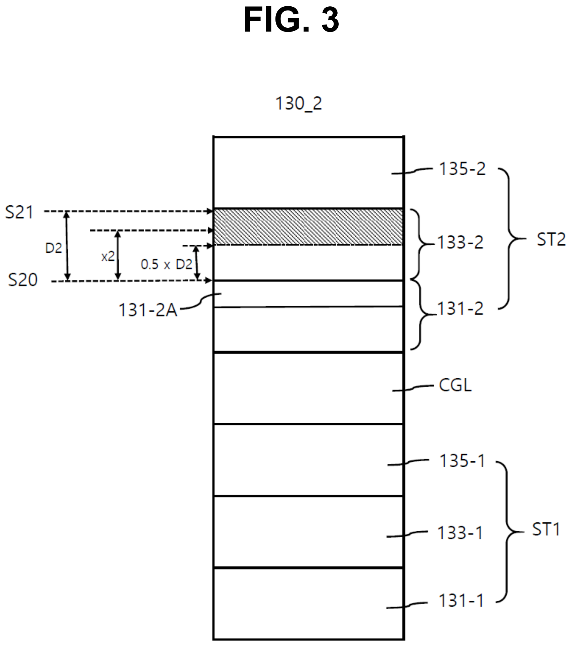

### Description For FIG. 3

FIG. 3 is a diagram schematically showing an interlayer 130_2, which is another example of the interlayer 130 included in the light-emitting device 10 of Fig. 1 according to one or more embodiments, and the interlayer 130_2 satisfies Condition 2.

A description of the first stack ST1 in the interlayer 130_2 of FIG. 3 incorporates the description of the first stack ST1 in the interlayer 130_1 of FIG. 2, excluding the description regarding Condition 1.

A description of a charge-generation layer CGL in the interlayer 130_2 of FIG. 3 incorporates the description of the charge-generation layer CGL in the interlayer 130_1 of FIG. 2.

A description of the second stack ST2 in the interlayer 130_2 of FIG. 3 incorporates the description of the second stack ST2 in the interlayer 130_1 of FIG. 2, except for the description regarding Condition 2.

The interlayer 130_2 satisfies Condition 2:
**Condition 2**
In the second emission layer 133-2, a weight of the second hole-transporting host is greater than a weight of the second electron-transporting host,
the second hole transport region 131-2 includes a second hole transport layer 131-2A in direct contact with the second emission layer 133-2,
the second hole transport layer 131-2A includes a second HT material,
the second HT material is different from the second hole-transporting host, and
an absolute value of a difference between a HOMO energy level of the second HT material and a HOMO energy level of the second hole-transporting host is about 0.1 eV to about 0.35 eV.

As in Condition 2, because the second hole transport layer 131-2A including the second HT material is in direct contact with the second emission layer 133-2, the light-emitting device 10 may have excellent or suitable power efficiency and excellent or suitable lifespan characteristics.

In addition, as in Condition 2, because the weight of the second hole-transporting host in the second emission layer 133-2 is greater than the weight of the second electron-transporting host, an emission zone in the second emission layer 133-2 may be formed closer to the second electron transport region 135-2 than to the second hole transport region 131-2. For example, the second emission layer 133-2 may have an exciton concentration profile represented by C2(x2), which is the exciton concentration at a position spaced apart by x2 Å from an interface S20 between the second emission layer 133-2 and the second hole transport layer 131-2A in the second emission layer 133-2. x2 is a variable satisfying the condition of 0 Å ≤ x2 Å ≤ D2 Å, and D2 is a thickness of the second emission layer 133-2. Therefore, C2(0) is the exciton concentration at an interface S20 between the second emission layer 133-2 and the second hole transport layer 131-2A, and C2(D2) is the exciton concentration at a second surface S21 spaced apart from the interface S20 by a thickness D2 of the second emission layer 133-2 in the second emission layer 133-2. As in Condition 2, because the weight of the second hole-transporting host in the second emission layer 133-2 is greater than the weight of the second electron-transporting host, a maximum value of C2(x2) of the second emission layer 133-2 may exist in a region where x2 satisfies the condition of 0.5 x D2 Å ≤ x2 Å ≤ D2 Å in the exciton concentration profile, for example, in the hatched region of the second emission layer 133-2 in FIG. 3. As a result, the emission zone of the second emission layer 133-2 may be formed closer to the second electron transport region 135-2 than to the second hole transport region 131-2. Accordingly, as in Condition 2, even if the second hole transport layer 131-2A including the second HT material is in direct contact with the second emission layer 133-2, a decrease in luminescence efficiency due to exciton quenching in the second emission layer 133-2 may be substantially prevented or reduced, so that the light-emitting device 10 may have an excellent or suitable driving voltage and excellent or suitable luminescence efficiency.

The second hole-transporting host of the second emission layer 133-2 and the second HT material of the second hole transport layer 131-2A may be selected from among compounds that satisfy the absolute value range of the HOMO energy level difference in Condition 2. For example, in one or more embodiments, the second hole-transporting host of the second emission layer 133-2 and the second HT material of the second hole transport layer 131-2A may be selected from among compounds that satisfy the absolute value range of the HOMO energy level difference in Condition 2, wherein the second hole-transporting host is an amine-free compound, and the second HT material is an amine-containing compound (for example, selected from among a compound represented by Formula 201, a compound represented by Formula 202, Compounds HT1 to HT46, m-MTDATA, TDATA, 2-TNATA, NPB(NPD), β-NPB, TPD, Spiro-TPD, Spiro-NPB, methylated-NPB, TAPC, HMTPD, TCTA, and/or the like, which are all described herein).

According to one or more embodiments, the absolute value of the difference between the HOMO energy level of the second HT material and the HOMO energy level of the second hole-transporting host in Condition 2 is about 0.1 eV to about 0.35 eV, for example, about 0.1 eV to about 0.30 eV, about 0.1 eV to about 0.25 eV, about 0.1 eV to about 0.20 eV, about 0.15 eV to about 0.35 eV, about 0.15 eV to about 0.30 eV, about 0.15 eV to about 0.25 eV, or about 0.15 eV to about 0.20 eV.

In one or more embodiments, the HOMO energy level of the second HT material in Condition 2 may be greater than the HOMO energy level of the second hole-transporting host.

In one or more embodiments, the HOMO energy level of the second HT material in Condition 2 may be about -4.9 eV to about -5.5 eV, about -4.9 eV to about - 5.3 eV, about -5.1 eV to about -5.5 eV, or about -5.1 eV to about -5.3 eV.

In one or more embodiments, the HOMO energy level of the second hole-transporting host may be about -5.1 eV to about -5.7 eV, or about -5.3 eV to about -5.7 eV.

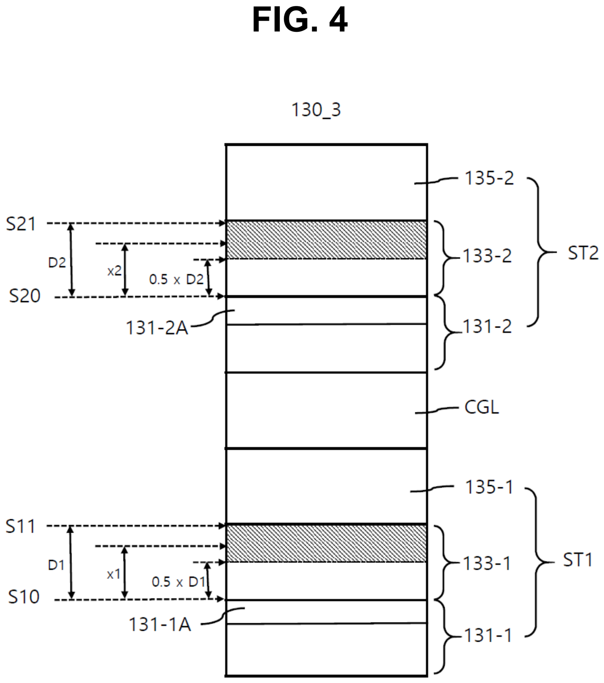

### Description of FIG. 4

FIG. 4 is a diagram schematically showing an interlayer 130_3, which is another example of the interlayer 130 included in the light-emitting device 10 of Fig. 1 according to one or more embodiments, and the interlayer 130_3 satisfies both (e.g., simultaneously) Condition 1 and Condition 2.

A description of the first stack ST1 in the interlayer 130_3 of FIG. 4 incorporates the description of the first stack ST1 in the interlayer 130_1 of FIG. 2.

A description of a charge-generation layer CGL in the interlayer 130_3 of FIG. 4 incorporates the description of the charge-generation layer CGL in the interlayer 130_1 of FIG. 2.

A description of the second stack ST2 in the interlayer 130_3 of FIG. 4 incorporates the description of the second stack ST2 in the interlayer 130_2 of FIG. 3.

### First electrode 110

In FIG. 1, in one or more embodiments, a substrate may be additionally provided and arranged under the first electrode 110 and/or on the second electrode 150. As the substrate, a glass substrate or a plastic substrate may be used. In one or more embodiments, the substrate may be a flexible substrate. For example, the substrate may include a plastic material with excellent or suitable heat resistance and durability, such as polyimide, polyethylene terephthalate (PET), polycarbonate, polyethylene naphthalate, polyarylate (PAR), polyetherimide, or any combination thereof.

The first electrode 110 may be formed by depositing or sputtering a material for forming the first electrode 110 on the substrate. When the first electrode 110 is an anode, a high-work function material that facilitates injection of holes may be used as a material for forming the first electrode 110.

The first electrode 110 may be a reflective electrode, a semi-transmissive electrode, a transflective electrode, or a transmissive electrode. In one or more embodiments, to form the first electrode 110, which is a transparent electrode, indium tin oxide (ITO), indium zinc oxide (IZO), tin oxide (SnO₂), zinc oxide (ZnO), or any combination thereof may be used as the material for forming the first electrode 110. In one or more embodiments, to form the first electrode 110, which is a semi-transmissive electrode or a transflective electrode or a reflective electrode, magnesium (Mg), silver (Ag), aluminium (Al), aluminium-lithium (Al-Li), calcium (Ca), magnesium-indium (Mg-In), magnesium-silver (Mg-Ag), or any combination thereof may be used as the material for forming the first electrode 110.

The first electrode 110 may have a single-layered structure including (e.g., consisting of) a single layer or a multi-layered structure including a plurality of layers. For example, in one or more embodiments, the first electrode 110 may have a three-layer structure of ITO/Ag/ITO.

### Hole transport region

According to one or more embodiments, the first HT material of the first hole transport layer 131-1A of FIGS. 2 and 4 and the second HT material of the second hole transport layer 131-2A of FIGS. 3 and 4 may each be independently selected from among amine-containing compounds, such as a compound represented by Formula 201 and a compound represented by Formula 202, in a range satisfying the HOMO energy level relationship in Condition 1 and/or Condition 2.

A general description of each of the first hole transport region 131-1 and the second hole transport region 131-2 of FIGS. 2 to 4 is as follows.

The hole transport region may have: i) a single-layer structure including (e.g., consisting of) a single layer including (e.g., consisting of) a single material, ii) a single-layer structure including (e.g., consisting of) a single layer including (e.g., consisting of) a plurality of materials that are different from each other, or iii) a multilayer structure including a plurality of layers including a plurality of materials that are different from each other.

The hole transport region may include a hole injection layer, a hole transport layer, an emission auxiliary layer, an electron blocking layer, or any combination thereof.

For example, in one or more embodiments, the hole transport region may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, wherein constituent layers in each structure are sequentially stacked from the first electrode 110 in the stated order.

In one or more embodiments, the hole transport region may include a compound represented by Formula 201, a compound represented by Formula 202, or any combination thereof: 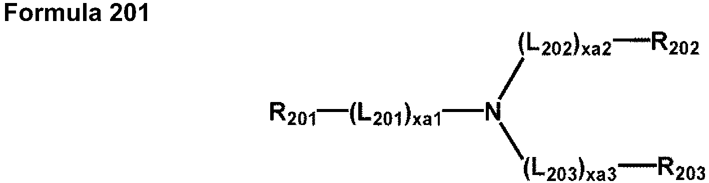 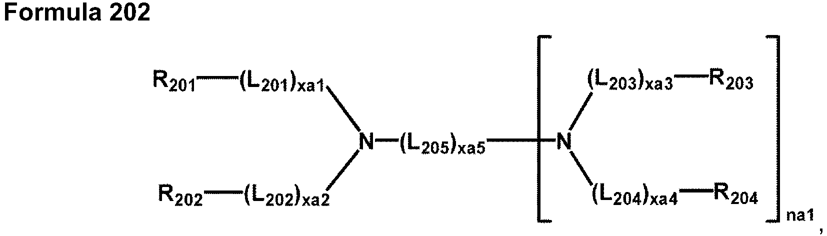
wherein, in Formulae 201 and 202,
L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₃ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may be optionally linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ (for example, a carbazole group, and/or the like) (see, for example, compound HT16, and/or the like),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

In one or more embodiments, each of Formulae 201 and 202 may include at least one selected from among groups represented by Formulae CY201 to CY217: 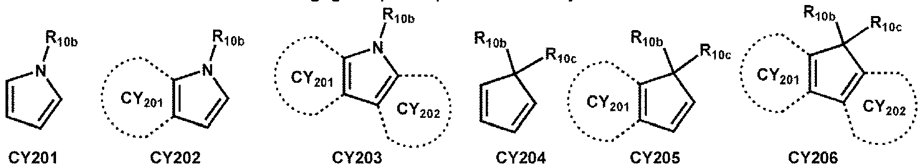 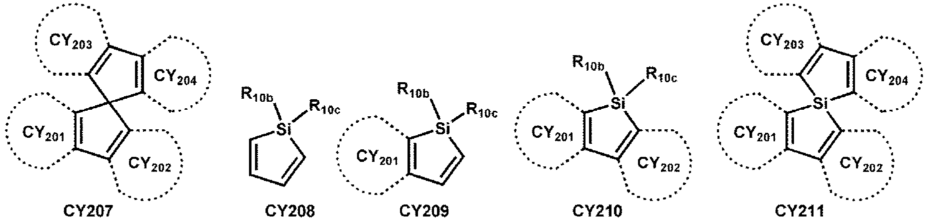 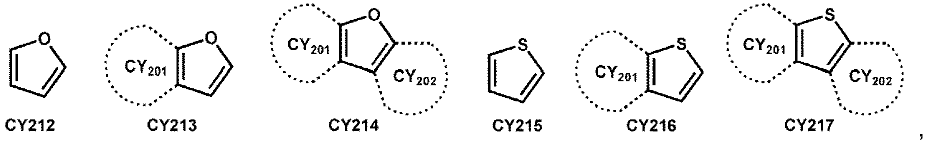 wherein, in Formulae CY201 to CY217, R_{10b} and R_{10c} are each the same as described with respect to R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In one or more embodiments, in Formulae CY201 to CY217, ring CY₂₀₁ to ring CY₂₀₄ may each independently be a benzene group, a naphthalene group, a phenanthrene group, or an anthracene group.

In one or more embodiments, each of Formulae 201 and 202 may include at least one selected from among the groups represented by Formulae CY201 to CY203.

In one or more embodiments, Formula 201 may include at least one selected from among the groups represented by Formulae CY201 to CY203 and at least one selected from among the groups represented by Formulae CY204 to CY217.

In one or more embodiments, in Formula 201, xa1 may be 1, R₂₀₁ may be a group represented by any one selected from among Formulae CY201 to CY203, xa2 may be 0, and R₂₀₂ may be a group represented by any one selected from among Formulae CY204 to CY207.

In one or more embodiments, each of Formulae 201 and 202 may not include (e.g., may exclude) any of the groups represented by Formulae CY201 to CY203.

In one or more embodiments, Formulae 201 and 202 may each not include any of the groups represented by Formulae CY201 to CY203, and may include at least one selected from among the groups represented by Formulae CY204 to CY217.

In one or more embodiments, each of Formulae 201 and 202 may not include (e.g., may exclude) any of the groups represented by Formulae CY201 to CY217.

In one or more embodiments, the hole transport region may include one of (e.g., selected from among) Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or a combination thereof:

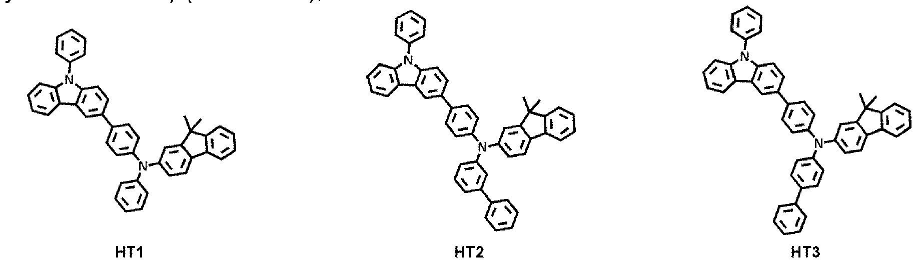

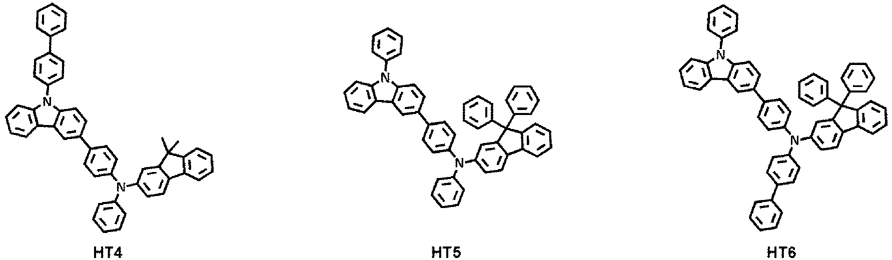

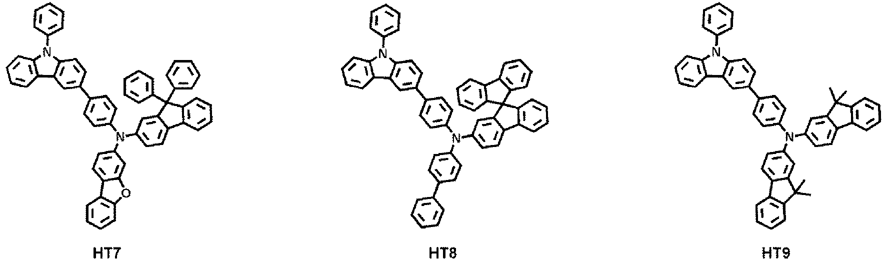

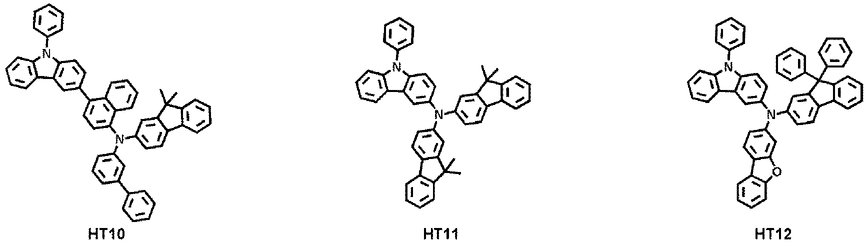

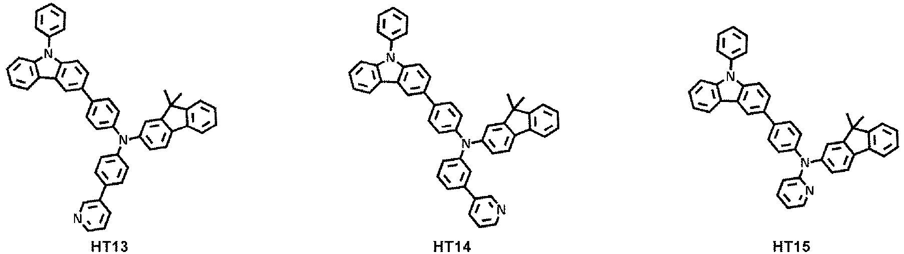

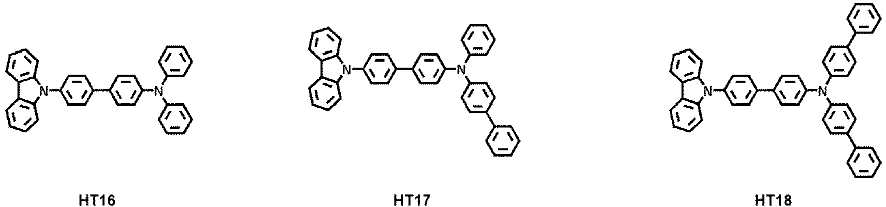

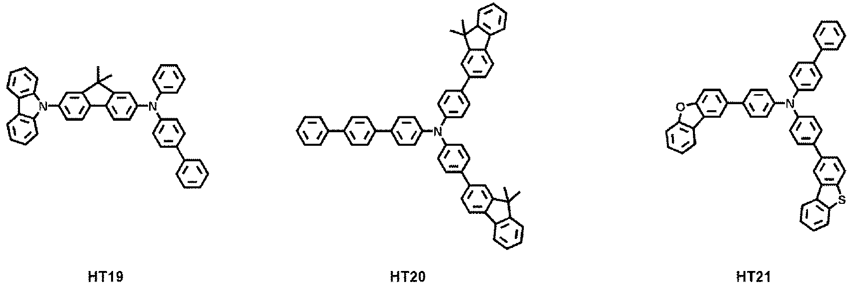

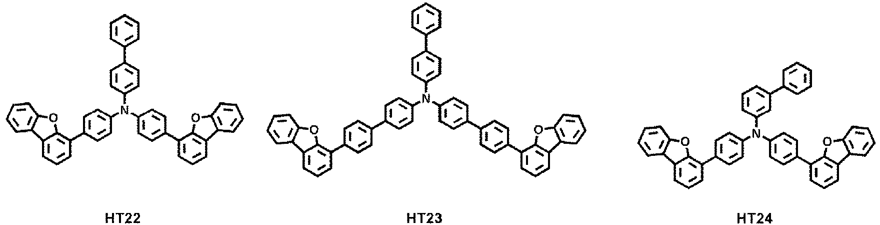

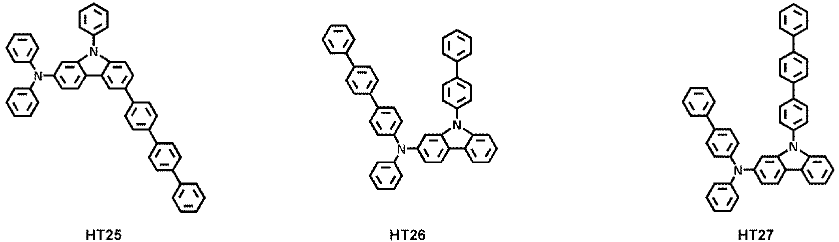

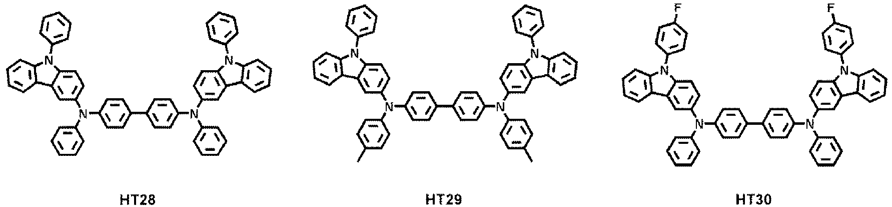

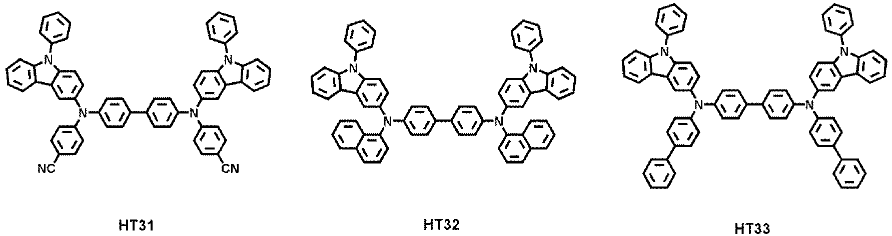

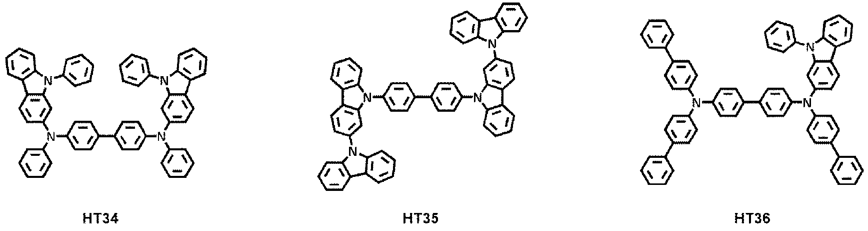

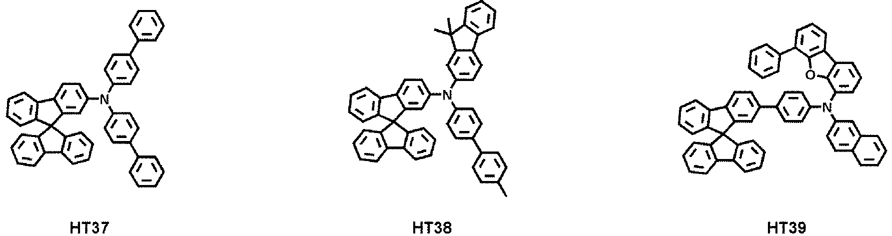

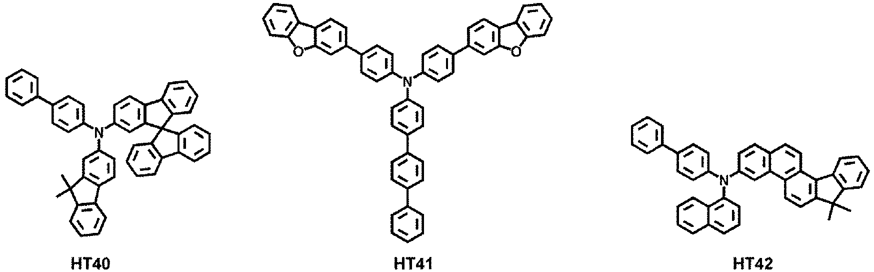

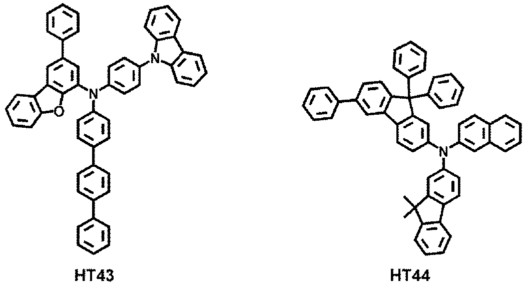

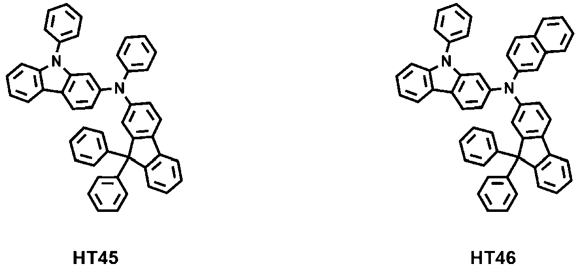

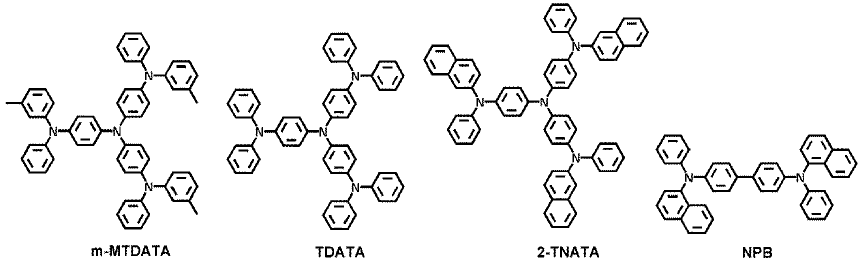

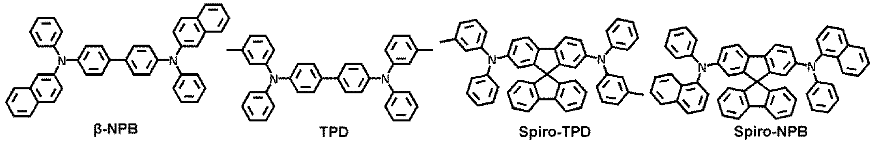

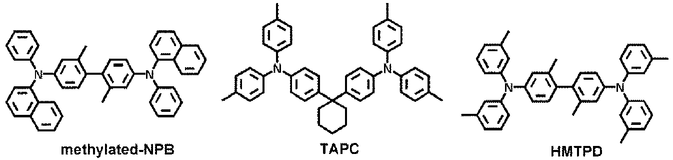

A thickness of the hole transport region may be about 50 Å to about 10,000 Å, for example, about 100 Å to about 4,000 Å. When the hole transport region includes a hole injection layer, a hole transport layer, or any combination thereof, a thickness of the hole injection layer may be about 100 Å to about 9,000 Å, for example, about 100 Å to about 1,000 Å, and a thickness of the hole transport layer may be about 50 Å to about 2,000 Å, for example, about 100 Å to about 1,500 Å. When the thicknesses of the hole transport region, the hole injection layer, and the hole transport layer are in the respective ranges described above, satisfactory hole transporting characteristics may be obtained without a substantial increase in driving voltage.

The emission auxiliary layer may serve to increase light-emission efficiency by compensating for an optical resonance distance according to the wavelength of light emitted by the emission layer. The electron blocking layer may serve to prevent or reduce electron leakage from the emission layer to the hole transport region. Materials that may be included in the hole transport region may be included in the emission auxiliary layer and the electron blocking layer. In one or more embodiments, the emission auxiliary layer may include a hole-transporting host as described herein.

In one or more embodiments, the hole transport region may further include, in addition to one or more of these aforementioned materials, a charge-generation material for the improvement of conductive properties. The charge-generation material may be uniformly (e.g., substantially uniformly) or non-uniformly dispersed in the hole transport region, for example, in the form of a single layer including (e.g., consisting of) a charge-generation material.

The charge-generation material may be, for example, a p-dopant.

For example, the p-dopant may have a lowest unoccupied molecular orbital (LUMO) energy level of about -3.5 eV or less.

In one or more embodiments, the p-dopant may include a quinone derivative, a cyano group-containing compound, a compound including an element EL1 and an element EL2, or any combination thereof.

Non-limiting examples of the quinone derivative may include tetracyanoquinodimethane (TCNQ) and 2,3,5,6-tetrafluoro-7,7,8,8-tetracyanoquinodimethane (F4-TCNQ).

Non-limiting examples of the cyano group-containing compound may include dipyrazino[2,3-f: 2',3'-h] quinoxaline-2,3,6,7,10,11-hexacarbonitrile (HAT-CN) and a compound represented by Formula 221.

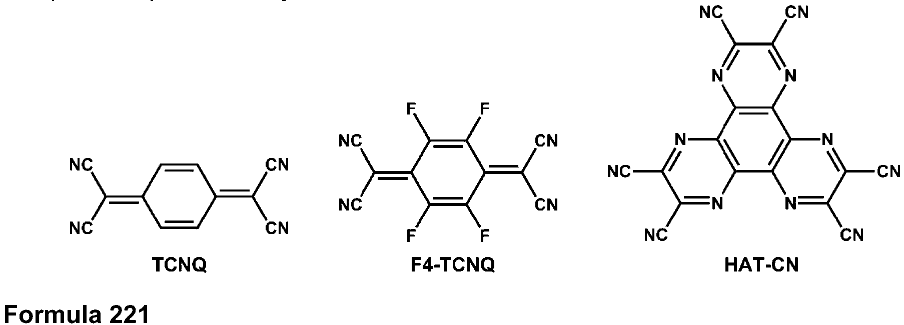

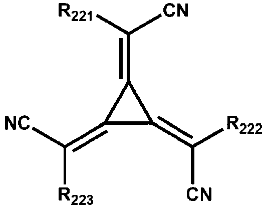

In Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one selected from among R₂₂₁ to R₂₂₃ may each independently be a C₃-C₆₀ carbocyclic group or a C₁-C₆₀ heterocyclic group, each substituted with: a cyano group; -F; -Cl; -Br; -I; a C₁-C₂₀ alkyl group substituted with a cyano group, -F, -Cl, -Br, - I, or any combination thereof; or any combination thereof.

In the compound including the element EL1 and the element EL2, the element EL1 may be a metal, a metalloid, or a combination thereof, and the element EL2 may be a non-metal, a metalloid, or a combination thereof.

Non-limiting examples of the metals are alkali metals (for example, lithium (Li), sodium (Na), potassium (K), rubidium (Rb), cesium (Cs), and/or the like); alkaline earth metals (for example, beryllium (Be), magnesium (Mg), calcium (Ca), strontium (Sr), barium (Ba), and/or the like); transition metals (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au)), and/or the like); post-transition metals (for example, zinc (Zn), indium (In), tin (Sn), and/or the like); lanthanide metals (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), and/or the like); and/or the like.

Non-limiting examples of the metalloids are silicon (Si), antimony (Sb), tellurium (Te), and/or the like.

Non-limiting examples of the non-metals are oxygen (O), halogens (for example, F, Cl, Br, I), and/or the like.

Non-limiting examples of the compound including the element EL1 and the element EL2 may include a metal oxide, a metal halide, for example, a metal fluoride, a metal chloride, a metal bromide, a metal iodide, and/or the like, a metalloid halide, for example, a metalloid fluoride, a metalloid chloride, a metalloid bromide, a metalloid iodide, and/or the like, a metal telluride, and/or any combination thereof.

Non-limiting examples of the metal oxides are tungsten oxides (for example, WO, W₂O₃, WO₂, WO₃, W₂O₅, and/or the like), vanadium oxides (for example, VO, V₂O₃, VO₂, V₂O₅, and/or the like), molybdenum oxides (for example, MoO, Mo₂O₃, MoO₂, MoO₃, Mo₂O₅, and/or the like), rhenium oxides (for example, ReO₃, and/or the like), and/or the like.

Non-limiting examples of the metal halide are alkali metal halides, alkaline earth metal halides, transition metal halides, post-transition metal halides, and/or lanthanide metal halides.

Non-limiting examples of the alkali metal halide are LiF, NaF, KF, RbF, CsF, LiCl, NaCl, KCI, RbCl, CsCl, LiBr, NaBr, KBr, RbBr, CsBr, Lil, Nal, Kl, Rbl, and/or Csl.

Non-limiting examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, and/or BaI₂.

Non-limiting examples of the transition metal halides are titanium halides (for example, TiF₄, TiCl₄, TiBr₄, TiI₄, and/or the like), zirconium halides (for example, ZrF₄, ZrCl₄, ZrBr₄, ZrI₄, and/or the like), hafnium halides (for example, HfF₄, HfCl₄, HfBr₄, HfI₄, and/or the like), vanadium halides (for example, VF₃, VCl₃, VBr₃, VI₃, and/or the like), niobium halides (for example, NbF₃, NbCl₃, NbBr₃, NbI₃, and/or the like), tantalum halides (for example, TaF₃, TaCl₃, TaBr₃, TaI₃, and/or the like), chromium halides (for example, CrF₃, CrCl₃, CrBr₃, CrI₃, and/or the like), molybdenum halides (for example, MoF₃, MoCl₃, MoBr₃, MoI₃, and/or the like), tungsten halides (for example, WF₃, WCl₃, WBr₃, WI₃, and/or the like), manganese halides (for example, MnF₂, MnCl₂, MnBr₂, MnI₂, and/or the like), technetium halides (for example, TcF₂, TcCl₂, TcBr₂, TcI₂, and/or the like), rhenium halides (for example, ReF₂, ReCl₂, ReBr₂, ReI₂, and/or the like), iron(II) halides (for example, FeF₂, FeCl₂, FeBr₂, FeI₂, and/or the like), ruthenium halides (for example, RuF₂, RuCl₂, RuBr₂, RuI₂, and/or the like), osmium halides (for example, OsF₂, OsCl₂, OsBr₂, OsI₂, and/or the like), cobalt halides (for example, CoF₂, CoCl₂, CoBr₂, CoI₂, and/or the like), rhodium halides (for example, RhF₂, RhCl₂, RhBr₂, RhI₂, and/or the like), iridium halides (for example, IrF₂, IrCl₂, IrBr₂, IrI₂, and/or the like), nickel halides (for example, NiF₂, NiCl₂, NiBr₂, NiI₂, and/or the like), palladium halides (for example, PdF₂, PdCl₂, PdBr₂, PdI₂, and/or the like), platinum halides (for example, PtF₂, PtCl₂, PtBr₂, PtI₂, and/or the like), copper(I) halides (for example, CuF, CuCl, CuBr, Cul, and/or the like), silver halides (for example, AgF, AgCl, AgBr, Agl, and/or the like), gold halides (for example, AuF, AuCl, AuBr, Aul, and/or the like), and/or the like.

Non-limiting examples of the transition metal halides are zinc halides (for example, ZnF₂, ZnCl₂, ZnBr₂, ZnI₂, and/or the like), indium halides (for example, InI₃, and/or the like), tin halides (for example, SnI₂, and/or the like), and/or the like.

Non-limiting examples of the lanthanide metal halides are YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, SmI₃, and/or the like.

Non-limiting examples of the metalloid halides are antimony halides (for example, SbCl₅, and/or the like).

Non-limiting examples of the metal tellurides are alkali metal tellurides (for example, Li₂Te, Na₂Te, K₂Te, Rb₂Te, Cs₂Te, and/or the like), alkaline earth metal tellurides (for example, BeTe, MgTe, CaTe, SrTe, BaTe, and/or the like), transition metal tellurides (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, and/or the like), post-transition metal tellurides (for example, ZnTe, and/or the like), and/or lanthanide metal tellurides (for example, LaTe, CeTe, PrTe, NdTe, PmTe, EuTe, GdTe, TbTe, DyTe, HoTe, ErTe, TmTe, YbTe, LuTe, and/or the like).

### Explanation of Formula of material for emission layer

Each of the first electron-transporting host of the first emission layer 133-1 and the second electron-transporting host of the second emission layer 133-2 may be independently a second compound including at least one π electron-deficient nitrogen-containing C₁-C₆₀ heterocyclic group. In one or more embodiments, the second compound may include a pyridine group, a pyrimidine group, a pyrazine group, a pyridazine group, a triazine group, or any combination thereof. In one or more embodiments, the second compound may include a triazine group.

Each of the first hole-transporting host of the first emission layer 133-1 and the second hole-transporting host of the second emission layer 133-2 may be independently a third compound including a group represented by Formula 3: 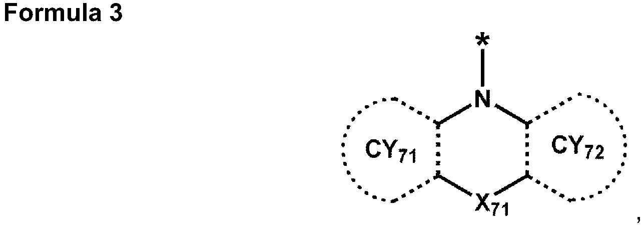 wherein, in Formula 3,
ring CY₇₁ and ring CY₇₂ may each independently a π electron-rich C₃-C₆₀ cyclic group (for example, a benzene group, a naphthalene group, a phenanthrene group, a carbazole group, a dibenzofuran group, a dibenzothiophene group, a fluorene group, a dibenzosilole group, and/or the like) or a pyridine group,
X₇₁ may be a single bond, or a linking group including O, S, N, B, C, Si, or any combination thereof, and
* indicates a binding site to any atom included in the remaining part other than the group represented by Formula 3 in the third compound.

A more detailed description of the second and third compounds will be provided later.

According to one or more embodiments, the first electron-transporting host of the first emission layer 133-1, the second electron-transporting host of the second emission layer 133-2, and the second compound may each include at least one deuterium, at least one silicon (for example, a silicon-containing group), at least one carbazole group, at least one azine group (for example, a pyridine group, a pyrimidine group, a pyrazine group, a pyridazine group, a triazine group, and/or the like), or a combination thereof.

In one or more embodiments, the first electron-transporting host of the first emission layer 133-1, the second electron-transporting host of the second emission layer 133-2, and the second compound may each include at least one silicon (for example, a silicon-containing group), at least one triazine group, and at least one carbazole group.

In one or more embodiments, each of the first hole-transporting host of the first emission layer 133-1, the second hole-transporting host of the second emission layer 133-2, and the third compound may include at least one deuterium, at least one silicon (for example, a silicon-containing group), at least one fluorene group, at least one carbazole group, or a combination thereof.

In one or more embodiments, each of the first hole-transporting host of the first emission layer 133-1, the second hole-transporting host of the second emission layer 133-2, and the third compound may include at least one silicon (for example, a silicon-containing group) and at least one carbazole group.

In one or more embodiments, each of the first thermally activated delayed fluorescence emitter of the first emission layer 133-1 and the second thermally activated delayed fluorescence emitter of the second emission layer 133-2 may be a C₈-C₆₀ polycyclic group-containing compound including two or more cyclic groups condensed while sharing boron (B).

In one or more embodiments, each of the first thermally activated delayed fluorescence emitter of the first emission layer 133-1 and the second thermally activated delayed fluorescence emitter of the second emission layer 133-2 may be a fourth compound as described herein.

In one or more embodiments, each of the first sensitizer of the first emission layer 133-1 and the second sensitizer of the second emission layer 133-2 may be a first compound as described herein.

The first compound may be a compound represented by Formula 1-1, 1-2, 1-3, 1-4, 1-5, 1-6, or 1-7: 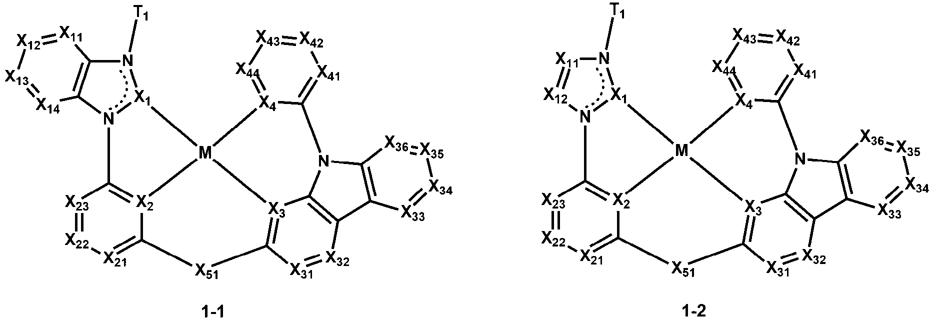 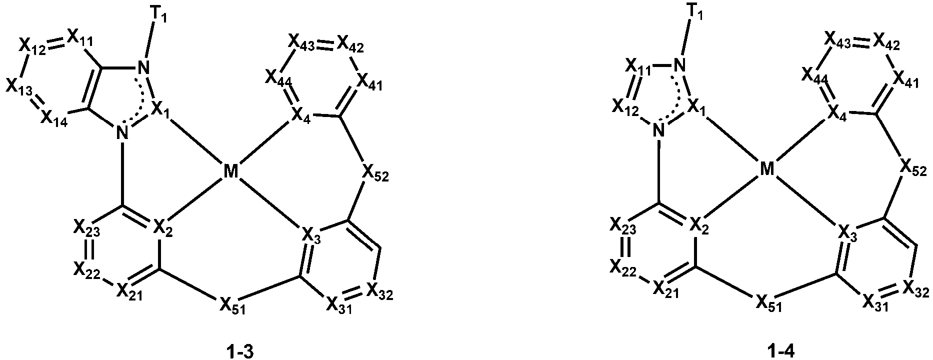 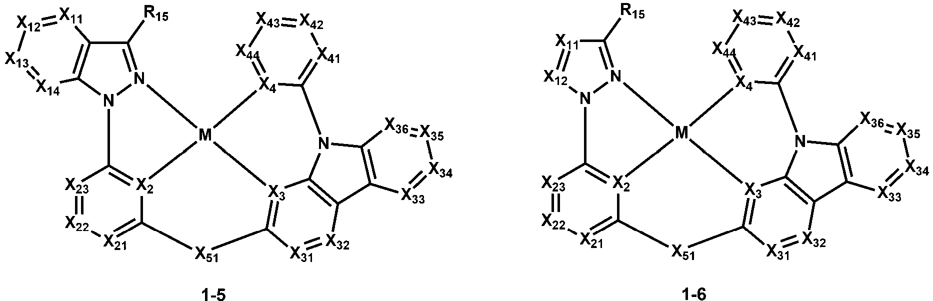 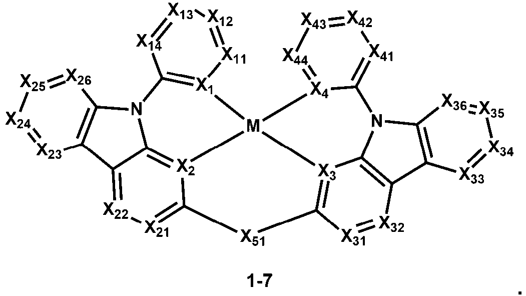
In Formulae 1-1, 1-2, 1-3, 1-4, 1-5, 1-6, and 1-7,
M may be platinum (Pt) or palladium (Pd),
X₁ to X₄ may each independently be C or N,
X₅₁ and X₅₂ may each independently be a single bond, *-N(Z₅₁ₐ)-*', *-B(Z₅₁ₐ)-*', *-P(Z₅₁ₐ)-*', *-C(Z₅₁ₐ)(Z_{51b})-*', *-Si(Z₅₁ₐ)(Z_{51b})-*', *-Ge(Z₅₁ₐ)(Z_{51b})-*', *-S-*', *-Se-*', *-O-*', *-C(=O)-*', *-S(=O)-*', *-S(=O)₂-*', *-C(Z₅₁ₐ)=*', *=C(Z₅₁ₐ)-*', *-C(Z₅₁ₐ)=C(Z_{51b})-*', *-C(=S)-*', or *-C=C-*',
X₁₁ may be C(R₁₁) or N, X₁₂ may be C(R₁₂) or N, X₁₃ may be C(R₁₃) or N, X₁₄ may be C(R₁₄) or N,
X₂₁ may be C(R₂₁) or N, X₂₂ may be C(R₂₂) or N, X₂₃ may be C(R₂₃) or N, X₂₄ may be C(R₂₄) or N, X₂₅ may be C(R₂₅) or N, X₂₆ may be C(R₂₆) or N,
X₃₁ may be C(R₃₁) or N, X₃₂ may be C(R₃₂) or N, X₃₃ may be C(R₃₃) or N, X₃₄ may be C(R₃₄) or N, X₃₅ may be C(R₃₅) or N, X₃₆ may be C(R₃₆) or N,
X₄₁ may be C(R₄₁) or N, X₄₂ may be C(R₄₂) or N, X₄₃ may be C(R₄₃) or N, X₄₄ may be C(R₄₄) or N,
R₁₁ to R₁₅, R₂₁ to R₂₆, R₃₁ to R₃₆, R₄₁ to R₄₄, T₁, Z₅₁ₐ, and Z_{51b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, -C(Q₁)(Q₂)(Q₃), -Si(Q₁)(Q₂)(Q₃), - N(Q₁)(Q₂), -B(Q₁)(Q₂), -C(=O)(Q₁), -S(=O)₂(Q₁), or -P(=O)(Q₁)(Q₂), and
two or more selected from among R₁₁, R₁₂, R₁₃ R₁₄, R₁₅, R₂₁, R₂₂, R₂₃, R₂₄, R₂₅, R₂₆, R₃₁, R₃₂, R₃₃, R₃₄, R₃₅, R₃₆, R₄₁, R₄₂, R₄₃, R₄₄, T₁, Z₅₁ₐ, and Z_{51b} may optionally be bound to form a C₃-C₆₀ carbocyclic group unsubstituted or substituted with at least one R₁₀ₐ or a C₁-C₆₀ heterocyclic group unsubstituted or substituted with at least one R₁₀ₐ.

According to one or more embodiments, X₁ in Formulae 1-1 to 1-4 may be C.

In one or more embodiments, in Formulae 1-1 to 1-6, X₂ and X₃ may each be C and X₄ may be N.

In one or more embodiments, in Formula 1-7, X₁ and X₄ may each be N, and X₂ and X₃ may each be C.

In one or more embodiments, X₅₁ and X₅₂ in Formulae 1-1 to 1-4 may each independently be *-S-*' or *-O-*'.

In one or more embodiments, in Formulae 1-1 to 1-7, R₁₁ to R₁₅, R₂₁ to R₂₆, R₃₁ to R₃₆, R₄₁ to R₄₄, T₁, Z₅₁ₐ, and Z_{51b} may each independently be:
hydrogen, deuterium, -F, or a cyano group;
a C₁-C₆₀ alkyl group unsubstituted or substituted with at least one R₁₀ₐ;
a phenyl group, a biphenyl group, a terphenyl group, a quaterphenyl group, a carbazolyl group, a dibenzofuranyl group, or a dibenzothiophenyl group (or, a dibenzothienyl group), each unsubstituted or substituted with at least one R₁₀ₐ; or
-Si(Q₁)(Q₂)(Q₃).

In one or more embodiments, T₁ in Formulae 1-1 and 1-2 may be a phenyl group, a biphenyl group, a terphenyl group, a quaterphenyl group, a carbazolyl group, a dibenzofuranyl group, or a dibenzothiophenyl group, each unsubstituted or substituted with at least one R₁₀ₐ.

The second compound may be a compound represented by Formula 2: 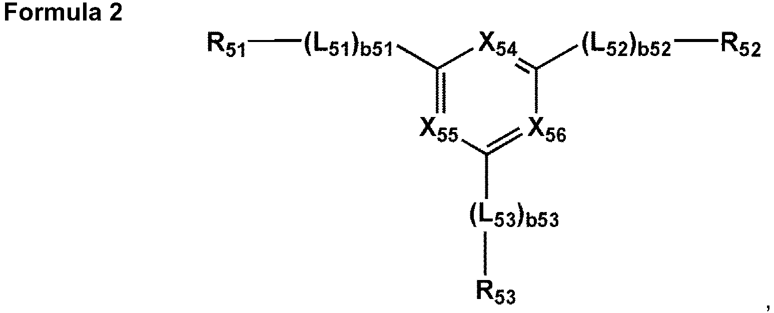 wherein, in Formula 2,
L₅₁ to L₅₃ may each independently be a single bond, a C₃-C₆₀ carbocyclic group unsubstituted or substituted with at least one R₁₀ₐ, or a C₁-C₆₀ heterocyclic group unsubstituted or substituted with at least one R₁₀ₐ,
b51 to b53 may each independently be an integer from 1 to 5,
X₅₄ may be N or C(R₅₄), X₅₅ may be N or C(R₅₅), X₅₆ may be N or C(R₅₆), at least one selected from among X₅₄ to X₅₆ may be N,
R₅₁ to R₅₆ and R₁₀ₐ may each be the same as described herein.

According to one or more embodiments, L₅₁ to L₅₃ in Formula 2 may each independently be:
a single bond; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a dibenzoxasiline group, a dibenzothiasiline group, a dibenzodihydroazasiline group, a dibenzodihydrodisiline group, a dibenzodihydrosiline group, a dibenzodioxin group, a dibenzoxathiin group, a dibenzoxazine group, a dibenzopyran group, a dibenzodithiin group, a dibenzothiazine group, a dibenzothiopyran group, a dibenzocyclohexadiene group, a dibenzodihydropyridine group, or a dibenzodihydropyrazine group, each unsubstituted or substituted with at least one R₁₀ₐ.

In one or more embodiments, L₅₁ to L₅₃ in Formula 2 may each independently be a benzene group unsubstituted or substituted with at least one R₁₀ₐ or a carbazole group unsubstituted or substituted with at least one R₁₀ₐ.

In one or more embodiments, at least one selected from among L₅₁ to L₅₃ in Formula 2 may each independently be an m-phenylene group unsubstituted or substituted with at least one R₁₀ₐ.

In Formula 2, b51 to b53 indicate the number of L₅₁ to L₅₃, respectively, and may each be an integer from 1 to 5. If (e.g., when) b51 is 2 or greater, two or more of L₅₁(s) may be identical to or different from each other, if (e.g., when) b52 is 2 or greater, two or more of L₅₂(s) may be identical to or different from each other, and if (e.g., when) b53 is 2 or greater, two or more of L₅₃(s) may be substantially identical to or different from each other. In one or more embodiments, b51 to b53 may each independently be 1 or 2.

In one or more embodiments, two or three selected from among X₅₄ to X₅₆ in Formula 2 may be N.

In one or more embodiments, R₅₁ to R₅₃ in Formula 2 may each independently be:
hydrogen, deuterium, -F, or a cyano group;
a C₁-C₂₀ alkyl group unsubstituted or substituted with at least one R₁₀ₐ;
a phenyl group, a biphenyl group, a terphenyl group, a quaterphenyl group, a carbazolyl group, a dibenzofuranyl group, or a dibenzothiophenyl group, each unsubstituted or substituted with at least one R₁₀ₐ; or
-C(Q₁)(Q₂)(Q₃) or -Si(Q₁)(Q₂)(Q₃), wherein
Q₁ to Q₃ may each independently be a C₃-C₆₀ carbocyclic group or a C₁-C₆₀ heterocyclic group, each unsubstituted or substituted with deuterium, -F, a cyano group, a C₁-C₆₀ alkyl group, a phenyl group, a biphenyl group, a pyridinyl group, a pyrimidinyl group, a pyridazinyl group, a pyrazinyl group, a triazinyl group, or any combination thereof (for example, a phenyl group, a biphenyl group, a terphenyl group, a quaterphenyl group, a carbazole group, a dibenzofuranyl group, or a dibenzothiophenyl group, each unsubstituted or substituted with deuterium, -F, a cyano group, a C₁-C₆₀ alkyl group, a phenyl group, a biphenyl group, or any combination thereof).

In one or more embodiments, at least one selected from among R₅₁ to R₅₃ in Formula 2 may each independently be:
a phenyl group, a biphenyl group, a terphenyl group, a quaterphenyl group, a carbazole group, a dibenzofuranyl group, or a dibenzothiophenyl group, each unsubstituted or substituted with at least one R₁₀ₐ; or
-C(Q₁)(Q₂)(Q₃) or -Si(Q₁)(Q₂)(Q₃), and
Q₁ to Q₃ may each independently be a C₃-C₆₀ carbocyclic group or a C₁-C₆₀ heterocyclic group, each unsubstituted or substituted with deuterium, -F, a cyano group, a C₁-C₆₀ alkyl group, a phenyl group, a biphenyl group, a pyridinyl group, a pyrimidinyl group, a pyridazinyl group, a pyrazinyl group, a triazinyl group, or any combination thereof (for example, a phenyl group, a biphenyl group, a terphenyl group, a quaterphenyl group, a carbazole group, a dibenzofuranyl group, or a dibenzothiophenyl group, each unsubstituted or substituted with deuterium, -F, a cyano group, a C₁-C₆₀ alkyl group, a phenyl group, a biphenyl group, or any combination thereof).

The third compound may include a compound represented by Formula 3-1, a compound represented by Formula 3-2, a compound represented by Formula 3-3, a compound represented by Formula 3-4, or a compound represented by Formula 3-5: 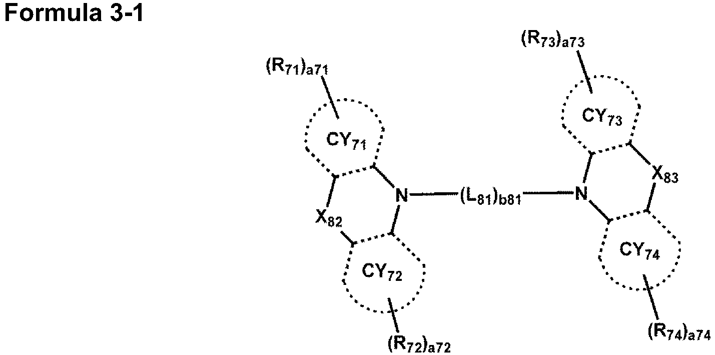 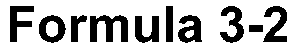 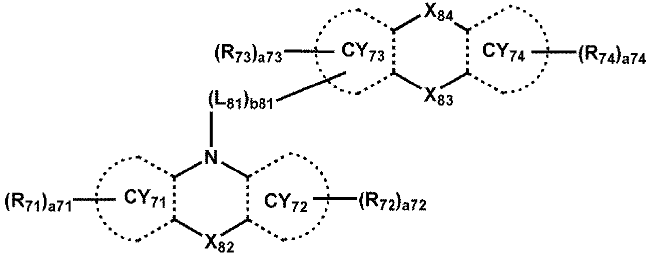 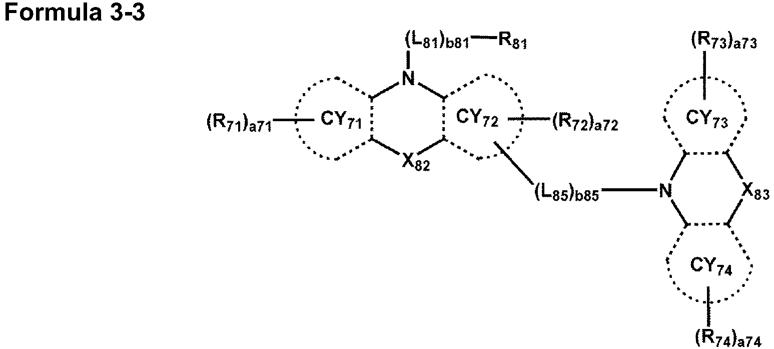 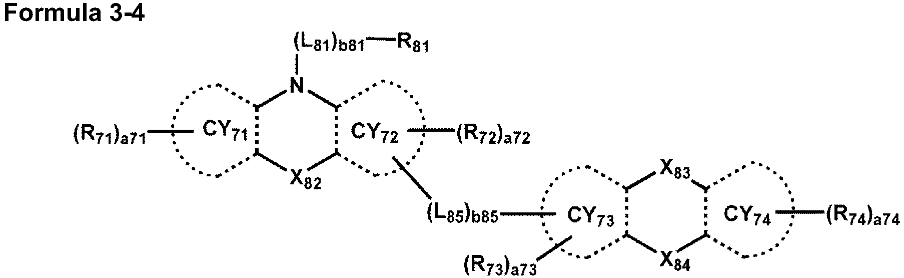 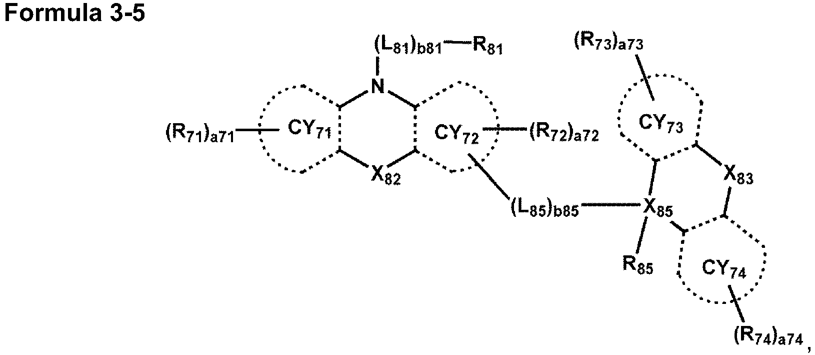 wherein, in Formulae 3-1 to 3-5,
ring CY₇₁ to ring CY₇₄ may each independently a π electron-rich C₃-C₆₀ cyclic group (for example, a benzene group, a naphthalene group, a phenanthrene group, a carbazole group, a dibenzofuran group, a dibenzothiophene group, a fluorene group, a dibenzosilole group, and/or the like) or a pyridine group,
X₈₂ may be a single bond, O, S, N[(L₈₂)_{b82}-R₈₂], B[(L₈₂)_{b82}-R₈₂], C(R₈₂ₐ)(R_{82b}), or Si(R₈₂ₐ)(R_{82b}),
X₈₃ may be a single bond, O, S, N[(L₈₃)_{b83}-R₈₃], B[(L₈₃)_{b83}-R₈₃], C(R₈₃ₐ)(R_{83b}), or Si(R₈₃ₐ)(R_{83b}),
X₈₄ may be O, S, N[(L₈₄)_{b84}-R₈₄], C(R₈₄ₐ)(R_{84b}), B[(L₈₄)_{b84}-R₈₄], or Si(R₈₄ₐ)(R_{84b}),
X₈₅ may be C or Si,
L₈₁ to L₈₅ may each independently be a single bond, *-C(Q₄)(Q₅)-*', *-Si(Q₄)(Q₅)-*', a π electron-rich C₃-C₆₀ cyclic group unsubstituted or substituted with at least one R₁₀ₐ, or a pyridine group unsubstituted or substituted with at least one R₁₀ₐ, wherein Q₄ and Q₅ may each be the same as described with respect to Q₁,
b81 to b85 may each independently be an integer from 1 to 5,
R₇₁ to R₇₄, R₈₁ to R₈₅, R₈₂ₐ, R_{82b}, R₈₃ₐ, R_{83b}, R₈₄ₐ, and R_{84b} may each be the same as described herein,
a71 to a74 may each independently be an integer from 0 to 20, and
R₁₀ₐ may be the same as described herein.

According to one or more embodiments, L₈₁ to L₈₅ in Formulae 3-1 to 3-5 may each independently be:
a single bond;
*-C(Q₄)(Q₅)-*' or *-Si(Q₄)(Q₅)-*'; or
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, or a benzothiadiazole group, each unsubstituted or substituted with deuterium, - F, -Cl, -Br, -I, a hydroxyl group, a cyano group, a nitro group, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, -Si(Q₃₁)(Q₃₂)(Q₃₃), - N(Q₃₁)(Q₃₂), -B(Q₃₁)(Q₃₂), -C(=O)(Q₃₁), -S(=O)₂(Q₃₁), -P(=O)(Q₃₁)(Q₃₂), or a combination thereof, and
Q₄, Q₅, and Q₃₁ to Q₃₃ may each independently be hydrogen, deuterium, a C₁-C₂₀ alkyl group, a C₁-C₂₀ alkoxy group, a phenyl group, a biphenyl group, a terphenyl group, a pyridinyl group, a pyrimidinyl group, a pyridazinyl group, a pyrazinyl group, or a triazinyl group.

In one or more embodiments, a group represented by 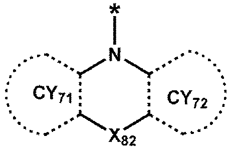 in Formulae 3-1 and 3-2 may be a group represented by one (e.g., any one) selected from among Formulae CY71-1(1) to CY71-1(8), and/or
a group represented by 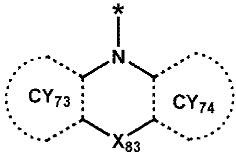 in Formulae 3-1 and 3-3 may be a group represented by one (e.g., any one) selected from among Formulae CY71-2(1) to CY71-2(8), and/or
a group represented by 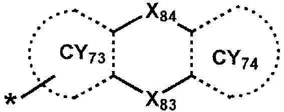 in Formulae 3-2 and 3-4 may be a group represented by one (e.g., any one) selected from among Formulae CY71-3(1) to CY71-3(32), and/or
a group represented by 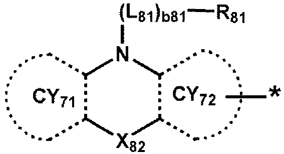 in Formulae 3-3 to 3-5 may be a group represented by one (e.g., any one) selected from among Formulae CY71-4(1) to CY71-4(32), and/or
a group represented by 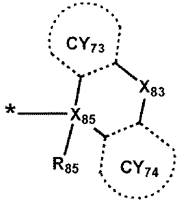 in Formula 3-5 may be a group represented by one (e.g., any one) selected from among Formulae CY71-5(1) to CY71-5(8): 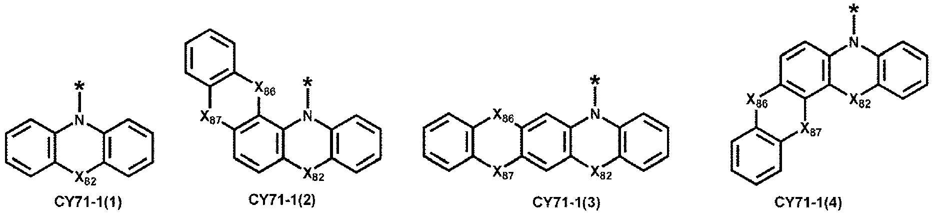 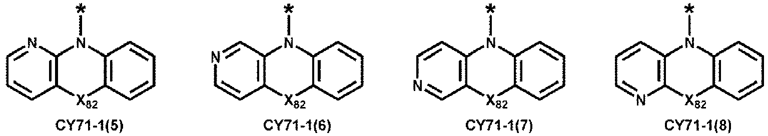 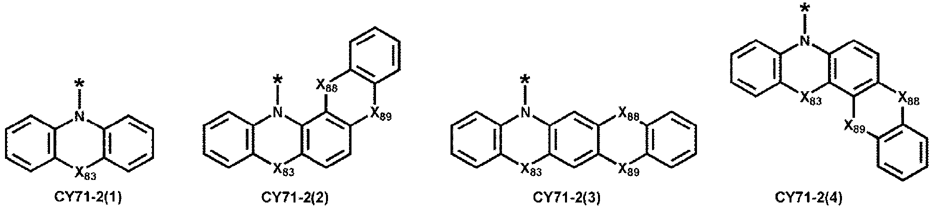 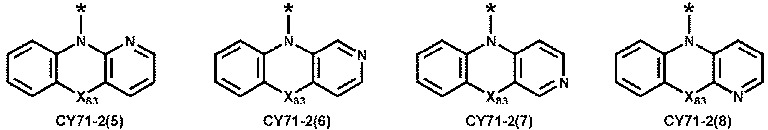 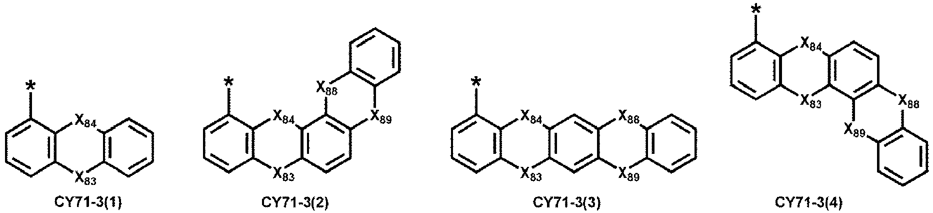 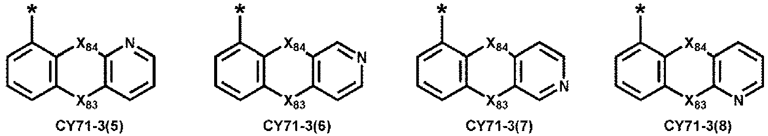 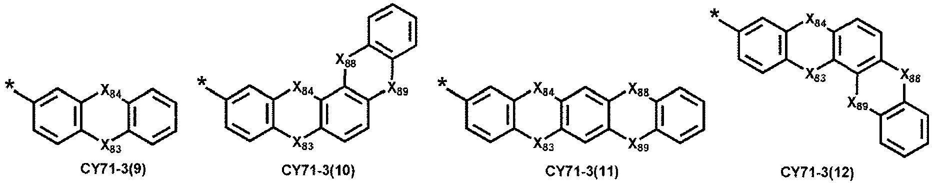 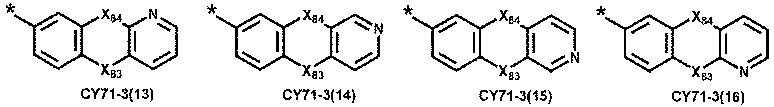 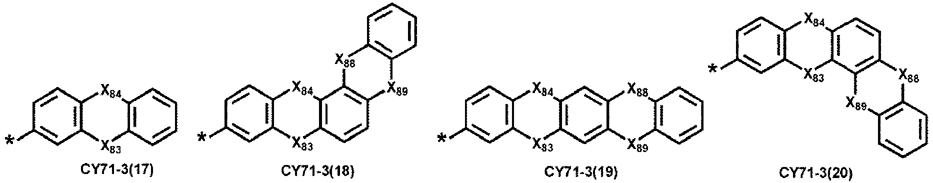 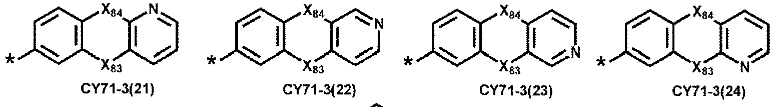 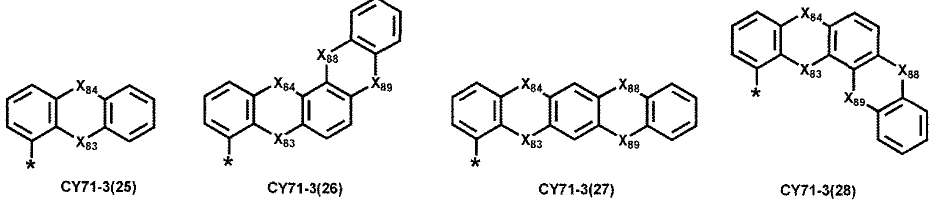 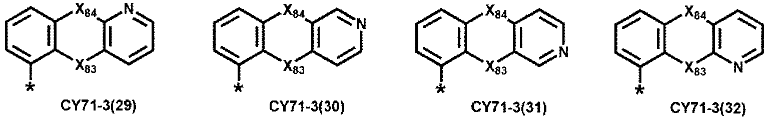 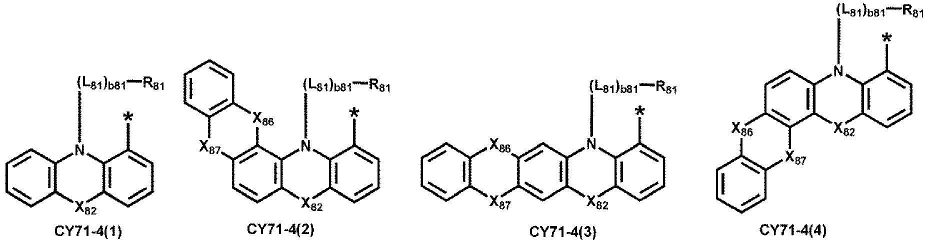 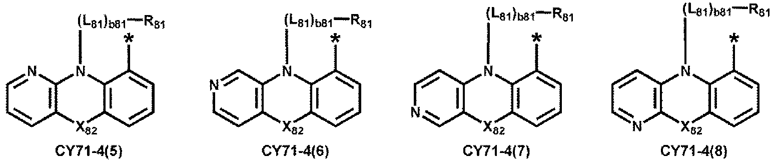 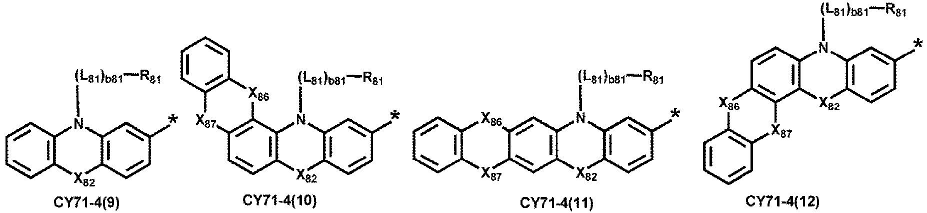 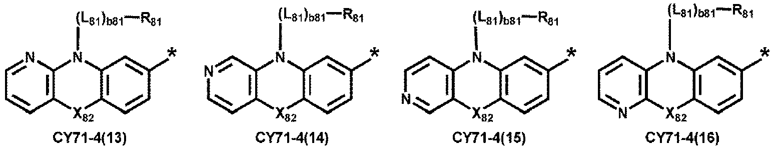 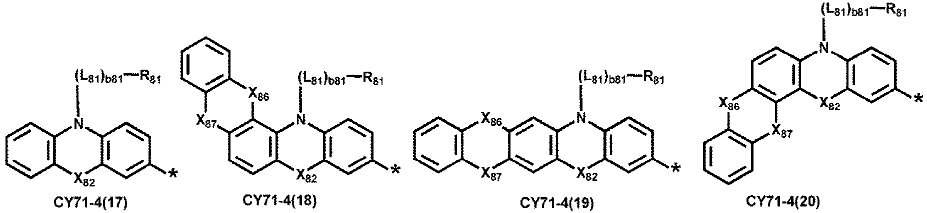 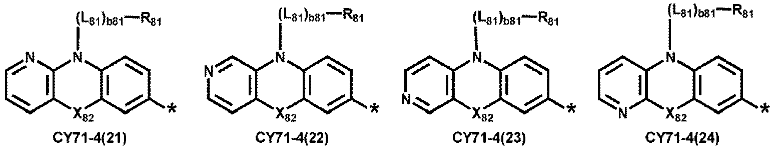 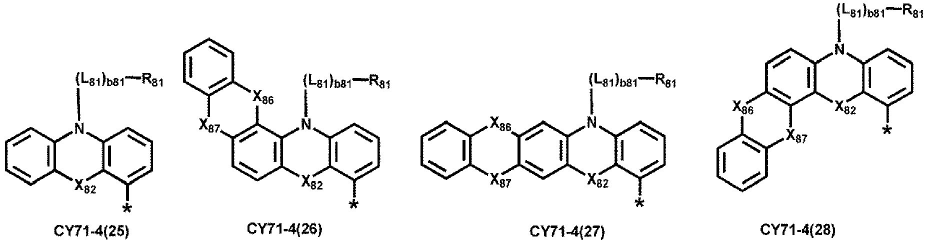 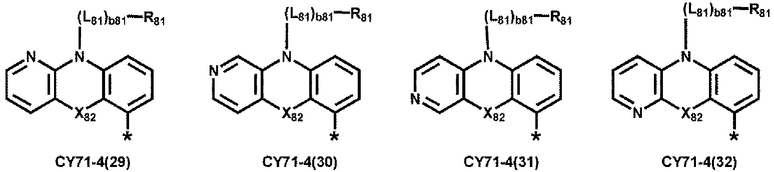 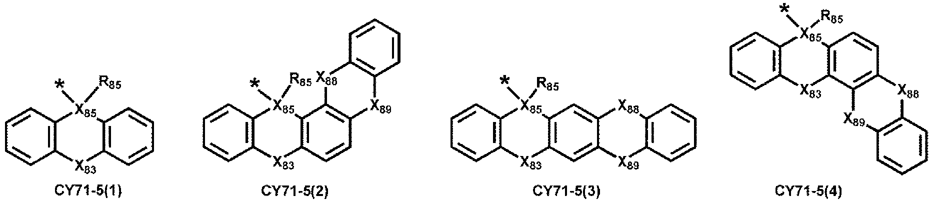 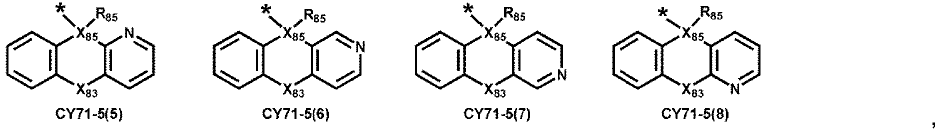
wherein, in Formulae CY71-1(1) to CY71-1(8), CY71-2(1) to CY71-2(8), CY71-3(1) to CY71-3(32), CY71-4(1) to CY71-4(32), and CY71-5(1) to CY71-5(8),
X₈₂ to X₈₅, L₈₁, b81, R₈₁, and R₈₅ may each be the same as described herein,
X₈₆ may be a single bond, O, S, N(R₈₆), B(R₈₆), C(R₈₆ₐ)(R_{86b}), or Si(R₈₆ₐ)(R_{86b}),
X₈₇ may be a single bond, O, S, N(R₈₇), B(R₈₇), C(R₈₇ₐ)(R_{87b}), or Si(R₈₇ₐ)(R_{87b}),
each of X₈₆ and X₈₇ in Formulae CY71-1(1) to CY71-1(8), and CY71-4(1) to CY71-4(32) may not be a single bond at the same time,
X₈₈ may be a single bond, O, S, N(R₈₈), B(R₈₈), C(R₈₈ₐ)(R_{88b}), or Si(R₈₈ₐ)(R_{88b}),
X₈₉ may be a single bond, O, S, N(R₈₉), B(R₈₉), C(R₈₉ₐ)(R_{89b}), or Si(R₈₉ₐ)(R_{89b}),
each of X₈₈ and X₈₉ in Formulae CY71-2(1) to CY71-2(8), CY71-3(1) to CY71-3(32), and CY71-5(1) to CY71-5(8) may not be a single bond at the same time, and
R₈₆ to R₈₉, R₈₆ₐ, R_{86b}, R₈₇ₐ, R_{87b}, R₈₈ₐ, R_{88b}, R₈₉ₐ, and R_{89b} may each be the same as described with respect to R₈₁.

The fourth compound may be a compound represented by Formula 502 or a compound represented by Formula 503: 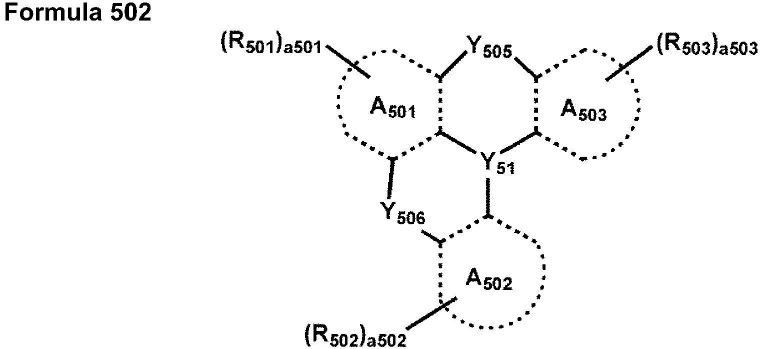 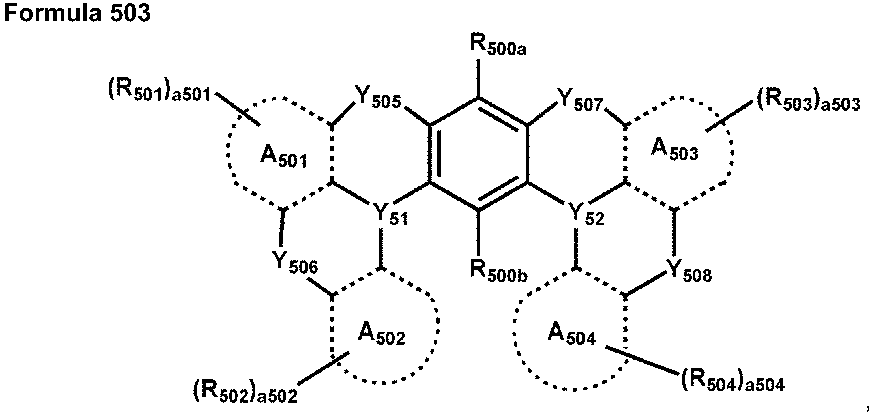 wherein, in Formulae 502 and 503,
ring A₅₀₁ to ring A₅₀₄ may each independently be a C₃-C₆₀ carbocyclic group or a C₁-C₆₀ heterocyclic group (for example, a benzene group, a naphthalene group, a phenanthrene group, a carbazole group, a dibenzofuran group, a dibenzothiophene group, a fluorene group, a dibenzosilole group, and/or the like),
Y₅₀₅ may be O, S, N(R₅₀₅), B(R₅₀₅), C(R₅₀₅ₐ)(R_{505b}), or Si(R₅₀₅ₐ)(R_{505b}),
Y₅₀₆ may be O, S, N(R₅₀₆), B(R₅₀₆), C(R₅₀₆ₐ)(R_{506b}), or Si(R₅₀₆ₐ)(R_{506b}),
Y₅₀₇ may be O, S, N(R₅₀₇), B(R₅₀₇), C(R₅₀₇ₐ)(R_{507b}), or Si(R₅₀₇ₐ)(R_{507b}),
Y₅₀₈ may be O, S, N(R₅₀₈), B(R₅₀₈), C(R₅₀₈ₐ)(R_{508b}), or Si(R₅₀₈ₐ)(R_{508b}),
Y₅₁ and Y₅₂ may each independently be B, P=O, or S=O,
R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} may each be the same as described herein, and
a501 to a504 may each independently be an integer from 0 to 20.

In the present disclosure, R₁₁ to R₁₅, R₂₁ to R₂₆, R₃₁ to R₃₆, R₄₁ to R₄₄, T₁, Z₅₁ₐ, Z_{51b}, R₅₁ to R₅₆, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} may each independently be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₇-C₆₀ arylalkyl group unsubstituted or substituted with at least one R₁₀ₐ, a C₂-C₆₀ heteroarylalkyl group unsubstituted or substituted with at least one R₁₀ₐ, - C(Q₁)(Q₂)(Q₃), -Si(Q₁)(Q₂)(Q₃), -N(Q₁)(Q₂), -B(Q₁)(Q₂), -C(=O)(Q₁), -S(=O)₂(Q₁), or **-** P(=O)(Q₁)(Q₂). Q₁ to Q₃ may each be the same as described herein.

For example, in one or more embodiments, i) R₁₁ to R₁₅, R₂₁ to R₂₆, R₃₁ to R₃₆, R₄₁ to R₄₄, T₁, Z₅₁ₐ, and Z_{51b} in Formulae 1-1 to 1-7 and ii) R₅₁ to R₅₆, R₇₁ to R₇₄, R₈₁ to R₈₅, R₈₂ₐ, R_{82b}, R₈₃ₐ, R_{83b}, R₈₄ₐ, R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in Formulae 2, 3-1 to 3-5, 502, and 503 may each independently be:

hydrogen, deuterium, -F, -Cl, -Br, -I, a hydroxyl group, a cyano group, a nitro group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, an azafluorenyl group, an azadibenzosilolyl group, or a group represented by Formula 91, each unsubstituted or substituted with deuterium, -F, -Cl, -Br, -I, -CD₃, - CD₂H, -CDH₂, -CF₃, -CF₂H, -CFH₂, a hydroxyl group, a cyano group, a nitro group, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a biphenyl group, a (C₁-C₁₀ alkyl)phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzothiazolyl group, a benzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), - P(=O)(Q₃₁)(Q₃₂), or any combination thereof; or
-C(Q₁)(Q₂)(Q₃), -Si(Q₁)(Q₂)(Q₃), -N(Q₁)(Q₂), -B(Q₁)(Q₂), -C(=O)(Q₁), - S(=O)₂(Q₁), or -P(=O)(Q₁)(Q₂),
Q₁ to Q₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof: 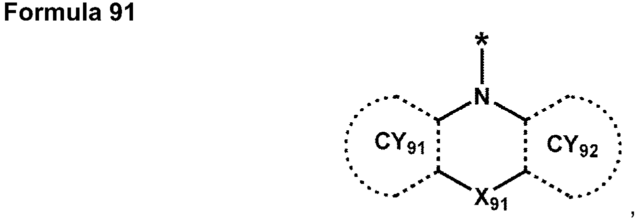
wherein, in Formula 91,
   ring CY₉₁ and ring CY₉₂ may each independently be a C₅-C₃₀ carbocyclic group unsubstituted or substituted with at least one R₁₀ₐ or a C₁-C₃₀ heterocyclic group unsubstituted or substituted with at least one R₁₀ₐ,
X₉₁ may be a single bond, O, S, N(R₉₁), B(R₉₁), C(R₉₁ₐ)(R_{91b}), or Si(R₉₁ₐ)(R_{91b}),
R₉₁, R₉₁ₐ, and R_{91b} may be the same as described with respect to R₈₂, R₈₂ₐ, and R_{82b}, respectively,
R₁₀ₐ may be the same as described herein, and
* indicates a binding site to a neighboring atom.

For example, in one or more embodiments, in Formula 91,
ring CY₉₁ and ring CY₉₂ may each independently be a benzene group, a pyridine group, a pyrimidine group, a pyrazine group, a pyridazine group, or a triazine group, each unsubstituted or substituted with at least one R₁₀ₐ, and
R₉₁, R₉₁ₐ, and R_{91b} may each independently be:
hydrogen or a C₁-C₁₀ alkyl group; or
a phenyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

In one or more embodiments, i) R₁₁ to R₁₅, R₂₁ to R₂₆, R₃₁ to R₃₆, R₄₁ to R₄₄, T₁, Z₅₁ₐ, and Z_{51b} in Formulae 1-1 to 1-7 and ii) R₅₁ to R₅₆, R₇₁ to R₇₄, R₈₁ to R₈₅, R₈₂ₐ, R_{82b}, R₈₃ₐ, R_{83b}, R₈₄ₐ and R_{84b}, R₅₀₀ₐ, R_{500b}, R₅₀₁ to R₅₀₈, R₅₀₅ₐ, R_{505b}, R₅₀₆ₐ, R_{506b}, R₅₀₇ₐ, R_{507b}, R₅₀₈ₐ, and R_{508b} in Formulae 2, 3-1 to 3-5, 502, and 503 may each independently be hydrogen, deuterium, -F, a cyano group, a nitro group, -CH₃, -CD₃, -CD₂H, -CDH₂, - CF₃, -CF₂H, -CFH₂, a group represented by one selected from among Formulae 9-1 to 9-19, a group represented by one selected from among Formulae 10-1 to 10-246, - C(Q₁)(Q₂)(Q₃), -Si(Q₁)(Q₂)(Q₃), or -P(=O)(Q₁)(Q₂)(where a description of Q₁ to Q₃ is the same as described herein): 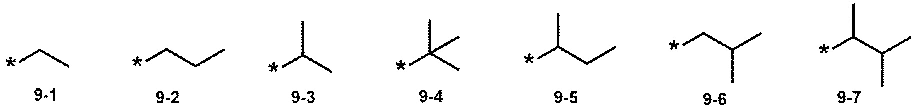 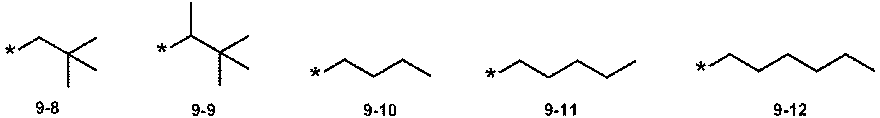 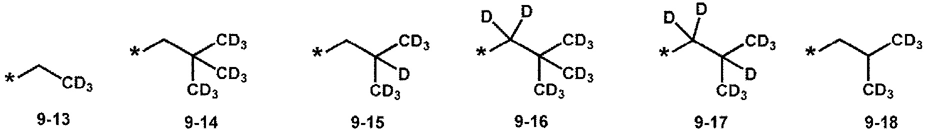 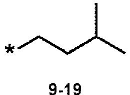 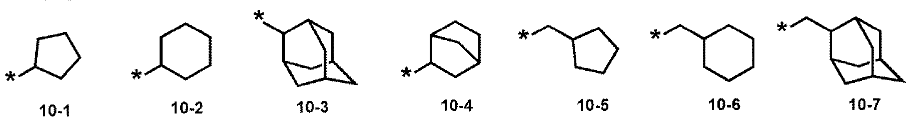 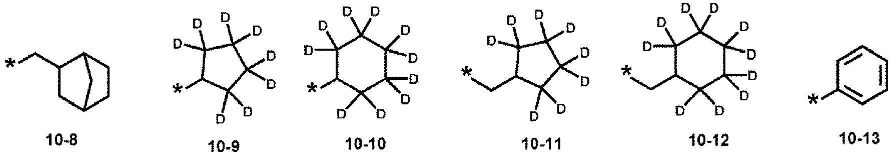 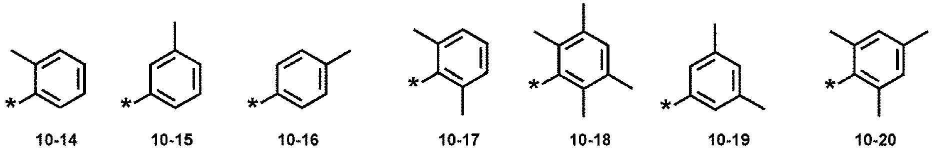 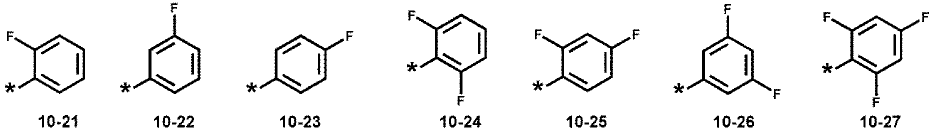 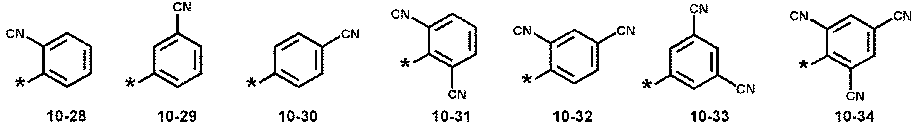 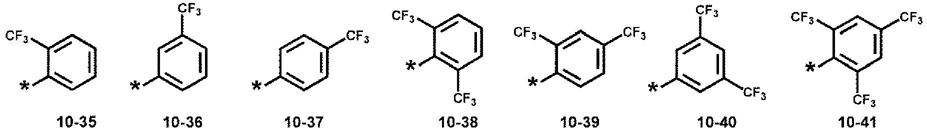 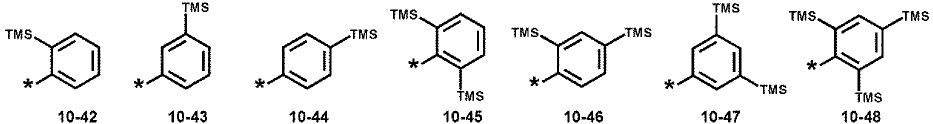 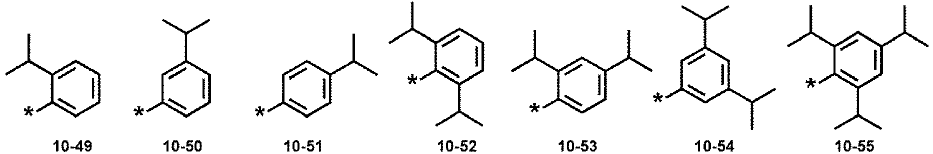 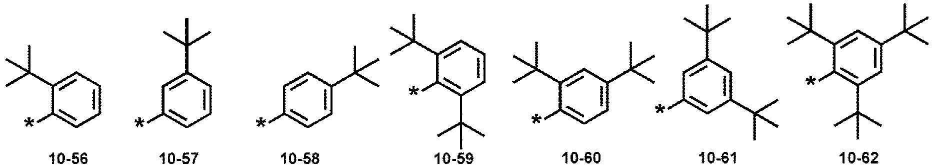 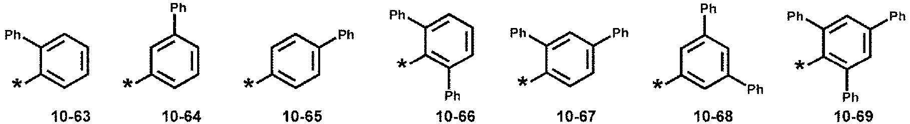 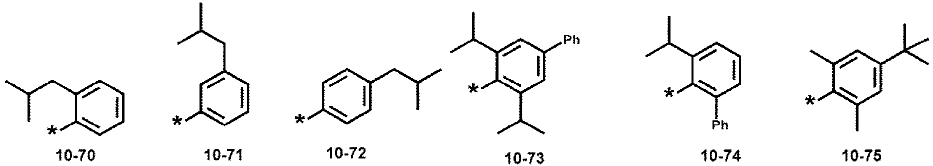 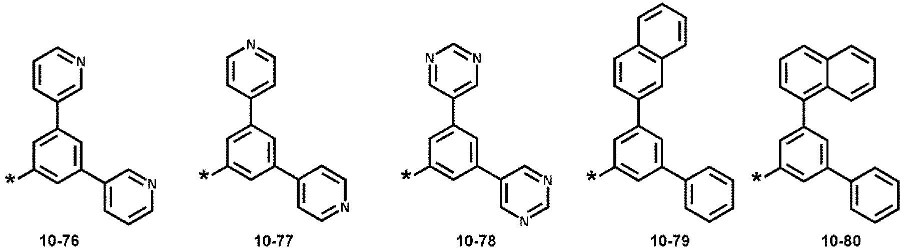 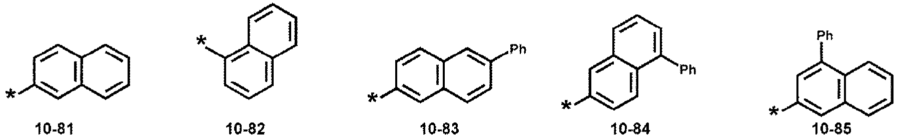 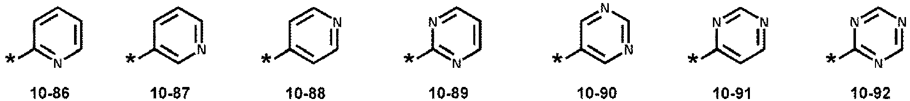 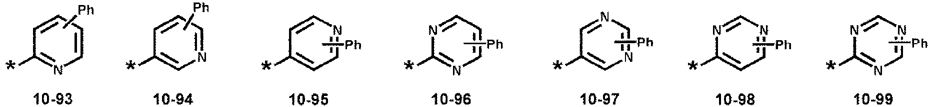 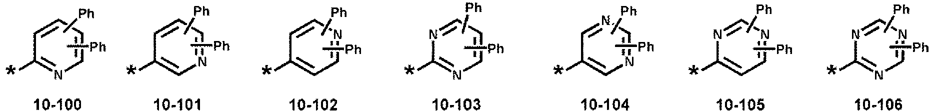 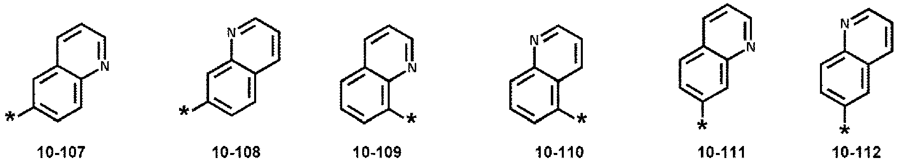 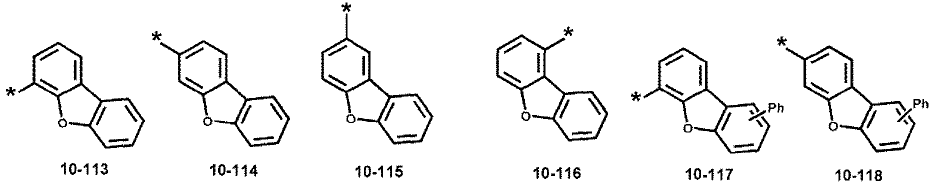 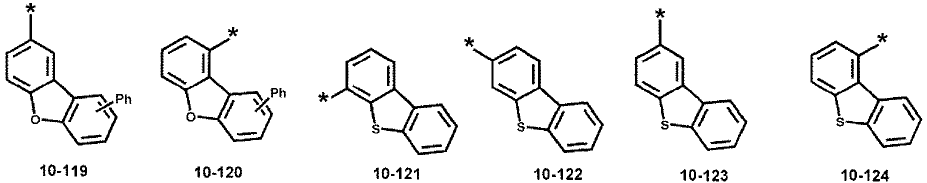 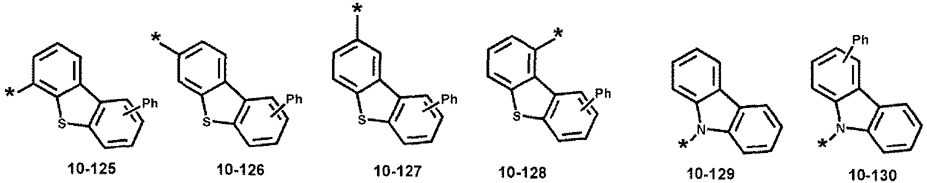 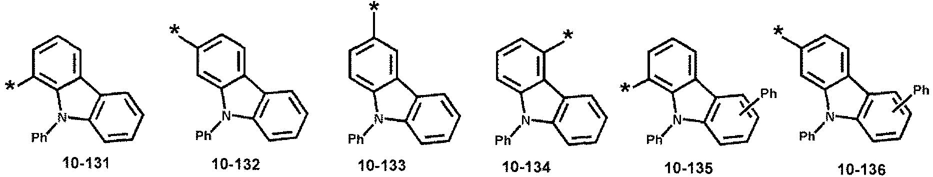 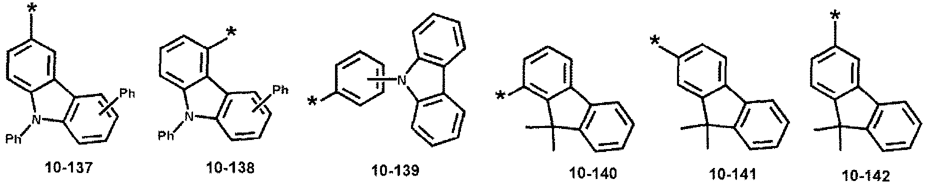 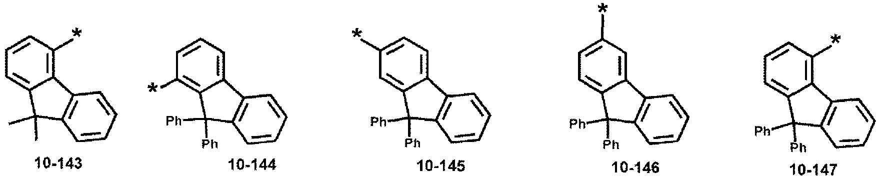 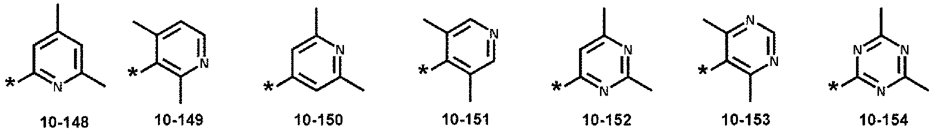 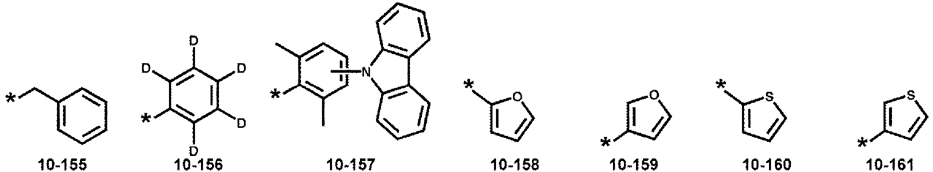 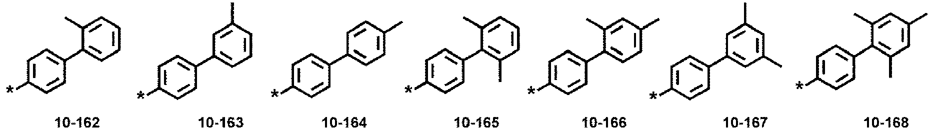 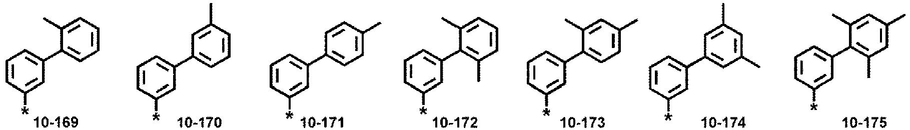 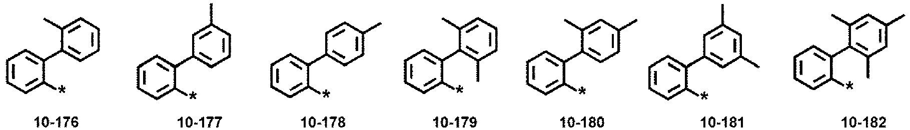 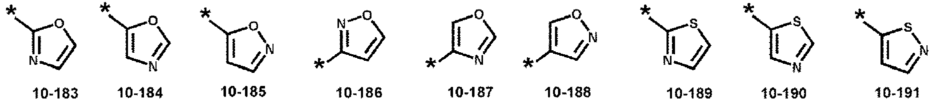 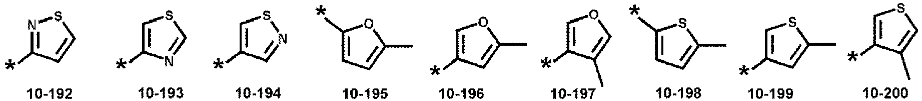 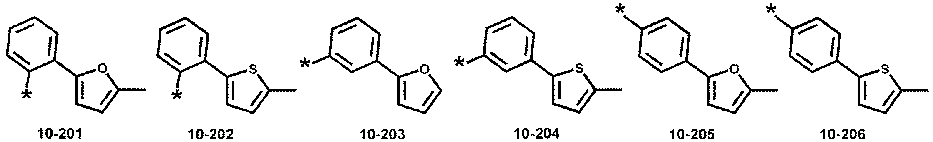 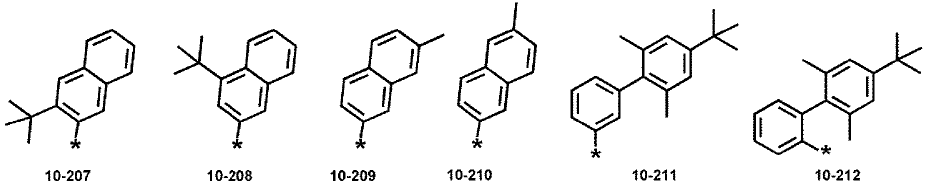 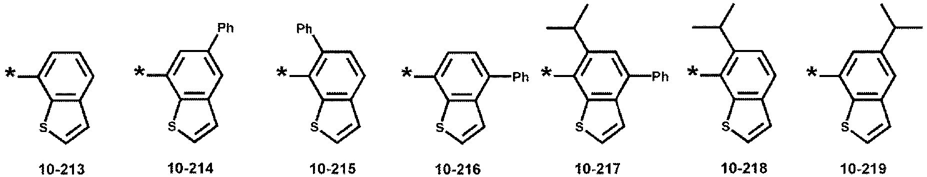 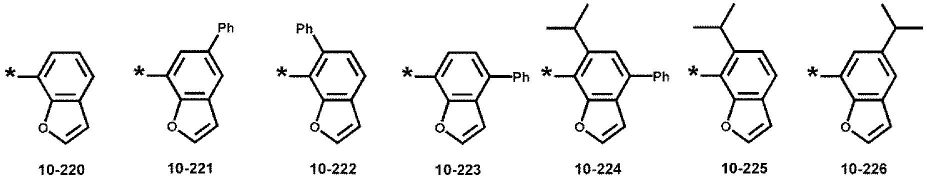 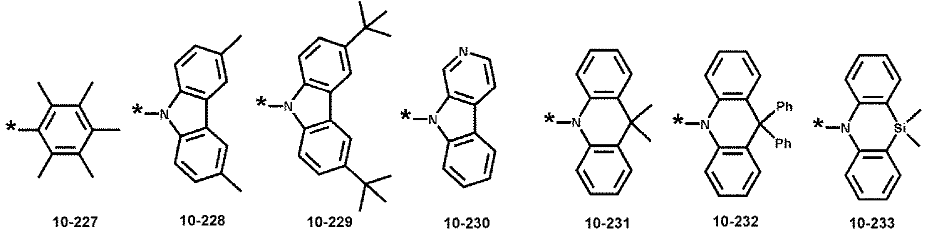 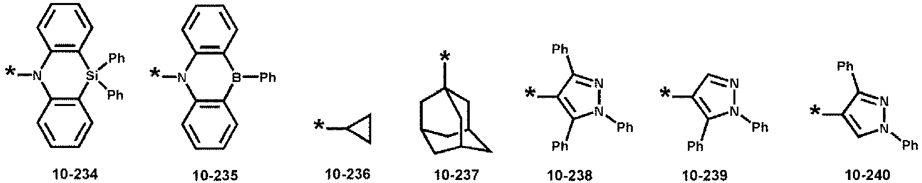 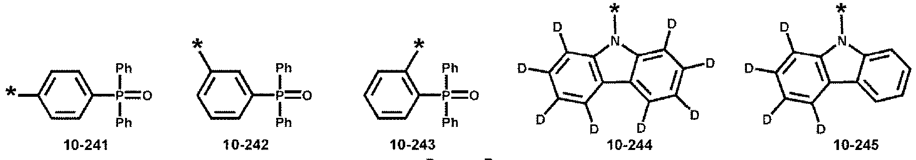 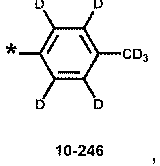 wherein, in Formulae 9-1 to 9-19 and 10-1 to 10-246, * indicates a binding site to a neighboring atom, "Ph" represents a phenyl group, "D" represents a deuterium atom, and "TMS" represents a trimethylsilyl group.

In Formulae 3-1 to 3-5, 502, and 503, a71 to a74 and a501 to a504 each indicate the number of R₇₁ to R₇₄ and the number of R₅₀₁ to R₅₀₄, respectively, and may each independently be an integer from 0 to 20. If (e.g., when) a71 is 2 or greater, two or more of R₇₁(s) may be identical to or different from each other, if (e.g., when) a72 is 2 or greater, two or more of R₇₂(s) may be identical to or different from each other, if (e.g., when) a73 is 2 or greater, two or more of R₇₃(s) may be identical to or different from each other, if (e.g., when) a74 is 2 or greater, two or more of R₇₄(s) may be identical to or different from each other, if (e.g., when) a501 is 2 or greater, two or more of R₅₀₁(s) may be identical to or different from each other, if (e.g., when) a502 is 2 or greater, two or more of R₅₀₂(s) may be identical to or different from each other, if (e.g., when) a503 is 2 or greater, two or more of R₅₀₃(s) may be identical to or different from each other, and if (e.g., when) a504 is 2 or greater, two or more of R₅₀₄(s) may be substantially identical to or different from each other. In one or more embodiments, a71 to a74 and a501 to a504 may each independently be an integer from 0 to 8.

### Examples of compounds

According to one or more embodiments, each of the first hole-transporting host, the second hole-transporting host, and the third compound may be selected from among compounds HT-1 to HT-16:

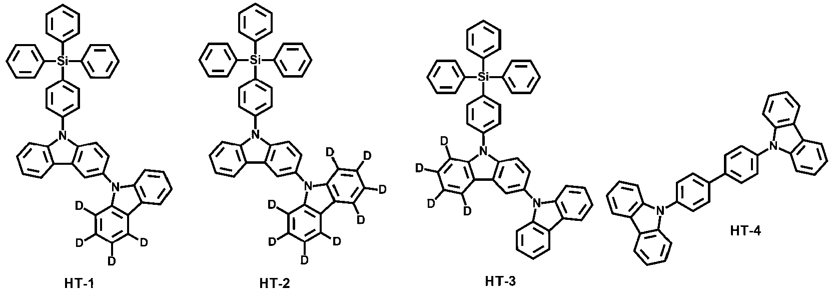

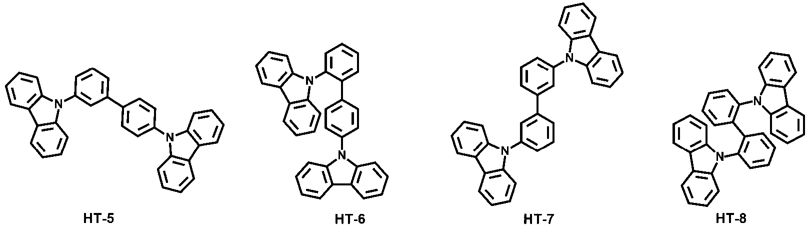

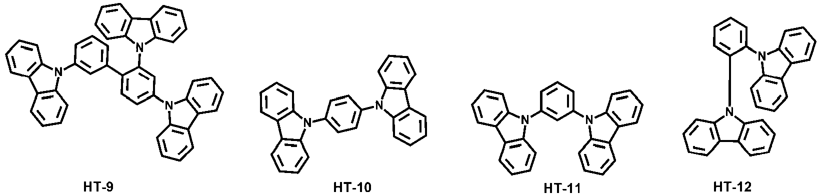

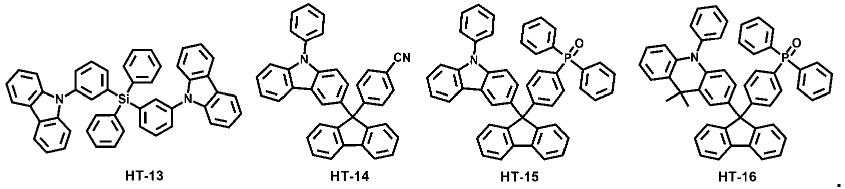

In one or more embodiments, each of the first electron-transporting host, the second electron-transporting host, and the second compound may be selected from among compounds ET-1 to ET-12:

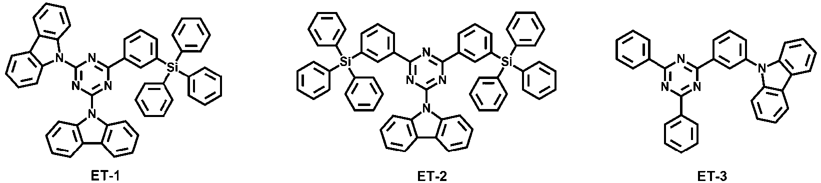

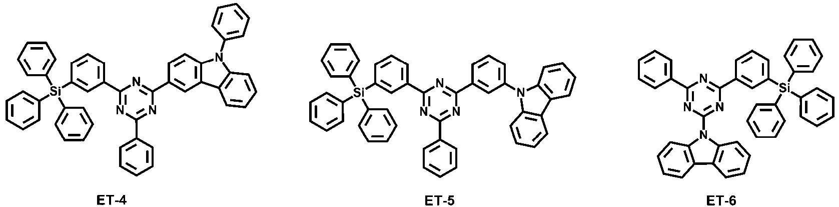

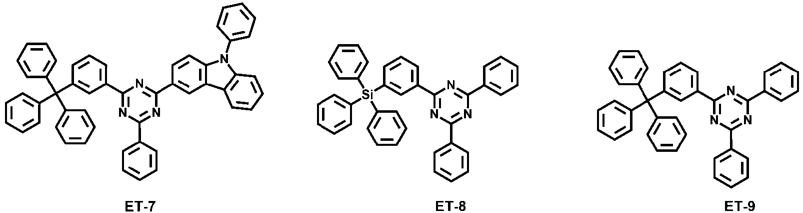

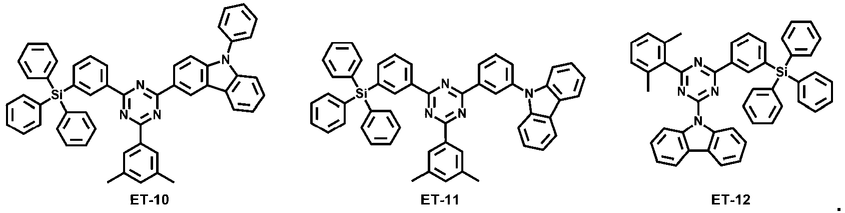

In one or more embodiments, each of the first sensitizer, the second sensitizer and the first compound may be selected from among compounds BD-1 to BD-16:

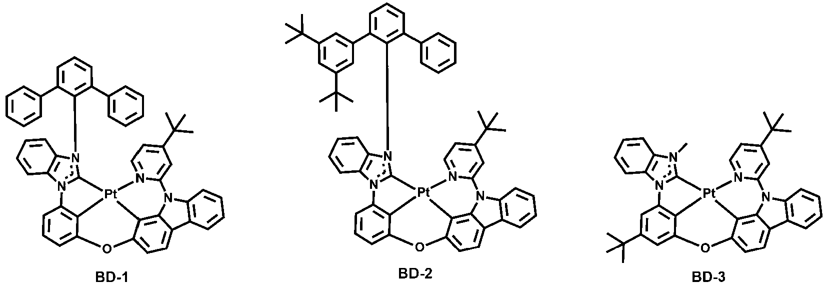

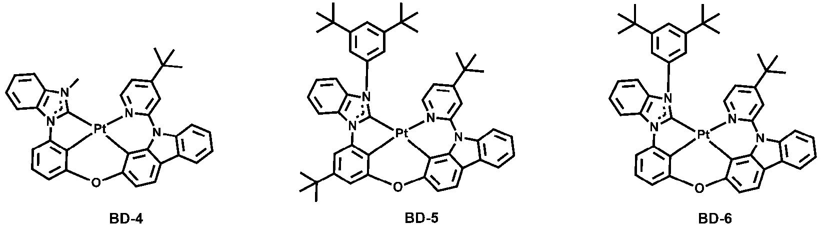

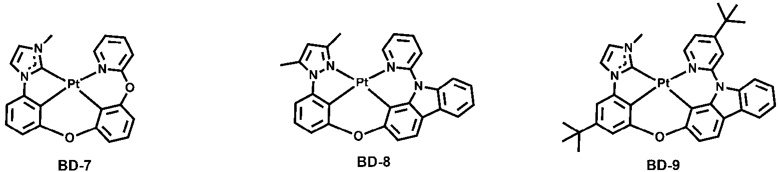

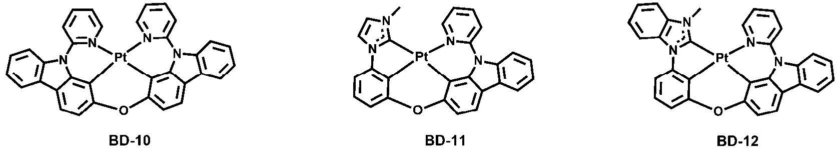

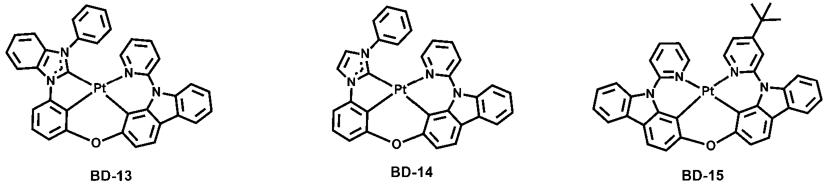

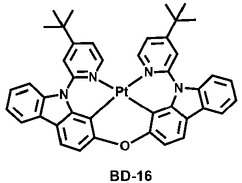

In one or more embodiments, each of the first thermally activated delayed fluorescence emitter, the second thermally activated delayed fluorescence emitter and the fourth compound may be selected from among compounds D-01 to D-11 (Ph in compounds D-01 to D-11 represents a phenyl group):

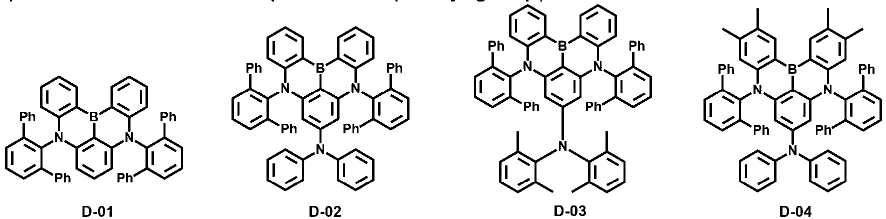

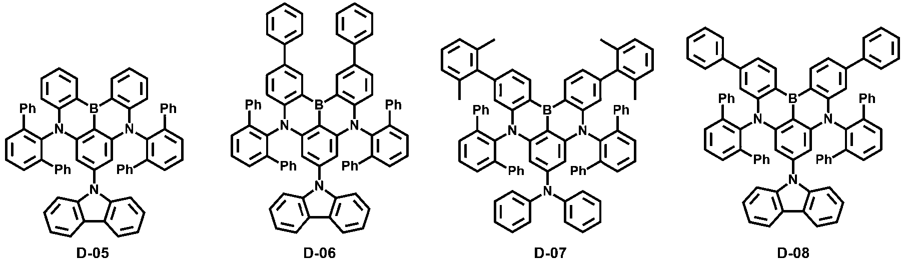

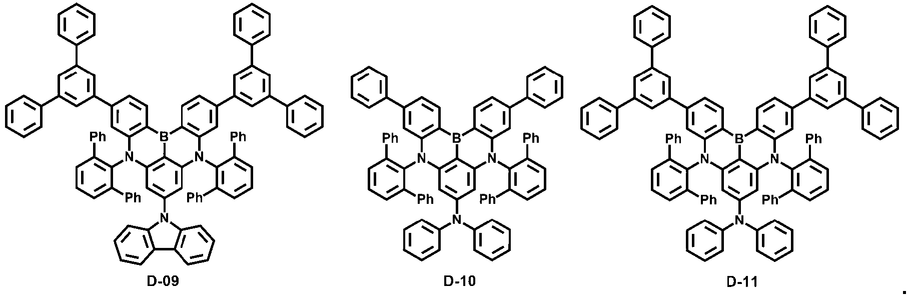

### Electron transport region

A general description of each of the first electron transport region 135-1 and the second electron transport region 135-2 is as follows.

The electron transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron transport region may include a buffer layer, a hole blocking layer, an electron control layer, an electron transport layer, an electron injection layer, or any combination thereof.

For example, in one or more embodiments, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, the constituting layers of each structure being sequentially stacked from an emission layer in the stated order.

The electron transport region (for example, a buffer layer, a hole blocking layer, an electron control layer, or an electron transport layer in the electron transport region) may include a metal-free compound including at least one π electron-deficient nitrogen-containing C₁-C₆₀ heterocyclic group.

In one or more embodiments, the electron transport region may include a compound represented by Formula 601.

**Formula 601** **[Ar₆₀₁]ₓₑ₁₁-[(L₆₀₁)ₓₑ₁-R₆₀₁]ₓₑ₂₁**

In Formula 601,
Ar₆₀₁ and L₆₀₁ may each independently be a C₃-C₆₀ carbocyclic group that is unsubstituted or substituted with at least one R₁₀ₐ or a C₁-C₆₀ heterocyclic group that is unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group that is unsubstituted or substituted with at least one R₁₀ₐ, a C₁-C₆₀ heterocyclic group that is unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or - P(=O)(Q₆₀₁)(Q₆₀₂),
Q₆₀₁ to Q₆₀₃ are each independently the same as described with respect to Q₁,
xe21 may be 1, 2, 3, 4, or 5, and
at least one selected from among Ar₆₀₁, L₆₀₁, and R₆₀₁ may each independently be a π electron-deficient nitrogen-containing C₁-C₆₀ heterocyclic group unsubstituted or substituted with at least one R₁₀ₐ.

In one or more embodiments, if (e.g., when) xe11 in Formula 601 is 2 or greater, two or more of Ar₆₀₁(s) may be linked together via a single bond.

In one or more embodiments, Ar₆₀₁ in Formula 601 may be an anthracene group that is unsubstituted or substituted with at least one R₁₀ₐ.

In one or more embodiments, the electron transport region may include a compound represented by Formula 601-1: 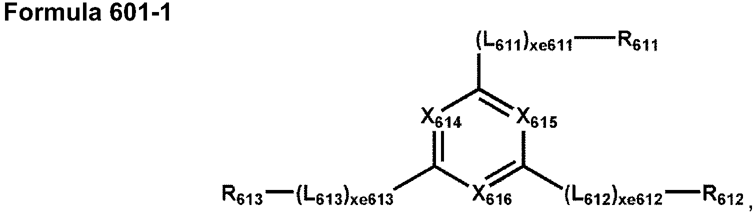 wherein, in Formula 601-1,
X₆₁₄ may be N or C(R₆₁₄), X₆₁₅ may be N or C(R₆₁₅), X₆₁₆ may be N or C(R₆₁₆), at least one selected from among X₆₁₄ to X₆₁₆ may be N,
L₆₁₁ to L₆₁₃ are each independently the same as described with respect to L601,
xe611 to xe613 are each independently the same as described with respect to xe1,
R₆₁₁ to R₆₁₃ are each independently the same as described with respect to R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group that is unsubstituted or substituted with at least one R₁₀ₐ, or a C₁-C₆₀ heterocyclic group that is unsubstituted or substituted with at least one R₁₀ₐ.
In one or more embodiments, xe1 and xe611 to xe613 in Formulae 601 and 601-1 may each independently be 0, 1, or 2.

In one or more embodiments, the electron transport region may include one of (e.g., at least one selected from among) compounds ET1 to ET45, 2,9-dimethyl-4,7-diphenyl-1,10-phenanthroline (BCP), 4,7-diphenyl-1,10-phenanthroline (Bphen), tris(8-hydroxyquinolinato)aluminium (Alq₃), bis(2-methyl-8-quinolinolato-N1,O8)-(1,1'-biphenyl-4-olato)aluminium (BAlq), 3-(4-biphenyl)-4-phenyl-5-tert-butylphenyl-1,2,4-triazole (TAZ), 4-(naphthalen-1-yl)-3,5-diphenyl-4H-1,2,4-triazole (NTAZ), 2,4,6-tris(3-(pyrimidin-5-yl)phenyl)-1,3,5-triazine (TPM-TAZ), or any combination thereof:

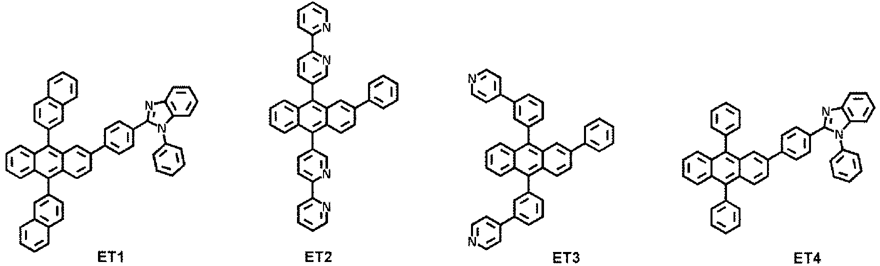

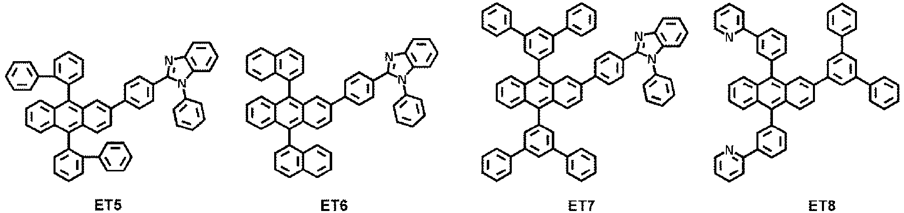

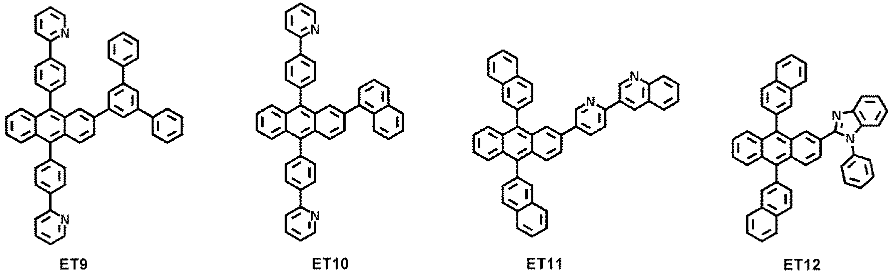

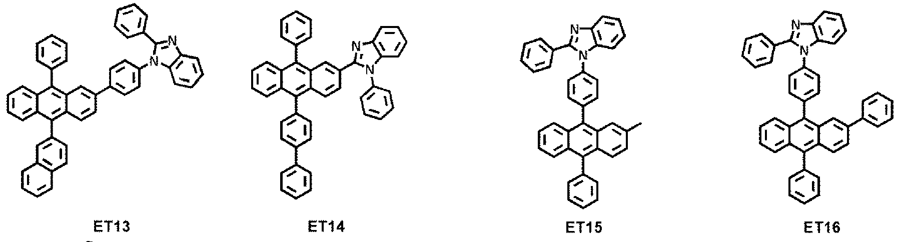

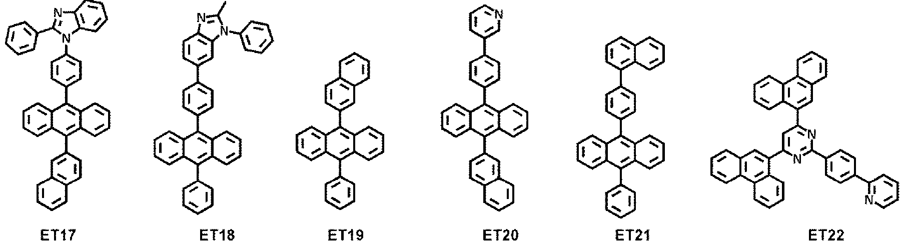

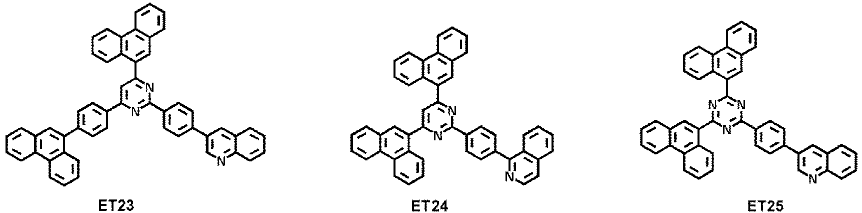

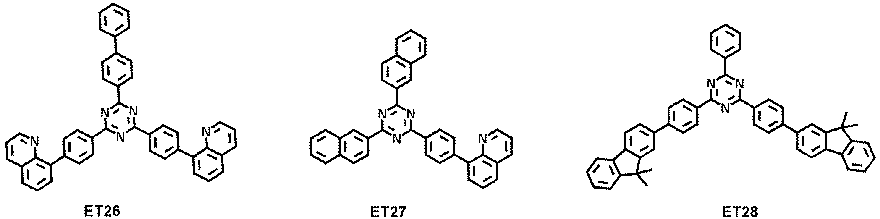

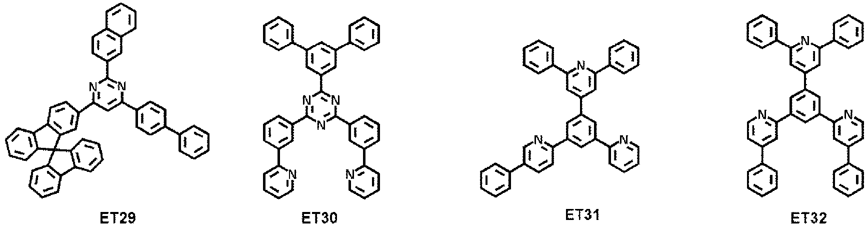

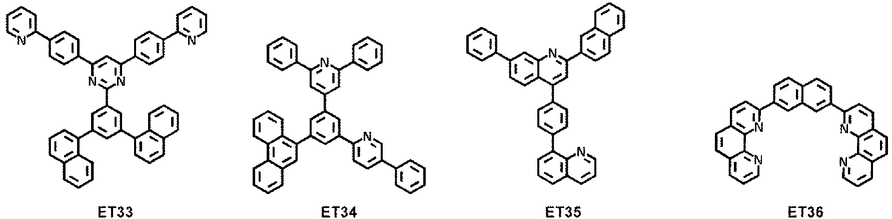

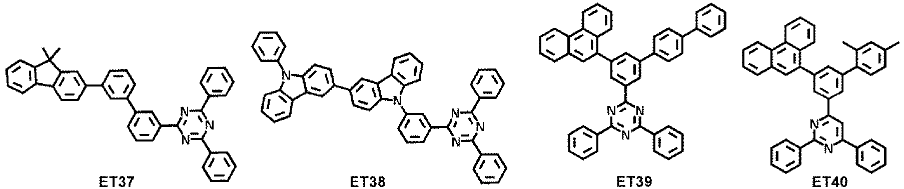

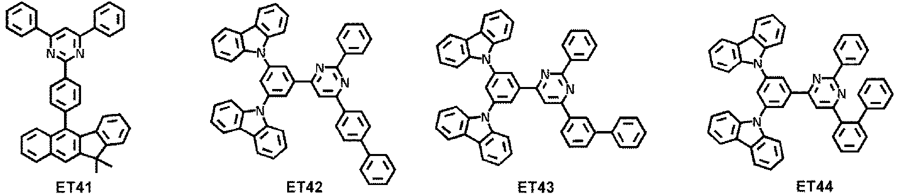

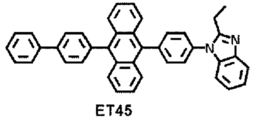

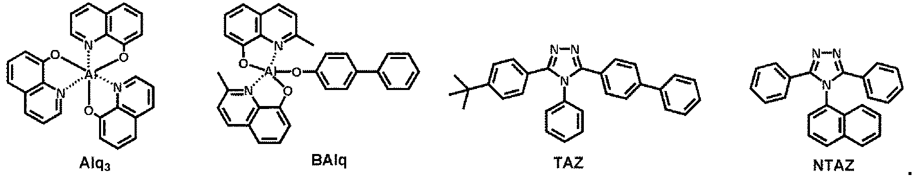

A thickness of the electron transport region may be about 100 Å to about 5,000 Å, for example, about 160 Å to about 4,000 Å. When the electron transport region includes a buffer layer, a hole blocking layer, an electron control layer, an electron transport layer, or any combination thereof, a thickness of the buffer layer, the hole blocking layer, or the electron control layer may each independently be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. When the thicknesses of the buffer layer, the hole blocking layer, the electron control layer, the electron transport layer, and/or the electron transport region are in the respective ranges described above, satisfactory electron transporting characteristics may be obtained without a substantial increase in driving voltage.

In one or more embodiments, the electron transport region (for example, the electron transport layer in the electron transport region) may further include, in addition to one or more of the materials described above, a metal-containing material.

The metal-containing material may include an alkali metal complex, an alkaline earth metal complex, or any combination thereof. A metal ion of the alkali metal complex may be a Li ion, a Na ion, a K ion, a Rb ion, or a Cs ion, and a metal ion of the alkaline earth metal complex may be a Be ion, a Mg ion, a Ca ion, a Sr ion, or a Ba ion. A ligand coordinated with the metal ion of the alkali metal complex or the metal ion of the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

In one or more embodiments, the metal-containing material may include a Li complex. The Li complex may include, for example, Compound ET-D1 (Liq) or ET-D2:

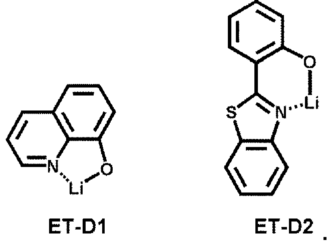

In one or more embodiments, the electron transport region may include an electron injection layer that facilitates the injection of electrons from the second electrode 150. The electron injection layer may directly contact the second electrode 150.

The electron injection layer may have: i) a single-layered structure including (e.g., consisting of) a single layer including (e.g., consisting of) a single material, ii) a single-layered structure including (e.g., consisting of) a single layer including multiple different materials, or iii) a multilayer structure including multiple layers including multiple different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include oxides, halides for example, fluorides, chlorides, bromides, iodides, and/or the like, or tellurides of the alkali metal, the alkaline earth metal, and the rare earth metal, respectively, or any combination thereof.

The alkali metal-containing compound may include: alkali metal oxides, such as Li₂O, Cs₂O, and/or K₂O; alkali metal halides, such as LiF, NaF, CsF, KF, Lil, Nal, Csl, and/or Kl; or any combination thereof. The alkaline earth metal-containing compound may include an alkaline earth metal oxide, such as BaO, SrO, CaO, BaₓSr₁₋ₓO (x is a real number satisfying the condition of 0<x<1), BaₓCa₁₋ₓO (x is a real number satisfying the condition of 0<x<1), and/or the like. The rare earth metal-containing compound may include YbF₃, ScF₃, Sc₂O₃, Y₂O₃, Ce₂O₃, GdF₃, TbF₃, Ybl₃, SCl₃, Tbl₃, or any combination thereof. In one or more embodiments, the rare earth metal-containing compound may include a lanthanide metal telluride. Non-limiting examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, and/or Lu₂Te₃.

The alkali metal complex, the alkaline earth-metal complex, and the rare earth metal complex may include i) one of metal ions of the alkali metal, one of metal ions of the alkaline earth metal, and one of metal ions of the rare earth metal, respectively, and ii) a ligand bonded to the respective metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or any combination thereof.

In one or more embodiments, the electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further include an organic material, for example, a compound represented by Formula 601.

In one or more embodiments, the electron injection layer may include (e.g., consist of) i) an alkali metal-containing compound, for example, an alkali metal halide, or ii) a) an alkali metal-containing compounds for example, an alkali metal halide; and b) an alkali metal, an alkaline earth metal, a rare earth metal, or any combination thereof. In one or more embodiments, the electron injection layer may be a KI:Yb co-deposited layer, an Rbl:Yb co-deposited layer, a LiF:Yb co-deposited layer, and/or the like.

When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth-metal complex, the rare earth metal complex, or any combination thereof may be uniformly (e.g., substantially uniformly) or non-uniformly dispersed in a matrix including the organic material.

A thickness of the electron injection layer may be about 1 Å to about 100 Å, for example, about 3 Å to about 90 Å. When the thickness of the electron injection layer is in the range as described above, satisfactory electron injection characteristics may be obtained without a substantial increase in driving voltage.

### Second electrode 150

The second electrode 150 may be placed above (e.g., on) the electron transport region. The second electrode 150 may be a cathode, which is an electron injection electrode, and as a material for forming the second electrode 150, a metal, an alloy, an electrically conductive compound, or any combination thereof, each having a low-work function, may be used.

The second electrode 150 may include Li, Na, Ag, Mg, Al, Ag-Li, Ag-Na, Al-Li, Ca, Mg-In, Mg-Ag, Yb, Ag-Yb, ITO, IZO, or any combination thereof. The second electrode 150 may be a transmissive electrode, a semi-transmissive electrode, or a reflective electrode.

The second electrode 150 may have a single-layer structure or a multi-layer structure including multiple layers.

### Capping layer

In one or more embodiments, the light-emitting device 10 may further include a capping layer positioned on the outside of (e.g., on) the first electrode 110 and/or the second electrode 150.

For example, in one or more embodiments, the light-emitting device 10 may further include a first capping layer positioned on the outside of (e.g., on) the first electrode 110. In one or more embodiments, the light-emitting device 10 may further include a second capping layer positioned on the outside of (e.g., on) the second electrode 150. In one or more embodiments, the light-emitting device 10 may further include a first capping layer positioned on the outside of (e.g., on) the first electrode 110 and a second capping layer positioned on the outside of (e.g., on) the second electrode 150.

In one or more embodiments, light generated in the emission layer of the light-emitting device 10 may be extracted toward the outside through the first electrode 110 which is a transflective electrode or a transmissive electrode, and the first capping layer. In one or more embodiments, light generated in the emission layer of the light-emitting device 10 may be extracted toward the outside through the second electrode 150 which is a transflective electrode or a transmissive electrode, and the second capping layer.

The first capping layer and the second capping layer may increase external emission efficiency according to the principle of constructive interference. Thereby, the light extraction efficiency of the light-emitting device 10 increases, so that the luminescence efficiency of the light-emitting device 10 may be improved.

Each of the first capping layer and the second capping layer may include a material having a refractive index of about 1.2 or higher (at 550 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and/or the second capping layer may (e.g., the first capping layer and the second capping layer may each independently) include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may each optionally be substituted with a substituent including O, N, S, Se, Si, F, Cl, Br, I, or any combination thereof. In one or more embodiments, at least one of the first capping layer and/or the second capping layer may (e.g., the first capping layer and the second capping layer may each independently) include an amine group-containing compound.

In one or more embodiments, at least one of the first capping layer and/or the second capping layer may (e.g., the first capping layer and the second capping layer may each independently) include a compound represented by Formula 201, a compound represented by Formula 202, or any combination thereof.

In one or more embodiments, at least one of the first capping layer and/or the second capping layer may (e.g., the first capping layer and the second capping layer may each independently) include one of (e.g., selected from among) Compounds HT28 to HT33, one of (e.g., selected from among) Compounds CP1 to CP6, β-NPB, or any combination thereof:

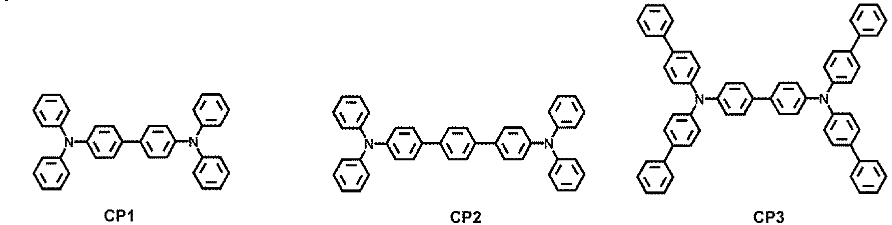

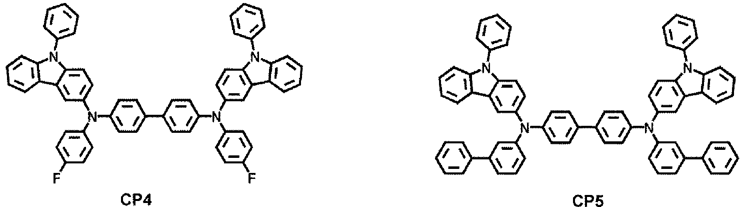

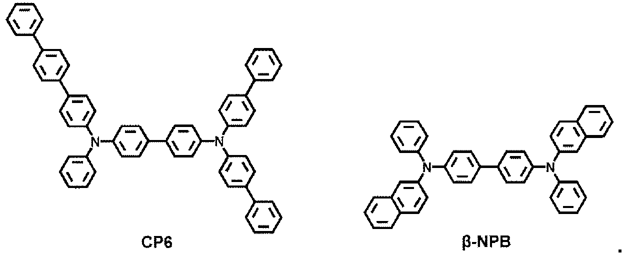

FIGS. 2 to 4 each illustrate an interlayer including two stacks ST1 and ST2. In one or more embodiments, the interlayer may include three or more stacks.

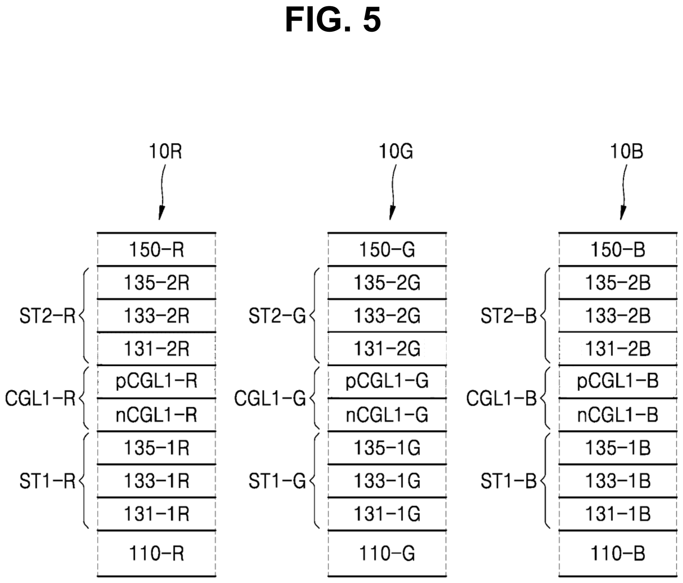

FIG. 5 is a schematic diagram illustrating a plurality of light-emitting devices included in a display device according to one or more embodiments of the present disclosure.

Referring to FIG. 5, the display device includes a first light-emitting device 10R, a second light-emitting device 10G, and a third light-emitting device 10B. The first light-emitting device 10R, the second light-emitting device 10G, and the third light-emitting device 10B may each be positioned on a substrate, and the first light-emitting device 10R may be positioned in a first region of the substrate, the second light-emitting device 10G may be positioned in a second region of the substrate, and the third light-emitting device 10B may be positioned in a third region of the substrate.

The first light-emitting device 10R includes a first-1 electrode 110-R, a first-2 electrode 150-R opposite to (e.g., facing) the first-1 electrode 110-R, and a first interlayer between the first-1 electrode 110-R and the first-2 electrode 150-R. The first interlayer includes a first-1 stack ST1-R, a first-2 stack ST2-R, and a first charge-generation layer CGL1-R between the first-1 stack ST1-R and the first-2 stack ST2-R.

The first-1 stack ST1-R may include a first-1 hole transport region 131-1R, a first-1 emission layer 133-1R, and a first-1 electron transport region 135-1R sequentially arranged from the first-1 electrode 110-R (e.g., in the stated order).

The first charge-generation layer CGL1-R may include a first n-type (kind) charge-generation layer nCGL1-R and a first p-type (kind) charge-generation layer pCGL1-R.

The first-2 stack ST2-R may include a first-2 hole transport region 131-2R, a first-2 emission layer 133-2R, and a first-2 electron transport region 135-2R sequentially arranged from the first-1 electrode 110-R (e.g., in the stated order).

The second light-emitting device 10G includes a second-1 electrode 110-G, a second-2 electrode 150-G opposite to (e.g., facing) the second-1 electrode 110-G, and a second interlayer between the second-1 electrode 110-G and the second-2 electrode 150-G. The second interlayer includes a second-1 stack ST1-G, a second-2 stack ST2-G, and a second charge-generation layer CGL1-G between the second-1 stack ST1-G and the second-2 stack ST2-G.

The second-1 stack ST1-G may include a second-1 hole transport region 131-1G, a second-1 emission layer 133-1G, and a second-1 electron transport region 135-1G which are sequentially arranged from the second-1 electrode 110-G (e.g., in the stated order).

The second charge-generation layer CGL1-G may include a second n-type (kind) charge-generation layer nCGL1-G and a second p-type (kind) charge-generation layer pCGL1-G.

The second-2 stack ST2-G may include a second-2 hole transport region 131-2G, a second-2 emission layer 133-2G, and a second-2 electron transport region 135-2G which are sequentially arranged from the second-1 electrode 110-G (e.g., in the stated order).

The third light-emitting device 10B includes a third-1 electrode 110-B, a third-2 electrode 150-B opposite to (e.g., facing) the third-1 electrode 110-B, and a third interlayer between the third-1 electrode 110-B and the third-2 electrode 150-B. The third interlayer includes a third-1 stack ST1-B, a third-2 stack ST2-B, and a third charge-generation layer CGL1-B between the third-1 stack ST1-B and the third-2 stack ST2-B.

The third-1 stack ST1-B may include a third-1 hole transport region 131-1B, a third-1 emission layer 133-1B, and a third-1 electron transport region 135-1B which are sequentially arranged from the third-1 electrode 110-B (e.g., in the stated order).

The third charge-generation layer CGL1-B may include a third n-type (kind) charge-generation layer nCGL1-B and a third p-type (kind) charge-generation layer pCGL1-B.

The third-2 stack ST2-B may include a third-2 hole transport region 131-2B, a third-2 emission layer 133-2B, and a third-2 electron transport region 135-2B, which are sequentially arranged from the third-1 electrode 110-B (e.g., in the stated order).

Referring to FIG. 5, the components included in each of the first light-emitting device 10R, the second light-emitting device 10G, and the third light-emitting device 10B are depicted as separate and distinct from each other, but, in one or more embodiments, some of the components may be connected to each other to form a common layer.

For example, in one or more embodiments, the first p-type (kind) charge-generation layer pCGL1-R and the second p-type (kind) charge-generation layer pCGL1-G may be connected to each other and may be a common layer. In one or more embodiments, the second p-type (kind) charge-generation layer pCGL1-G and the third p-type (kind) charge-generation layer pCGL1-B may be connected to each other and may be a common layer. In one or more embodiments, the first p-type (kind) charge-generation layer pCGL1-R, the second p-type (kind) charge-generation layer pCGL1-G, and the third p-type (kind) charge-generation layer pCGL1-B may be connected to one another and may be a common layer.

In one or more embodiments, the first-2 hole transport region 131-2R and the second-2 hole transport region 131-2G may be connected to each other to form a common layer. In one or more embodiments, the second-2 hole transport region 131-2G and the third-2 hole transport region 131-2B may be connected to each other to form a common layer. In one or more embodiments, the first-2 hole transport region 131-2R, the second-2 hole transport region 131-2G, and the third-2 hole transport region 131-2B may be connected to each other and may be a common layer. For example, the hole transport layer included in the first-2 hole transport region 131-2R, the hole transport layer included in the second-2 hole transport region 131-2G, and the hole transport layer included in the third-2 hole transport region 131-2B may be connected to one another and may be a common layer.

For example, in one or more embodiments, the light emitted from the third light-emitting device 10B may be blue light.

In one or more embodiments, the third light-emitting device 10B may be the light-emitting device 10 (Fig. 1) described in this disclosure.

In one or more embodiments, in the display device of FIG. 5, the third-1 emission layer 133-1B includes a third-1 hole-transporting host, a third-1 electron-transporting host, a third-1 sensitizer, and a third-1 thermally activated delayed fluorescence emitter, and the third-2 emission layer 133-2B includes a third-2 hole-transporting host, a third-2 electron-transporting host, a third-2 sensitizer, and a third-2 thermally activated delayed fluorescence emitter, and the display device of FIG. 5 may satisfy at least one of Condition 3-1 and Condition 3-2:

### Condition 3-1

In the third-1 emission layer 133-1B, a weight of a third-1 hole-transporting host is greater than a weight of the third-1 electron-transporting host,
the third-1 hole transport region 131-1B includes a third-1 hole transport layer that is in direct contact with the third-1 emission layer 133-1B,
the third-1 hole transport layer includes a third-1 HT material,
the third-1 HT material is different from the third-1 hole-transporting host, and
an absolute value of a difference between a HOMO energy level of the third-1 HT material and a HOMO energy level of the third-1 hole-transporting host is about 0.1 eV to about 0.35 eV.

### Condition 3-2

In the third-2 emission layer 133-2B, a weight of the third-2 hole-transporting host is greater than a weight of the third-2 electron-transporting host,
the third-2 hole transport region 131-2B includes a third-2 hole transport layer in direct contact with the third-2 emission layer 133-2B,
the third-2 hole transport layer includes a third-2 HT material,
the third-2 HT material is different from the third-2 hole-transporting host, and
an absolute value of a difference between a HOMO energy level of the third-2 HT material and a HOMO energy level of the third-2 hole-transporting host is about 0.1 eV to about 0.35 eV.

A description of Condition 3-1 incorporates the description of Condition 1 in this disclosure, and a description of Condition 3-2 incorporates the description of Condition 2 in this disclosure.

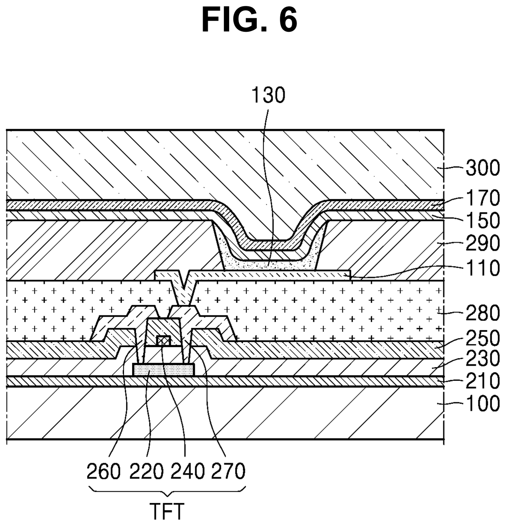

FIG. 6 is a cross-sectional view schematically showing a display device according to one or more embodiments of the present disclosure.

The display device of FIG. 6 may include a substrate 100, a thin film transistor TFT, a light-emitting device, and a sealing portion 300.

The substrate 100 may be a flexible substrate, a glass substrate, or a metal substrate. A buffer layer 210 may be arranged on the substrate 100. The buffer layer 210 may prevent or reduce penetration of impurities through the substrate 100 and may provide a flat surface on the substrate 100.

The thin film transistor TFT may be arranged on the buffer layer 210. The thin film transistor TFT may include an activation layer 220, a gate electrode 240, a source electrode 260, and a drain electrode 270.

The activation layer 220 may include an inorganic semiconductor, such as silicon or polysilicon, an organic semiconductor, or an oxide semiconductor, and may include a source region, a drain region, and a channel region.

A gate insulating film 230 for insulating the activation layer 220 from the gate electrode 240 may be positioned on the activation layer 220, and the gate electrode 240 may be positioned on the gate insulating film 230.

An interlayer insulating film 250 may be arranged on the gate electrode 240. The interlayer insulating film 250 may be located between the gate electrode 240 and the source electrode 260 to insulate the gate electrode 240 from the source electrode 260 and between the gate electrode 240 and the drain electrode 270 to insulate the gate electrode 240 from the drain electrode 270.

The source electrode 260 and the drain electrode 270 may be arranged on the interlayer insulating film 250. The interlayer insulating film 250 and the gate insulating film 230 may be formed to expose the source region and the drain region of the activation layer 220, and the source electrode 260 and the drain electrode 270 may be arranged in contact with the exposed portions of the source region and the drain region of the activation layer 220, respectively.

The thin film transistor TFT may be electrically connected to the light-emitting device to drive the light-emitting device, and may be covered and protected by a passivation layer 280. The passivation layer 280 may include an inorganic insulating film, an organic insulating film, or any combination thereof. The light-emitting device may be provided on the passivation layer 280. The light-emitting device includes a first electrode 110, an interlayer 130, and a second electrode 150.

The first electrode 110 may be arranged on the passivation layer 280. The passivation layer 280 may be arranged to expose a portion of the drain electrode 270, not fully covering the drain electrode 270, and the first electrode 110 may be arranged to be connected to the exposed portion of the drain electrode 270.

A pixel-defining film 290 including an insulating material may be arranged on the first electrode 110. The pixel-defining film 290 may expose a certain region of the first electrode 110, and the interlayer 130 may be formed in the exposed region of the first electrode 110. The pixel-defining film 290 may be a polyimide-based organic film or a polyacrylic-based organic film. In one or more embodiments, at least some layers of the interlayer 130 may extend to an upper portion of the pixel-defining film 290 and may be arranged in the form of a common layer.

The second electrode 150 may be arranged on the interlayer 130, and a capping layer 170 may be further formed on the second electrode 150. The capping layer 170 may be formed to cover the second electrode 150.

The sealing portion 300 may be arranged on the capping layer 170. The sealing portion 300 may be positioned on the light-emitting device to protect the light-emitting device from moisture and/or oxygen. The sealing portion 300 may include: an inorganic film including silicon nitride (SiNₓ), silicon oxide (SiOₓ), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic-based resin (for example, polymethyl methacrylate, polyacrylic acid, and/or the like), an epoxy-based resin (for example, aliphatic glycidyl ether (AGE), and/or the like), or any combination thereof; or a combination of the inorganic film and the organic film.

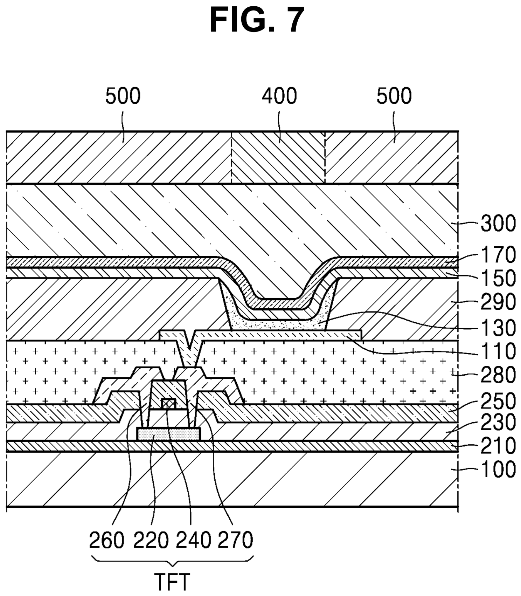

FIG. 7 is a cross-sectional view schematically showing a display device according to one or more embodiments of the present disclosure.

The display device of FIG. 7 is substantially the same display device as the display device of FIG. 6, except that a light-blocking pattern 500 and a functional region 400 are additionally arranged on the upper portion of the sealing portion 300. The functional region 400 may be i) a color filter region, ii) a color conversion region, or iii) a combination of a color filter region and a color conversion region. According to one or more embodiments, the light-emitting device included in the display device of FIG. 7 may be a tandem light-emitting device.

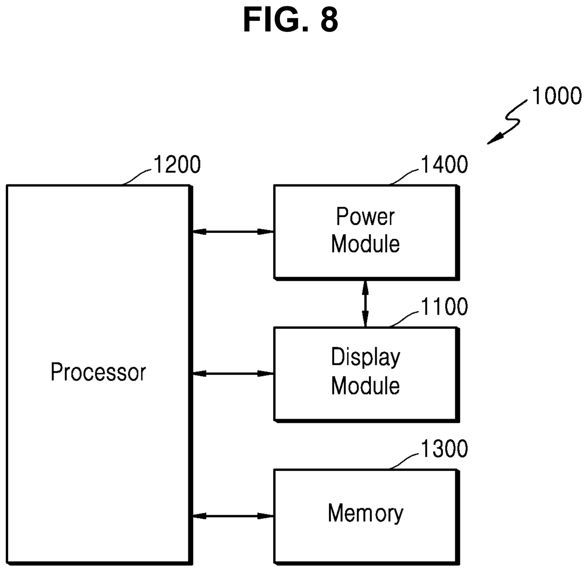

FIG. 8 is a block diagram illustrating an electronic device including a light-emitting device 1000 according to one or more embodiments and/or a display device according to one or more embodiments.

A display device including a light-emitting device 10 (Fig. 1) according to one or more embodiments may be applied to an electronic device 1000. The electronic device 1000 according to one or more embodiments includes the display device described above, and may further include a module or a device having additional functions in addition to the display device.

Referring to FIG. 8, the electronic device 1000 according to one or more embodiments may include a display module 1100, a processor 1200, a memory 1300, and a power module 1400.

The display module 1100 may be to emit light to display images such as moving images or still images, and may include, for example, the display device described above.

The processor 1200 may include at least one of a central processing unit (CPU), an application processor (AP), a graphic processing unit (GPU), a communication processor (CP), an image signal processor (ISP), and a controller.

Data information necessary for the operation of the processor 1200 and/or display module 1100 may be stored in the memory 1300. When the processor 1200 executes an application stored in the memory 1300, an image data signal and/or an input control signal are transmitted to the display module 1100, and the display module 1100 may process the received signal and output image information through a display screen.

The power module 1400 may include a power supply module, such as a power adapter or a battery device, and a power conversion module that converts power supplied by the power supply module to generate power desired or required for the operation of the electronic device 1000.

At least one of the components of the electronic device 1000 may be included in a display device according to one or more embodiments. In one or more embodiments, some of the individual modules functionally included in a module may be included in the display device, while others may be provided separately from the display device. For example, in one or more embodiments, the display device may include a display module 1100, and the processor 1200, the memory 1300, and the power module 1400 may be provided in the form of other devices in the electronic device 1000 other than the display device.

In one or more embodiments, the electronic device 1000 may be at least one of a flat panel display, a curved display, a computer monitor, a medical monitor, a television, a billboard, an indoor light, an outdoor light, a light for signaling, a head-up display, a fully transparent display, a partially transparent display, a flexible display, a rollable display, a foldable display, a stretchable display, smart glasses, a head-mounted display, a smart watch, a laser printer, a telephone, a mobile phone, a tablet, a phablet, a personal digital assistant (PDA), a wearable device, a laptop computer, a digital camera, a camcorder, a viewfinder, a micro display, a three-dimensional (3D) display, a virtual reality display, an augmented reality display, a vehicle dashboard, a center information display (CID), a vehicle head-up display, a rear-view mirror display, a video wall including multiple displays that are tiled together, a theater screen, a stadium screen, a light therapy device, or a signage.

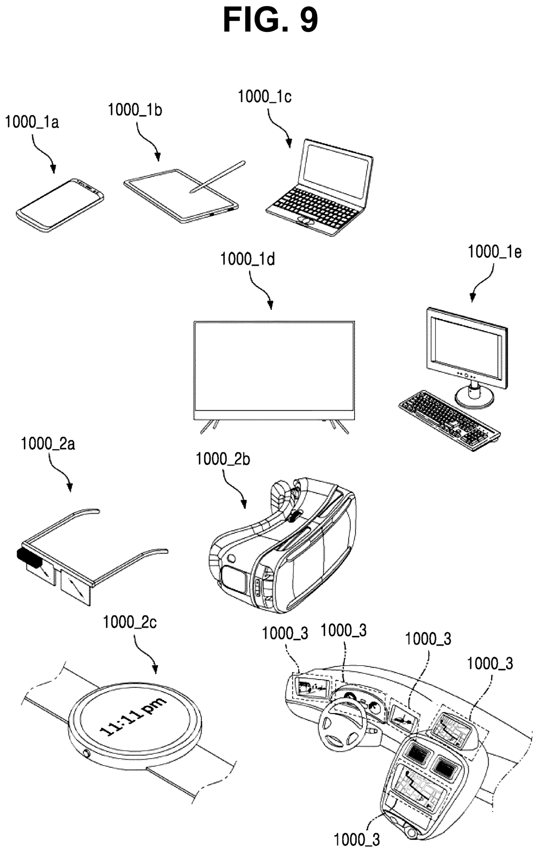

FIG. 9 is a schematic diagram showing one or more embodiments of an electronic device according to one or more suitable implementations;
Referring to FIG. 9, the electronic device, to which a display device according to one or more embodiments is applied, may include not only image display electronic devices such as a smart phone 1000_1a, a tablet PC 1000_1b, a laptop 1000_1c, a TV 1000_1d, and a desk monitor 1000_1e, but also wearable electronic devices including display modules such as smart glasses 1000_2a, a head mounted display 1000_2b, and a smart watch 1000_2c, and a vehicle electronic device 1000_3 including display modules such as a room mirror display, and a center information display (CID) on a dashboard, center fascia, and a car instrument panel.

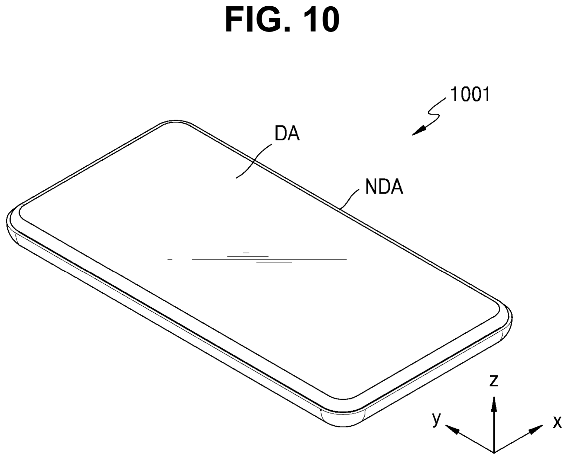

FIG. 10 is a perspective view schematically illustrating an electronic device 1001 including a light-emitting device 10 (Fig. 1) according to one or more embodiments. The electronic device 1001 may be, as a device that displays a moving image or a still image, a portable electronic device, such as a mobile phone, a smart phone, a tablet personal computer (PC), a mobile communication terminal, an electronic notebook, an electronic book, a portable multimedia player (PMP), a navigation, or a ultra mobile PC (UMPC), as well as one or more suitable other products, such as a television, a laptop, a monitor, a billboards, or an Internet of things (IoT) device. The electronic device 1001 may be such a product above or a part thereof. In one or more embodiments, the electronic device 1001 may be a wearable device, such as a smart watch, a watch phone, a glasses-type (kind) display, or a head mounted display (HMD), or a part of such a wearable device. However, embodiments of the present disclosure are not limited thereto. For example, in one or more embodiments, the electronic device 1001 may be a center information display (CID) on a dashboard, a center fascia, and a car instrument panel, a room mirror display instead of a side mirror of a vehicle, an entertainment display for the rear seat of a car, a display placed on the back of the front seat of a vehicle, head up display (HUD) installed in the front of a vehicle or projected on a front window glass, or a computer generated hologram augmented reality head up display (CGH AR HUD). For convenience of explanation, FIG. 10 illustrates an embodiment where the electronic device 1001 is a smart phone.

The electronic device 1001 may include a display area DA and a non-display area NDA outside (e.g., adjacent) the display area DA. The electronic device 1001 may implement an image through an array of a plurality of pixels arranged two-dimensionally in the display area DA.

The non-display area NDA is an area that does not display an image, and may entirely surround the display area DA. In the non-display area NDA, a driver for providing electrical signals or power to display elements arranged in the display area DA may be arranged. In the non-display area NDA, a pad, to which an electronic element or a printed circuit board, may be electrically connected may be arranged.

The electronic device 1001 may have different lengths in an x-axis direction and in a y-axis direction. For example, in one or more embodiments, as illustrated in Fig. 10, a length in the x-axis direction may be shorter than a length in the y-axis direction. In one or more embodiments, the length in the x-axis direction may be substantially the same as the length in the y-axis direction. In one or more embodiments, the length in the x-axis direction may be greater than the length in the y-axis direction.

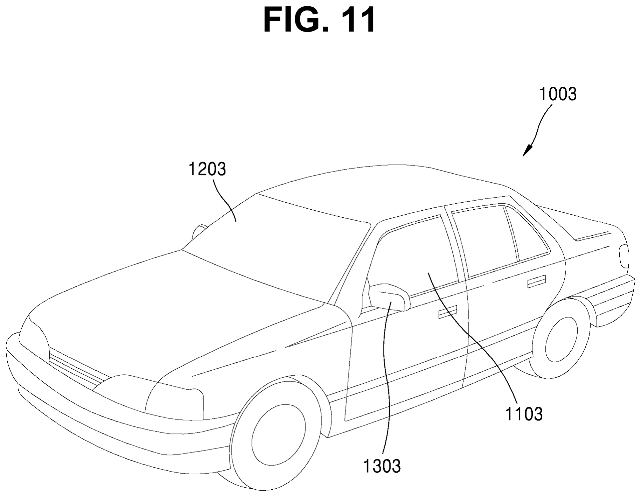

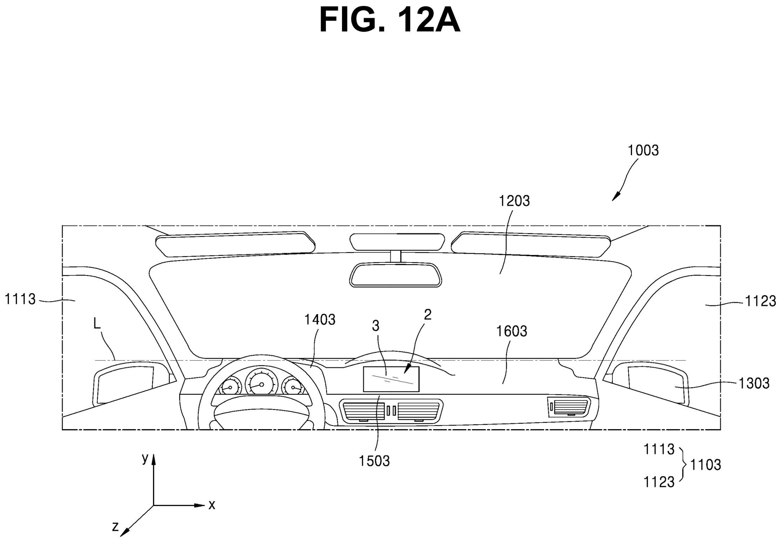

FIG. 11 is a diagram schematically illustrating an exterior of a vehicle 1003 as an electronic device including the light-emitting device 10 (Fig. 1) according to one or more embodiments. FIGS. 12A to 12C are each a schematic drawing illustrating an interior of a vehicle 1003 according to one or more embodiments of the disclosure.

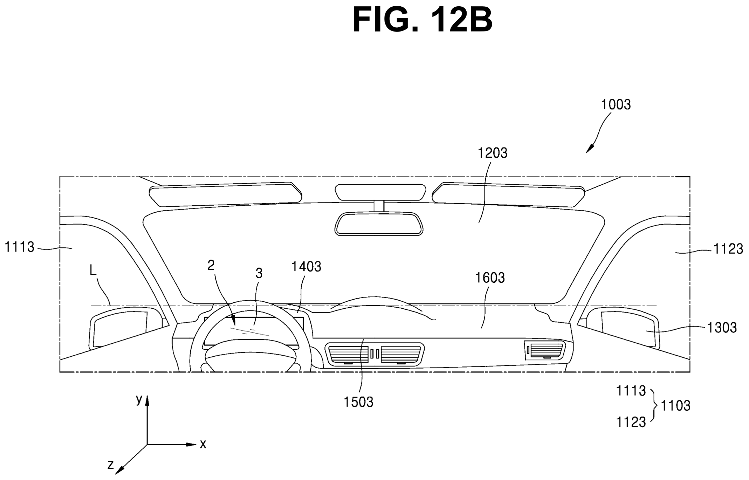

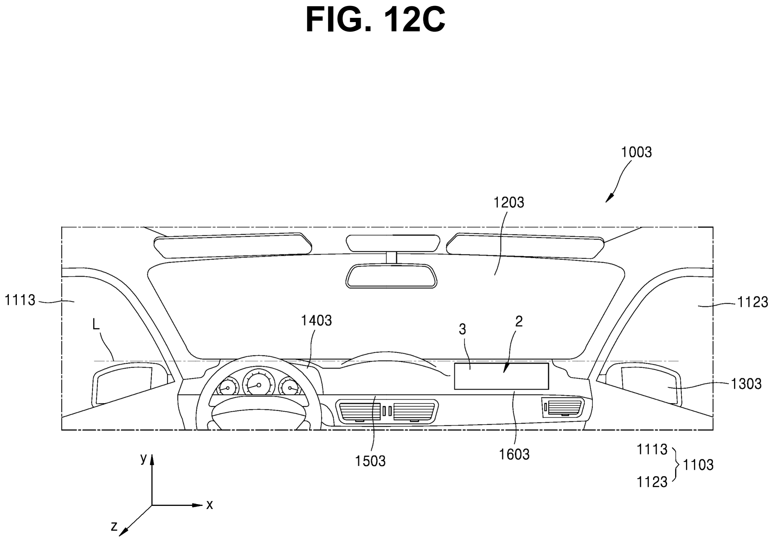

Referring to FIGS. 11, 12A, 12B, and 12C, the vehicle 1003 may refer to one or more suitable devices that move a transport object, such as a human, an object, or an animal, from a starting point to a destination. The vehicle 1003 may include a vehicle traveling on a road or a track, a vessel moving over the sea or a river, an airplane flying in the sky using the action of air, and/or the like.

In one or more embodiments, the vehicle 1003 may travel on roads or tracks. The vehicle 1003 may move in a preset direction according to the rotation of at least one wheel thereof. For example, the vehicle 1003 may include a three-wheeled or four-wheeled vehicle, a construction machine, a two-wheeled vehicle, a prime mover device, a bicycle, or a train running on a track.

The vehicle 1003 may include a body having an interior and an exterior, and a chassis in which mechanical apparatuses necessary for driving are installed as other parts except for the body. The exterior of the body of the vehicle 1003 may include a front panel, a bonnet, a roof panel, a rear panel, a trunk, a pillar provided at a boundary between doors, and/or the like. The chassis of the vehicle 1003 may include a power generation device, a power transmission device, a driving device, a steering device, a braking device, a suspension device, a transmission device, a fuel device, front, rear, left, and right wheels, and/or the like.

The vehicle 1003 may include a side window glass 1103, a front window glass 1203, a side mirror 1303, a cluster 1403, a center fascia 1503, a passenger seat dashboard 1603, and a display device 2.

The side window glass 1103 and the front window glass 1203 may be partitioned by a pillar positioned between the side window glass 1103 and the front window glass 1203.

The side window glass 1103 may be installed on a side of the vehicle 1003. In one or more embodiments, the side window glass 1103 may be installed on a door of the vehicle 1003. The side window glass 1103 may be provided in a plurality and may face each other. In one or more embodiments, the side window glass 1103 may include a first side window glass 1113 and a second side window glass 1123. In one or more embodiments, the first side window glass 1113 may be positioned adjacent to the cluster 1403. The second side window glass 1123 may be positioned adjacent to the passenger seat dashboard 1603.

In one or more embodiments, the side window glasses 1103 may be spaced apart from each other in an x direction or a -x direction (the direction opposite the x-direction). For example, in one or more embodiments, the first side window glass 1113 and the second side window glass 1123 may be spaced apart from each other in the x direction or the -x direction. For example, an imaginary straight line L connecting the side window glasses 1103 may extend in the x direction or the -x direction. For example, in one or more embodiments, an imaginary straight line L connecting the first side window glass 1113 and the second side window glass 1123 to each other may extend in the x direction or the -x direction.

The front window glass 1203 may be installed at the front of the vehicle 1003. The front window glass 1203 may be placed between the side window glasses 1103 opposite to (e.g., facing) each other.

The side mirror 1303 may provide a rear view of the vehicle 1003. The side mirror 1303 may be installed on the exterior of the body of the vehicle 1003. In one or more embodiments, the side mirror 1303 may be provided in a plurality. Any one of the plurality of side mirrors 1303 may be positioned on the outside of the first side window glass 1113. Another one of the plurality of side mirrors 1303 may be positioned on the outside of the second side window glass 1123.

The cluster 1403 may be located in front of the steering wheel. The cluster 1403 may include a tachometer, a speedometer, a coolant thermometer, a fuel gauge, a turn indicator, a high beam indicator, a warning light, a seat belt warning light, an odometer, a tachograph, an automatic shift selector indicator, a door open warning light, an engine oil warning light, and/or a low fuel warning light.

The center fascia 1503 may include a control panel having a plurality of buttons for adjusting audio, air conditioning, and/or seat heaters. The center fascia 1503 may be positioned on one side of the cluster 1403.

The passenger seat dashboard 1603 may be separated from the cluster 1403 with the center fascia 1503 therebetween. In one or more embodiments, the cluster 1403 may be arranged to correspond to a driver seat, and the passenger seat dashboard 1603 may be arranged to correspond to a passenger seat. In one or more embodiments, the cluster 1403 may be adjacent to the first side window glass 1113, and the passenger seat dashboard 1603 may be adjacent to the second side window glass 1123.

In one or more embodiments, the display device 2 may include a display panel 3, and the display panel 3 may display an image. The display device 2 may be placed inside the vehicle 1003. In one or more embodiments, the display device 2 may be placed between the side window glasses 1103 opposite to (e.g., facing) each other. The display device 2 may be placed on at least one of the cluster 1403, the center fascia 1503, or the passenger seat dashboard 1603.

The display device 2 may include an organic light-emitting display, an inorganic light-emitting display, a quantum dot display, and/or the like.

Referring to FIG. 12A, in one or more embodiments, the display device 2 may be placed in the center fascia 1503. In one or more embodiments, the display device 2 may display navigation information. In one or more embodiments, the display device 2 may display information regarding audio settings, video setting, and/or vehicle settings.

Referring to FIG. 12B, in one or more embodiments, the display device 2 may be placed in the cluster 1403. In these embodiments, the cluster 1403 may express operating information, and/or the like by the display device 2. For example, the cluster 1403 may be implemented digitally. The cluster 1403 implemented digitally may display vehicle information and driving information in the form of images. In one or more embodiments, a needle and a gauge of a tachometer and one or more suitable warning light icons may be displayed by a digital signal.

Referring to FIG. 12C, in one or more embodiments, the display device 2 may be placed on the passenger seat dashboard 1603. The display device 2 may be embedded in or positioned on the passenger seat dashboard 1603. In one or more embodiments, the display device 2 positioned on the passenger seat dashboard 1603 may display an image related to information displayed on the cluster 1403 and/or information displayed on the center fascia 1503. In one or more embodiments, the display device 2 arranged on the passenger seat dashboard 1603 may display information different from information displayed on the cluster 1403 and/or information displayed on the center fascia 1503.

### Definition of Terms

The term "C₃-C₆₀ carbocyclic group" as used herein refers to a cyclic group including (e.g., consisting of) carbon atoms as the only ring-forming atoms and having 3 to 60 carbon atoms.

The term "C₁-C₆₀ heterocyclic group" as used herein refers to a cyclic group that has 1 to 60 carbon atoms and further has, in addition to carbon atoms, a heteroatom as a ring-forming atom.

The C₃-C₆₀ carbocyclic group and the C₁-C₆₀ heterocyclic group may each be a monocyclic group including (e.g., consisting of) one (e.g., exactly one) ring or a polycyclic group in which two or more rings are condensed with each other. In one or more embodiments, the number of ring-forming atoms of the C₁-C₆₀ heterocyclic group may be 3 to 61.

The term "cyclic group" as used herein may include both (e.g., simultaneously) the C₃-C₆₀ carbocyclic group and the C₁-C₆₀ heterocyclic group.

The term "π electron-rich C₃-C₆₀ cyclic group" as used herein refers to a cyclic group that has 3 to 60 carbon atoms and does not include *-N=*' as a ring-forming moiety.

The term "the π electron-deficient nitrogen-containing C₁-C₆₀ heterocyclic group" as used herein refers to a heterocyclic group having 1 to 60 carbon atoms and including *-N=*' as a ring-forming moiety.

In one or more embodiments,
the C₃-C₆₀ carbocyclic group may be i) Group T1 or ii) a condensed cyclic group in which two or more of Group T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) Group T2, ii) a condensed cyclic group in which two or more of Group T2 are condensed with each other, or iii) a condensed cyclic group in which at least one Group T2 and at least one Group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, a xanthene group, and/or the like).

The π electron-rich C₃-C₆₀ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like).

The π electron-deficient nitrogen-containing C₁-C₆₀ heterocyclic group may be i) Group T4, ii) a condensed cyclic group in which two or more Groups T4 are condensed with each other, iii) a condensed cyclic group in which at least one Group T4 and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like).

Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group.

Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group.

Group T3 may be a furan group, a thiophene group, a 1H-pyrrole group, a silole group, or a borole group.

Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The term " cyclic group," "C₃-C₆₀ carbocyclic group," "C₁-C₆₀ heterocyclic group," "π electron-rich C₃-C₆₀ cyclic group", or "π electron-deficient nitrogen-containing C₁-C₆₀ heterocyclic group" as used herein may, depending on the structure of the chemical formula in which the term is used, be i) a group condensed to any cyclic group (for example, a benzo group, a naphtho group, and/or the like), ii) a monovalent group, or iii) a polyvalent group (for example, a divalent group, a trivalent group, a tetravalent group, and/or the like).

In one or more embodiments, the "benzene group" may be a benzo group, a phenyl group, a phenylene group, and/or the like, which may be easily understood by those of ordinary skill in the art according to the structure of a formula including the "benzene group."

Non-limiting examples of the monovalent C₃-C₆₀ carbocyclic group and monovalent C₁-C₆₀ heterocyclic group are a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group.

Non-limiting examples of the divalent C₃-C₆₀ carbocyclic group and the divalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a divalent non-aromatic condensed heteropolycyclic group.

The term "C₁-C₆₀ alkyl group" as used herein refers to a linear or branched aliphatic monovalent hydrocarbon group that has one to sixty carbon atoms, and non-limiting examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group.

The term "C₁-C₆₀ alkylene group" as used herein refers to a divalent group having substantially the same structure as the C₁-C₆₀ alkyl group.

The term "C₂-C₆₀ alkenyl group" as used herein refers to a monovalent hydrocarbon group having at least one carbon-carbon double bond in the middle or at the terminus of a C₂-C₆₀ alkyl group, and non-limiting examples thereof include an ethenyl group, a propenyl group, and a butenyl group.

The term "C₂-C₆₀ alkenylene group" as used herein refers to a divalent group having substantially the same structure as the C₂-C₆₀ alkenyl group.

The term "C₂-C₆₀ alkynyl group" as used herein refers to a monovalent hydrocarbon group having at least one carbon-carbon triple bond in the middle or at the terminus of the C₂-C₆₀ alkyl group, and non-limiting examples thereof include an ethynyl group and a propynyl group.

The term "C₂-C₆₀ alkynylene group" as used herein refers to a divalent group having substantially the same structure as the C₂-C₆₀ alkynyl group.

The term "C₁-C₆₀ alkoxy group" as used herein refers to a monovalent group represented by -OA₁₀₁ wherein A₁₀₁ is a C₁-C₆₀ alkyl group, and non-limiting examples thereof include a methoxy group, an ethoxy group, and an isopropyloxy group.

The term "C₃-C₁₀ cycloalkyl group" as used herein refers to a monovalent saturated hydrocarbon cyclic group having 3 to 10 carbon atoms, and non-limiting examples thereof may include a cyclopropyl group, a cyclobutyl group, a cyclopentyl group, a cyclohexyl group, a cycloheptyl group, a cyclooctyl group, an adamantanyl (i.e., adamantyl) group, a norbornanyl (i.e., norbornyl) group (or bicyclo[2.2.1]heptyl group), a bicyclo[1.1.1]pentyl group, a bicyclo[2.1.1]hexyl group, a bicyclo[2.2.2]octyl group, and/or the like.

The term "C₃-C₁₀ cycloalkylene group" as used herein refers to a divalent group having substantially the same structure as the C₃-C₁₀ cycloalkyl group.

The term "C₁-C₁₀ heterocycloalkyl group" as used herein refers to a monovalent cyclic group that has one to ten carbon atoms and further includes, in addition to the carbon atoms, at least one heteroatom as a ring-forming atom, and non-limiting examples thereof include a 1,2,3,4-oxatriazolidinyl group, a tetrahydrofuranyl group, and a tetrahydrothiophenyl group.

The term "C₁-C₁₀ heterocycloalkylene group" as used herein refers to a divalent group having substantially the same structure as the C₁-C₁₀ heterocycloalkyl group.

The term "C₃-C₁₀ cycloalkenyl group" as used herein refers to a monovalent cyclic group that has three to ten carbon atoms and at least one carbon-carbon double bond in the ring thereof and no aromaticity, and non-limiting examples thereof include a cyclopentenyl group, a cyclohexenyl group, and a cycloheptenyl group.

The term "C₃-C₁₀ cycloalkenylene group" as used herein refers to a divalent group having substantially the same structure as the C₃-C₁₀ cycloalkenyl group.

The term "C₁-C₁₀ heterocycloalkenyl group" as used herein refers to a monovalent cyclic group that has one to ten carbon atoms, further includes, in addition to the carbon atoms, at least one heteroatom as a ring-forming atom, and has at least one double bond in the ring thereof. Non-limiting examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group.

The term "C₁-C₁₀ heterocycloalkenylene group" as used herein refers to a divalent group having substantially the same structure as the C₁-C₁₀ heterocycloalkenyl group.

The term "C₆-C₆₀ aryl group" as used herein refers to a monovalent group having a carbocyclic aromatic system of 6 to 60 carbon atoms.

The term "C₆-C₆₀ arylene group" as used herein refers to a divalent group having a carbocyclic aromatic system of 6 to 60 carbon atoms.

Non-limiting examples of the C₆-C₆₀ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group.

When the C₆-C₆₀ aryl group and the C₆-C₆₀ arylene group each include two or more rings, the two or more rings may be condensed with each other.

The term "C₁-C₆₀ heteroaryl group" as used herein refers to a monovalent group having a heterocyclic aromatic system of 1 to 60 carbon atoms, further including, in addition to carbon atoms, at least one heteroatom, as ring-forming atoms.

The term "C₁-C₆₀ heteroarylene group" as used herein refers to a divalent group having a heterocyclic aromatic system of 1 to 60 carbon atoms, further including, in addition to carbon atoms, at least one heteroatom, as ring-forming atoms.

Non-limiting examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group.

When the C₁-C₆₀ heteroaryl group and the C₁-C₆₀ heteroarylene group each include two or more rings, the two or more rings may be condensed with each other.

The term "monovalent non-aromatic condensed polycyclic group" as used herein refers to a monovalent group having two or more rings condensed with each other, only carbon atoms for example, eight to sixty carbon atoms as ring-forming atoms, and no aromaticity in its molecular structure when considered as a whole. Non-limiting examples of the monovalent non-aromatic condensed polycyclic group include an indenyl group, a fluorenyl group, a spiro-bifluorenyl group, a benzofluorenyl group, an indenophenanthrenyl group, and an indeno anthracenyl group.

The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more rings condensed with each other, further includes, in addition to carbon atoms for example, one to sixty carbon atoms, at least one heteroatom as a ring-forming atom, and has no aromaticity in its molecular structure when considered as a whole. Non-limiting examples of the monovalent non-aromatic condensed heteropolycyclic group may include a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group.

The term "divalent non-aromatic condensed heteropolycyclic group" as used herein refers to a divalent group having substantially the same structure as the monovalent non-aromatic condensed heteropolycyclic group.

The term "C₆-C₆₀ aryloxy group" as used herein indicates -OA₁₀₂ wherein A₁₀₂ is a C₆-C₆₀ aryl group.

The term "C₆-C₆₀ arylthio group" as used herein indicates -SA₁₀₃ wherein A₁₀₃ is a C₆-C₆₀ aryl group.

The term "C₇-C₆₀ arylalkyl group" as used herein refers to -A₁₀₄A₁₀₅ wherein A₁₀₄ is a C₁-C₅₄ alkylene group, and A₁₀₅ is a C₆-C₅₉ aryl group.

The term "C₂-C₆₀ heteroarylalkyl group" as used herein refers to -A₁₀₆A₁₀₇ wherein A₁₀₆ is a C₁-C₅₉ alkylene group, and A₁₀₇ is a C₁-C₅₉ heteroaryl group.
As used herein, the term "C₃-C₆₀ carbocyclic group" includes a C₃-C₅₀ carbocyclic group, a C₃-C₄₀ carbocyclic group, a C₃-C₃₀ carbocyclic group, a C₃-C₂₀ carbocyclic group, or a C₃-C₁₀ carbocyclic group;
The term "C₁-C₆₀ heterocyclic group" includes a C₁-C₅₀ heterocyclic group, a C₁-C₄₀ heterocyclic group, a C₁-C₃₀ heterocyclic group, a C₁-C₂₀ heterocyclic group, or a C₁-C₁₀ heterocyclic group;
The term "C₁-C₆₀ alkyl group" includes a C₁-C₅₀ alkyl group, a C₁-C₄₀ alkyl group, a C₁-C₃₀ alkyl group, a C₁-C₂₀ alkyl group, or a C₁-C₁₀ alkyl group;
The term "C₂-C₆₀ alkenyl group" includes a C₂-C₃₀ alkenyl group, a C₂-C₂₀ alkenyl group, or a C₂-C₁₀ alkenyl group;
The term "C₂-C₆₀ alkynyl group" includes a C₂-C₃₀ alkynyl group, a C₂-C₂₀ alkynyl group, or a C₂-C₁₀ alkynyl group;
The term "C₁-C₆₀ alkoxy group" includes a C₁-C₃₀ alkoxy group, a C₁-C₂₀ alkoxy group, or a C₁-C₁₀ alkoxy group;
The term "C₆-C₆₀ aryl group" includes a C₆-C₅₀ aryl group, a C₆-C₄₀ aryl group, a C₆-C₃₀ aryl group, a C₆-C₂₀ aryl group, or a C₆-C₁₅ aryl group;
The term "C₁-C₆₀ heteroaryl group" includes a C₁-C₅₀ heteroaryl group, a C₁-C₄₀ heteroaryl group, a C₁-C₃₀ heteroaryl group, a C₁-C₂₀ heteroaryl group, or a C₁-C₁₀ heteroaryl group;
The term "monovalent non-aromatic condensed polycyclic group" includes a C₈-C₆₀ monovalent non-aromatic condensed polycyclic group, a C₈-C₅₀ monovalent non-aromatic condensed polycyclic group, a C₈-C₄₀ monovalent non-aromatic condensed polycyclic group, a C₈-C₃₀ monovalent non-aromatic condensed polycyclic group, or a C₈-C₂₀ monovalent non-aromatic condensed polycyclic group;
The term "monovalent non-aromatic condensed heteropolycyclic group" includes a C₁-C₆₀ monovalent non-aromatic condensed heteropolycyclic group, a C₁-C₅₀ monovalent non-aromatic condensed heteropolycyclic group, a C₁-C₄₀ monovalent non-aromatic condensed heteropolycyclic group, a C₁-C₃₀ monovalent non-aromatic condensed heteropolycyclic group, or a C₁-C₂₀ monovalent non-aromatic condensed heteropolycyclic group;
The term "C₆-C₆₀ aryloxy group" includes a C₆-C₅₀ aryloxy group, a C₆-C₄₀ aryloxy group, a C₆-C₃₀ aryloxy group, a C₆-C₂₀ aryloxy group, or a C₆-C₁₅ aryloxy group;
The term "C₆-C₆₀ arylthio group" includes a C₆-C₅₀ arylthio group, a C₆-C₄₀ arylthio group, a C₆-C₃₀ arylthio group, a C₆-C₂₀ arylthio group, or a C₆-C₁₅ arylthio group;
The term "C₇-C₆₀ arylalkyl group" includes a C₇-C₅₀ arylalkyl group, a C₇-C₄₀ arylalkyl group, a C₇-C₃₀ arylalkyl group, a C₇-C₂₀ arylalkyl group, or a C₇-C₁₅ arylalkyl group; and
The term "C₂-C₆₀ heteroarylalkyl group" includes a C₂-C₅₀ heteroarylalkyl group, a C₂-C₄₀ heteroarylalkyl group, a C₂-C₃₀ heteroarylalkyl group, a C₂-C₂₀ heteroarylalkyl group, or a C₂-C₁₅ heteroarylalkyl group.

The term "R₁₀ₐ" as used herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), - C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

For example, "R_{10a"} in this disclosure may be:
deuterium (-D), -F, or a cyano group;
a C₁-C₆₀ alkyl group, a C₂-C₆₀ alkenyl group, or a C₁-C₆₀ alkoxy group, each unsubstituted or substituted with deuterium, -F, a cyano group, a C₃-C₁₀ cycloalkyl group, or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, or any combination thereof, each unsubstituted or substituted with a deuterium, -F, a cyano group, a C₁-C₆₀ alkyl group, a C₂-C₆₀ alkenyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group; or
-Si(Q₃₁)(Q₃₂)(Q₃₃).

In the present disclosure, Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, a pyridinyl group, a pyrimidinyl group, a pyridazinyl group, a pyrazinyl group, a triazinyl group, or any combination thereof.

For example, in the present disclosure, Q₁ to Q₃, Q₁₁ to Q₁₃, Q₂₁ to Q₂₃ and Q₃₁ to Q₃₃ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, a pyridinyl group, a pyrimidinyl group, a pyridazinyl group, a pyrazinyl group, or a triazinyl group, each unsubstituted or substituted with deuterium, a C₁-C₁₀ alkyl group, a phenyl group, a biphenyl group, a pyridinyl group, a pyrimidinyl group, a pyridazinyl group, a pyrazinyl group, a triazinyl group, or any combination thereof.

The term "heteroatom" as used herein refers to any atom other than a carbon atom or a hydrogen atom. Non-limiting examples of the heteroatom include O, S, N, P, Si, B, Ge, Se, or any combination thereof.

The transition metal in this disclosure may include hafnium (Hf), tantalum (Ta), tungsten (W), rhenium (Re), osmium (Os), iridium (Ir), platinum (Pt), and gold (Au).

In this disclosure, "D" may refer to deuterium, "Ph" may refer to a phenyl group, "Me" may refer to a methyl group, "Et" may refer to an ethyl group, "tert-Bu", "tBu" or "Bu^{t}" may refer to a tert-butyl group, and "OMe" may refer to a methoxy group.

The term "biphenyl group" as used herein refers to "a phenyl group that is substituted with a phenyl group." For example, the "biphenyl group" may be a substituted phenyl group having a C₆-C₆₀ aryl group as a substituent.

The term "terphenyl group" as used herein refers to "a phenyl group substituted with a biphenyl group." The term "terphenyl group" as used herein may refer to i) a substituted phenyl group wherein the substituent is a C₆-C₆₀ aryl group substituted with a C₆-C₆₀ aryl group, and ii) a substituted phenyl group wherein two substituents are present, and each substituent is a C₆-C₆₀ aryl group.

* and *' as used herein, unless defined otherwise, each refer to a binding site to a neighboring atom in a corresponding formula or moiety.

The terms "x-axis", "y-axis", and "z-axis" as used herein are not limited to three axes in an orthogonal coordinate system, and may be interpreted in a broader sense than the aforementioned three axes in an orthogonal coordinate system. For example, the x-axis, y-axis, and z-axis may describe axes that are orthogonal to each other, or may describe axes that are in different directions that are not orthogonal to each other.

In the specification, "an integer selected from 0 to 20" refers to an integer selected from 0, 1, 2, 3, 4, 5, 6, 7, 8, 9, 10, 11, 12, 13, 14, 15, 16, 17, 18, 19, and 20. The above description of numerical ranges is also applicable for any other numerical range that appears in the present specification, for example, an integer selected from 0 and 1, an integer selected from 0 to 2, an integer selected from 0 to 3, an integer selected from 0 to 4, an integer selected from 0 to 5, an integer selected from 0 to 6, an integer selected from 0 to 7, an integer selected from 0 to 8, an integer selected from 0 to 9, an integer selected from 0 to 10, an integer selected from 0 to 11, an integer selected from 0 to 12, an integer selected from 0 to 13, an integer selected from 0 to 14, an integer selected from 0 to 15, an integer selected from 0 to 16, an integer selected from 0 to 17, an integer selected from 0 to 18, an integer selected from 0 to 19, and the like.

The HOMO energy level (negative value) in this disclosure may be measured using differential pulse voltammetry (DPV) equipment. For example, the HOMO energy level in this disclosure may be measured according to the following method: (1) Differential pulse voltammetry (DPV) (electrolyte: 0.1 M Bu₄NPF₆ in methylene chloride (MC), pulse height: 50 mV, pulse width: 1 sec, step height: 10 mV, step width: 2 sec, scan rate: 5 mV/sec, reference electrode: Ag/AgNO₃) is used to obtain a potential(V)-current(mA) graph for each compound, after which the oxidation peak potential Eₚₑₐₖ(eV) of the graph is evaluated (if (e.g., when) the HOMO energy level range exceeds the solvent window, the solvent is changed and measured again) and (2) the Eₚₑₐₖ(eV) is substituted into the equation HOMO energy level (eV) = -4.8 - (Eₚₑₐₖ - Eₚₑₐₖ(Ferrocene)) to evaluate the HOMO energy level(eV) of each compound.

### Manufacture of organic light-emitting device (OLED) 1-1

As an anode, a glass substrate provided with ITO 300 Å / Ag 50 Å / ITO 300 Å was cut to a size of 50 mm x 50 mm x 0.7 mm, ultrasonically cleaned for 5 minutes each with isopropyl alcohol and pure water, cleaned by irradiating with ultraviolet light for 30 minutes and exposing to ozone, and installed in a vacuum deposition apparatus.

Hexaazatriphenylenehexacarbonitrile (HAT-CN) was deposited on the anode to form a first hole injection layer having a thickness of 150 Å. Subsequently, 1,1-bis[4-[N,N-di(p-tolylamino)phenyl]cyclohexane] (TAPC) was deposited to form a first hole transport layer having a thickness of 400 Å. The HOMO energy level of TAPC is -5.3 eV.

On the first hole transport layer, HT-1, ET-1, BD-1, and D-01 were co-deposited as a first hole-transporting host, a first electron-transporting host, a first sensitizer, and a first emitter, respectively, to form a first emission layer having a thickness of 400 Å. In this regard, D-01 is a thermally activated delayed fluorescence material, the weight of the first hole-transporting host was 65 wt% based on 100 wt% of the sum of the weight of the first hole-transporting host and the weight of the first electron-transporting host, the weight of the first sensitizer was 13 wt% based on 100 wt% of the total weight of the first emission layer, and the weight of the first emitter was 1.5 wt% based on 100 wt% of the total weight of the first emission layer. The HOMO energy level of HT-1, which is the first hole-transporting host, is -5.5 eV.

On the first emission layer, 2,4,6-tris(3-(pyrimidin-5-yl)phenyl)-1,3,5-triazine (TPM-TAZ) and Liq were co-deposited in a weight ratio of 5:5 to form a first electron transport layer having a thickness of 300 Å, thereby forming a first stack.

On the first stack, BPhen and Li were co-deposited in a weight ratio of 98:2 to form an n-type (kind) charge-generation layer having a thickness of 100 Å, and on the n-type (kind) charge-generation layer, TAPC and F4-TCNQ were co-deposited in a weight ratio of 95:5 to form a p-type (kind) charge-generation layer having a thickness of 100 Å, thereby forming a first charge-generation layer.

On the first charge-generation layer, TAPC was deposited to form a second hole transport layer having a thickness of 400 Å, and on the second hole transport layer, HT-1 was deposited to form a second auxiliary layer having a thickness of 50 Å.

Next, on the second auxiliary layer, HT-1, ET-1, BD-1, and D-01 were co-deposited as a second hole-transporting host, a second electron-transporting host, a second sensitizer, and a second emitter, respectively, to form a second emission layer having a thickness of 400 Å. In this regard, D-01 is a thermally activated delayed fluorescence material, and the weight of the second hole-transporting host was 65 wt% based on 100 wt% of the sum of the weights of the second hole-transporting host and the second electron-transporting host, the weight of the second sensitizer was 13 wt% per 100 wt% of the total weight of the second emission layer, and the weight of the second emitter was 1.5 wt% based on 100 wt% of the total weight of the second emission layer.

On the second emission layer, TPM-TAZ and Liq were co-deposited in a weight ratio of 5:5 to form a second electron transport layer having a thickness of 300 Å, thereby forming a second stack.

On the second stack, Yb was vacuum deposited to 10 Å, and subsequently AgMg was vacuum deposited to 100 Å (Mg doping 5 wt%) to form a cathode, thereby completing the manufacture of a light-emitting device.

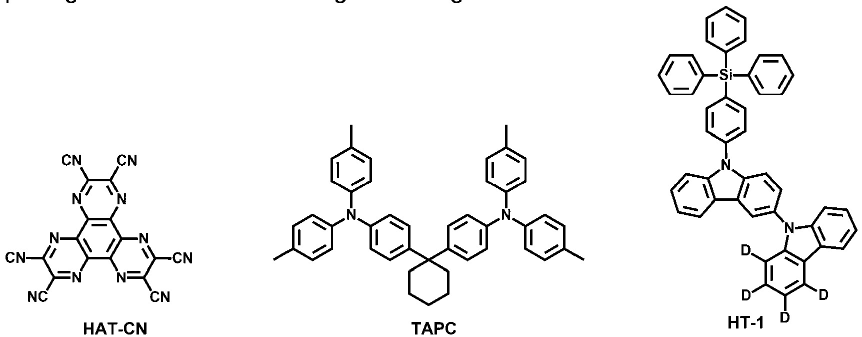

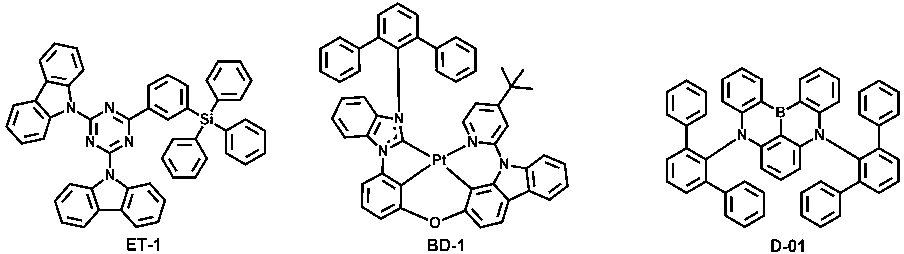

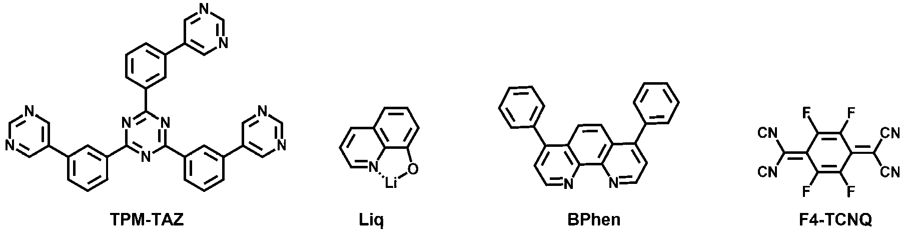

### Manufacture of OLEDs 1-2, 1-3 and 1-4

Light-emitting devices were each manufactured in substantially the same manner as used to manufacture OLED 1-1, except that the weight percentage of the first hole-transporting host in the first emission layer, the thickness of the first emission layer, and/or the thickness of the second emission layer were changed as shown in Table 1.

### OLED 1B

A light-emitting device was manufactured in substantially the same manner as used to manufacture OLED 1-1, except that in forming the first emission layer of the first stack, instead of HT-1, ET-1, BD-1, and D-01, ADN and FD-1 were co-deposited on the first hole transport layer to form a first emission layer having a thickness of 400 Å (the amount of FD-1 was 2 wt% based on 100 wt% of the total weight of the first emission layer), and in forming the second emission layer of the second stack, instead of HT-1, ET-1, BD-1, and D-01, ADN and FD-1 were co-deposited on the second auxiliary layer to form a second emission layer having a thickness of 400 Å (the amount of FD-1 was 2 wt% based on 100 wt% of the total weight of the second emission layer).

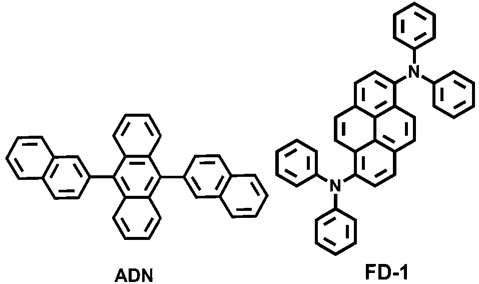

### OLED 1C

A light-emitting device was manufactured in substantially the same manner as used to manufacture OLED 1B, except that HT-1 was deposited on the first hole transport layer of the first stack to form a first auxiliary layer having a thickness of 50 Å, a first emission layer was formed on the first auxiliary layer, and a second emission layer was formed directly on the second hole transport layer of the second stack without forming the second auxiliary layer.

### Manufacture of OLED 2A

A light-emitting device was manufactured in substantially the same manner as used to manufacture OLED 1-1, except that HT-1 was deposited on the first hole transport layer of the first stack to form a first auxiliary layer having a thickness of 50 Å, and then a first emission layer was formed on the first auxiliary layer.

### Evaluation Example 1

In order to evaluate the characteristics of each of OLED 1-1, 1-2, 1-3, 1-4, 1B, 1C, and 2A, the driving voltage (V), luminescence efficiency (cd/A/y), power efficiency (Cd/W), lifespan (hr), and emission peak wavelength at 1000 nit were measured and evaluated using a source meter (Keithley Instrument, 2400 series), a luminance meter PR650, and an optical spectrometer (SR-3), and results are summarized in Table 2. The lifespan (T₉₅) is measured as the time required to reach 95% of the initial brightness, and the relative values (%) with respect to the lifespan of OLED 2A are summarized in Table 2. In Table 1, the weight percentage of the first hole-transporting host represents the weight percentage of the first hole-transporting host with respect to the total weight of the host included in the first emission layer, and the weight percentage of the second hole-transporting host represents the weight percentage of the second hole-transporting host with respect to the total weight of the host included in the second emission layer.

**Table 1**

| OL ED No . | First stack | | | | | | Second stack | | | | | |
|---|---|---|---|---|---|---|---|---|---|---|---|---|
| | First hole tran sport layer | First auxili ary layer | First emission layer | | | | Sec ond hole tran sport layer | Seco nd auxili ary layer | Second emission layer | | | |
| | | | Wei ght perc enta ge (wt %) of first hole - tran spor ting host | First sen sitiz er | First emit ter | Thi ck ne ss (Å) | | | Wei ght perc enta ge (wt %) of sec ond hole - tran spor ting host | Sec ond sen sitiz er | Sec ond emit ter | Thick ness (Å) |
| 1-1 | TAP C | - | 65 | BD-1 | D-01 | 40 0 | TAP C | HT-1 | 65 | BD-1 | D-01 | 400 |
| 1-2 | TAP C | - | 75 | BD-1 | D-01 | 40 0 | TAP C | HT-1 | 65 | BD-1 | D-01 | 400 |
| 1-3 | TAP C | - | 75 | BD-1 | D-01 | 35 0 | TAP C | HT-1 | 65 | BD-1 | D-01 | 450 |
| 1-4 | TAP C | - | 75 | BD-1 | D-01 | 30 0 | TAP C | HT-1 | 65 | BD-1 | D-01 | 450 |
| 1B | TAP C | - | 100 | - | FD-1 | 40 0 | TAP C | HT-1 | 100 | - | FD-1 | 400 |
| 1C | TAP C | HT-1 | 100 | - | FD-1 | 40 0 | TAP C | - | 100 | - | FD-1 | 400 |
| 2A | TAP C | HT-1 | 65 | BD-1 | D-01 | 40 0 | TAP C | HT-1 | 65 | BD-1 | D-01 | 400 |

**Table 2**

| OLED No. | Driving voltage (V) | Luminesce nce efficiency (cd/A/y) | Power efficiency (Cd/W) | **Lifespan** (T₉₅) (relative value, %) | Emission peak wavelength (nm) |
|---|---|---|---|---|---|
| 1-1 (Example) | 6.8 | 830 | 122.0 | 220 | 461 |
| 1-2 (Example) | 6.8 | 830 | 122.0 | 225 | 461 |
| 1-3 (Example) | 6.8 | 830 | 122.0 | 250 | 461 |
| 1-4 (Example) | 6.6 | 820 | 124.0 | 220 | 461 |
| 1B (Comparative Example) | 6.8 | 190 | 27.9 | 120 | 459 |
| 1C (Comparative Example) | 7.0 | 180 | 25.7 | 80 | 459 |
| 2A (Comparative Example) | 7.0 | 800 | 114.3 | 100 | 461 |

According to Table 2, OLEDs 1-1, 1-2, 1-3, and 1-4, which are examples each satisfying Condition 1, can be confirmed to have the same or improved driving voltage, improved luminescence efficiency, improved power efficiency, and improved lifespan characteristics compared to OLEDs 1B, 1C, and 2A, which are comparative examples.

### Manufacture of OLED 2-1

A light-emitting device was manufactured in substantially the same manner as used to manufacture OLED 2A, except that the second emission layer was formed directly on the second hole transport layer without forming the second auxiliary layer.

### Manufacture of OLED 2-2

A light-emitting device was manufactured in substantially the same manner as used to manufacture OLED 2-1, except that the weight percentage of the second hole-transporting host in the second emission layer and the thickness of the second emission layer were changed as shown in Table 3.

### Manufacture of OLED 3-1

A light-emitting device was manufactured in substantially the same manner as used to manufacture OLED 1-1, except that the second emission layer was formed directly on the second hole transport layer without forming the second auxiliary layer.

### Manufacture of OLED 3-2

A light-emitting device was manufactured in substantially the same manner as used to manufacture OLED 3-1, except that the weight percentage of the first hole-transporting host in the first emission layer, the thickness of the first emission layer, the weight percentage of the second hole-transporting host in the second emission layer, and the thickness of the second emission layer were changed as shown in Table 3.

### Evaluation Example 2

The lifespans of OLEDs 2-1, 2-2, 3-1, and 3-2 were each evaluated in substantially the same manner as used in Evaluation Example 1, and the results of lifespan are summarized in Table 4 as relative values (%) with respect to the lifespan of OLED 2A. For comparison, the lifespan data of OLED 1-1 and OLED 2A are also summarized in Table 4. In Table 3, the weight percentage of the first hole-transporting host represents the weight percentage of the first hole-transporting host with respect to the total weight of the host included in the first emission layer, and the weight percentage of the second hole-transporting host represents the weight percentage of the second hole-transporting host with respect to the total weight of the host included in the second emission layer.

**Table 3**

| OL ED No . | First stack | | | | | | Second stack | | | | | |
|---|---|---|---|---|---|---|---|---|---|---|---|---|
| | First hole tran spor t laye r | First auxili ary layer | First emission layer | | | | Sec ond hole tran spor t laye r | Seco nd auxili ary layer | Second emission layer | | | |
| | | | Wei ght perc enta ge (wt %) of first hole - tran spor ting host | First sen sitiz er | First emit ter | **Thi** ck **ne** ss (Å) | | | Wei ght perc enta ge (wt %) of sec ond hole - tran spor ting host | Sec ond sen sitiz er | Sec ond emit ter | Thick ness (Å) |
| 2-1 | TAP C | HT-1 | 65 | BD-1 | D-01 | 40 0 | TAP C | - | 65 | BD-1 | D-01 | 400 |
| 2-2 | TAP C | HT-1 | 65 | BD-1 | D-01 | 40 0 | TAP C | - | 75 | BD-1 | D-01 | 450 |
| 3-1 | TAP C | - | 65 | BD-1 | D-01 | 40 0 | TAP C | - | 65 | BD-1 | D-01 | 400 |
| 3-2 | TAP C | - | 75 | BD-1 | D-01 | 45 0 | TAP C | - | 70 | BD-1 | D-01 | 450 |

**Table 4**

| OLED No. | Lifespan (T₉₅) (relative value, %) |
|---|---|
| 1-1 (Example) | 220 |
| 2-1 (Example) | 200 |
| 2-2 (Example) | 220 |
| 3-1 (Example) | 190 |
| 3-2 (Example) | 209 |
| 2A (Comparative Example) | 100 |

According to Table 4, it can be confirmed that OLEDs 2-1 and 2-2, which are examples each satisfying Condition 2, and OLEDs 3-1 and 3-2, which are examples each satisfying both (e.g., simultaneously) Condition 1 and Condition 2, each have excellent or suitable lifespan characteristics at a similar level to OLED 1-1, which is an example satisfying Condition 1.

A light-emitting device satisfying at least one of Condition 1 and Condition 2 has a low driving voltage, high luminescence efficiency, high power efficiency, and/or a long lifespan, and thus a high-quality display device and/or electronic device can be manufactured using the same.

In the context of the present application and unless otherwise defined, the terms "use," "using," and "used" may be considered synonymous with the terms "utilize," "utilizing," and "utilized," respectively.

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, or 5% of the stated value.

Also, it should be understood that, even if the terms "about," "approximately," or "substantially" are not expressly recited in a given claim element, the scope of such claim element is intended to include variations that are insubstantial or within the understanding of one of ordinary skill in the art. For example, numerical values and ranges provided herein are intended to include tolerances and measurement uncertainties that would be recognized by those skilled in the art, and the claims should be construed accordingly to encompass such equivalents.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in the present disclosure is intended to include all higher numerical limitations subsumed therein. Accordingly, Applicant reserves the right to amend the disclosure, including the claims, to expressly recite any sub-range subsumed within the ranges expressly recited herein.

The light-emitting device, the display device, the electronic apparatus, the electronic device/equipment, the manufacturing apparatus thereof, or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random-access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

It should be understood that embodiments described herein should be considered in a descriptive sense only and not for purposes of limitation. Descriptions of features or aspects in each embodiment should typically be considered as available for other similar features or aspects in other embodiments. While one or more embodiments have been described with reference to the drawings, it will be understood by those of ordinary skill in the art that one or more suitable changes in form and details may be made therein without departing from the scope as defined by the following claims and equivalents thereof.

## Claims

1. A light-emitting device (10) comprising:
a first electrode (110);
a second electrode (150) opposite to the first electrode (110); and
an interlayer (130) between the first electrode (110) and the second electrode (150), wherein
the interlayer (130) comprises a first stack (ST1), a second stack (ST2), and a charge-generation layer (CGL),
the charge-generation layer (CGL) is between the first stack (ST1) and the second stack (ST2),
the first stack (ST1) comprises a first emission layer (133-1) and a first hole transport region (131-1),
the first hole transport region (131-1) is between the first emission layer (133-1) and the first electrode (110),
the second stack (ST2) comprises a second emission layer (133-2) and a second hole transport region (131-2),
the second emission layer (133-2) is between the second hole transport region (131-2) and the second electrode (150),
the first emission layer (133-1) comprises a first hole-transporting host, a first electron-transporting host, a first sensitizer, and a first thermally activated delayed fluorescence emitter,
the second emission layer (133-2) comprises a second hole-transporting host, a second electron-transporting host, a second sensitizer, and a second thermally activated delayed fluorescence emitter, and
the light-emitting device (10) satisfies at least one selected from among Condition 1 and Condition 2:
**Condition 1**
in the first emission layer (133-1), a weight of the first hole-transporting host is greater than a weight of the first electron-transporting host,
the first hole transport region (131-1) comprises a first hole transport layer (131-1A) in direct contact with the first emission layer (133-1),
the first hole transport layer (131-1A) comprises a first hole-transporting (HT) material,
the first HT material is different from the first hole-transporting host, and
an absolute value of a difference between a highest occupied molecular orbital (HOMO) energy level of the first HT material and a HOMO energy level of the first hole-transporting host is 0.1 eV to 0.35 eV; and
**Condition 2**
in the second emission layer (133-2), a weight of the second hole-transporting host is greater than a weight of the second electron-transporting host,
the second hole transport region (131-2) comprises a second hole transport layer (131-2A) in direct contact with the second emission layer (133-2),
the second hole transport layer (131-2A) comprises a second HT material,
the second HT material is different from the second hole-transporting host, and
an absolute value of a difference between a HOMO energy level of the second HT material and a HOMO energy level of the second hole-transporting host is 0.1 eV to 0.35 eV.

2. The light-emitting device (10) of claim 1, wherein
the light-emitting device (10) satisfies Condition 1,
the first emission layer (133-1) has an exciton concentration profile represented by C1(x1), which is an exciton concentration at a position spaced apart by x1 Å from an interface between the first emission layer (133-1) and the first hole transport layer (131-1A),
x1 is a variable that satisfies 0 Å ≤ x1 Å ≤ D1 Å,
D1 is a thickness of the first emission layer (133-1), and
a maximum value of C1(x1) exists in a region where x1 satisfies 0.5 x D1 Å ≤ x1 Å ≤ D1 Å of the exciton concentration profile.

3. The light-emitting device (10) of claim 1 or claim 2, wherein
the light-emitting device (10) satisfies Condition 2,
the second emission layer (133-2) has an exciton concentration profile represented by C2(x2), which is an exciton concentration at a position spaced apart by x2 Å from an interface between the second emission layer (133-2) and the second hole transport layer (131-2A),
x2 is a variable that satisfies 0 Å ≤ x2 Å ≤ D2 Å,
D2 is a thickness of the second emission layer (133-2), and
a maximum value of C2(x2) exists in a region where x2 satisfies 0.5 x D2 Å ≤ x2 Å ≤ D2 Å of the exciton concentration profile.

4. The light-emitting device (10) of any one of claims 1 to 3, wherein:
(i) a thickness (D1) of the first emission layer (133-1) is 250 Å to 500 Å; and/or
(ii) a thickness (D2) of the second emission layer (133-2) is 250 Å to 500 Å; and/or
(iii) a thickness (D2) of the second emission layer (133-2) is equal to or greater than a thickness (D1) of the first emission layer (133-1).

5. The light-emitting device (10) of any one of claims 1 to 4, wherein
a weight of the first hole-transporting host in the first emission layer (133-1) is 60 wt% to 90 wt% based on 100 wt% of a sum of the weight of the first hole-transporting host and a weight of the first electron-transporting host.

6. The light-emitting device (10) of any one of claims 1 to 5, wherein
a weight of the first sensitizer is 5 wt% to 30 wt% based on 100 wt% of a total weight of the first emission layer (133-1), and
a weight of the first thermally activated delayed fluorescence emitter is 0.5 wt% to 10 wt% based on 100 wt% of the total weight of the first emission layer (133-1).

7. The light-emitting device (10) of any one of claims 1 to 6, wherein
a weight of the second hole-transporting host in the second emission layer (133-2) is 60 wt% to 90 wt% based on 100 wt% of a sum of the weight of the second hole-transporting host and a weight of the second electron-transporting host.

8. The light-emitting device (10) of any one of claims 1 to 7, wherein
a weight of the second sensitizer is 5 wt% to 30 wt% based on 100 wt% of a total weight of the second emission layer (133-2), and
a weight of the second thermally activated delayed fluorescence emitter is 0.5 wt% to 10 wt% based on 100 wt% of the total weight of the second emission layer (133-2).

9. The light-emitting device (10) of any one of claims 1 to 8, wherein
each of the first hole-transporting host and the second hole-transporting host is an amine-free compound, and
each of the first HT material of Condition 1 and the second HT material of Condition 2 is an amine-containing compound.

10. The light-emitting device (10) of any one of claims 1 to 9, wherein
each of the first sensitizer and the second sensitizer is an organometallic compound containing platinum or palladium.

11. The light-emitting device (10) of any one of claims 1 to 9, wherein
each of the first sensitizer and the second sensitizer is an organometallic compound comprising platinum or palladium and a tetradentate ligand bonded to the platinum or palladium, and
the tetradentate ligand comprises a carbene moiety bonded to the platinum or the palladium.

12. The light-emitting device (10) of any one of claims 1 to 11, wherein
each of the first thermally activated delayed fluorescence emitter and the second thermally activated delayed fluorescence emitter is a multiple resonance thermally activated delayed fluorescence emitter containing at least one boron.

13. The light-emitting device (10) of any one of claims 1 to 12, wherein:
(i) each of a first light emitted from the first emission layer (133-1) and a second light emitted from the second emission layer (133-2) is blue light; and/or
(ii) an absolute value of a difference between an emission peak wavelength of a first light emitted from the first emission layer (133-1) and an emission peak wavelength of a second light emitted from the second emission layer (133-2) is 0 nm to 20 nm.

14. A display device (10) comprising:
a substrate having a first region, a second region, and a third region which are spaced from one another;
a first light-emitting device (10R) comprising a first-1 electrode (110-R) positioned on the substrate in the first region, a first-2 electrode (150-R) opposite to the first-1 electrode (110-R), and a first interlayer between the first-1 electrode (110-R) and the first-2 electrode (150-R);
a second light-emitting device (10G) comprising a second-1 electrode (110-G) positioned on the substrate in the second region, a second-2 electrode (150-G) opposite to the second-1 electrode (110-G), and a second interlayer between the second-1 electrode (110-G) and the second-2 electrode (150-G); and
a third light-emitting device (10B) comprising a third-1 electrode (110-B) positioned on the substrate in the third region, a third-2 electrode (150-B) opposite to the third-1 electrode (110-B), and a third interlayer between the third-1 electrode (110-B) and the third-2 electrode (150-B), wherein,
the first interlayer comprises a first-1 stack (ST1-R), a first-2 stack (ST2-R), and a first charge-generation layer (CGL1-R),
the second interlayer comprises a second-1 stack (ST1-G), a second-2 stack (ST2-G), and a second charge-generation layer (CGL1-G),
the third interlayer comprises a third-1 stack (ST1-B), a third-2 stack (ST2-B), and a third charge-generation layer (CGL1-B),
the third charge-generation (CGL1-B) layer is between the third-1 stack (ST1-B) and the third-2 stack (ST2-B),
the third-1 stack (ST1-B) comprises a third-1 emission layer (133-1B) and a third-1 hole transport region (131-1B),
the third-1 hole transport region (131-1B) is between the third-1 emission layer (133-1B) and the third-1 electrode (110-B),
the third-2 stack (ST2-B) comprises a third-2 emission layer (133-2B) and a third-2 hole transport region (131-2B),
the third-2 emission layer (133-2B) is between the third-2 hole transport region (131-2B) and the third-2 electrode (150-B),
the third-1 emission layer (133-1B) comprises a third-1 hole-transporting host, a third-1 electron-transporting host, a third-1 sensitizer, and a third-1 thermally activated delayed fluorescence emitter,
the third-2 emission layer (133-2B) comprises a third-2 hole-transporting host, a third-2 electron-transporting host, a third-2 sensitizer, and a third-2 thermally activated delayed fluorescence emitter, and
the display device (10) satisfies at least one selected from among Condition 3-1 and Condition 3-2:
**Condition 3-1**
in the third-1 emission layer (133-1B), a weight of a third-1 hole-transporting host is greater than a weight of the third-1 electron-transporting host,
the third-1 hole transport region (131-1B) comprises a third-1 hole transport layer that is in direct contact with the third-1 emission layer (133-1B),
the third-1 hole transport layer comprises a third-1 HT material,
the third-1 HT material is different from the third-1 hole-transporting host, and
an absolute value of a difference between a highest occupied molecular orbital (HOMO) energy level of the third-1 HT material and a HOMO energy level of the third-1 hole-transporting host is 0.1 eV to 0.35 eV; and
**Condition 3-2**
in the third-2 emission layer (133-2B), a weight of the third-2 hole-transporting host is greater than a weight of the third-2 electron-transporting host,
the third-2 hole transport region (131-2B) comprises a third-2 hole transport layer in direct contact with the third-2 emission layer (133-2B),
the third-2 hole transport layer comprises a third-2 HT material,
the third-2 HT material is different from the third-2 hole-transporting host, and
an absolute value of a difference between a HOMO energy level of the third-2 HT material and a HOMO energy level of the third-2 hole-transporting host is 0.1 eV to 0.35 eV, optionally wherein
light emitted from the third light-emitting device (10B) is blue light.

15. An electronic device (1000) comprising:
a light-emitting device (10); and
a processor (1200) configured to transmit a signal to the light-emitting device (10),
wherein the light-emitting device (10) comprises:
a first electrode (110);
a second electrode (150) opposite to the first electrode (110); and
an interlayer (130) between the first electrode (110) and the second electrode (150), wherein
the interlayer (130) comprises a first stack (ST1), a second stack (ST2), and a charge-generation layer (CGL),
the charge-generation layer (CGL) is between the first stack (ST1) and the second stack (ST2),
the first stack (ST1) comprises a first emission layer (133-1) and a first hole transport region (131-1),
the first hole transport region (131-1) is between the first emission layer (133-1) and the first electrode (110),
the second stack (ST2) comprises a second emission layer (133-2) and a second hole transport region (131-2),
the second emission layer (133-2) is between the second hole transport region (131-2) and the second electrode (150),
the first emission layer (133-1) comprises a first hole-transporting host, a first electron-transporting host, a first sensitizer, and a first thermally activated delayed fluorescence emitter,
the second emission layer (133-2) comprises a second hole-transporting host, a second electron-transporting host, a second sensitizer, and a second thermally activated delayed fluorescence emitter, and
the light-emitting device (10) satisfies at least one selected from among Condition 1 and Condition 2:
**Condition 1**
in the first emission layer (133-1), a weight of the first hole-transporting host is greater than a weight of the first electron-transporting host,
the first hole transport region (131-1) comprises a first hole transport layer (131-1A) in direct contact with the first emission layer (133-1),
the first hole transport layer (131-1A) comprises a first hole-transporting (HT) material,
the first HT material is different from the first hole-transporting host, and
an absolute value of a difference between a highest occupied molecular orbital (HOMO) energy level of the first HT material and a HOMO energy level of the first hole-transporting host is 0.1 eV to 0.35 eV; and
**Condition 2**
in the second emission layer (133-2), a weight of the second hole-transporting host is greater than a weight of the second electron-transporting host,
the second hole transport region (131-2) comprises a second hole transport layer (131-2A) in direct contact with the second emission layer (133-2),
the second hole transport layer (131-2A) comprises a second HT material,
the second HT material is different from the second hole-transporting host, and
an absolute value of a difference between a HOMO energy level of the second HT material and a HOMO energy level of the second hole-transporting host is 0.1 eV to 0.35 eV, optionally wherein the electronic device (1000) is at least one of
a flat panel display, a curved display, a computer monitor, a medical monitor, a television, a billboard, an indoor light, an outdoor light, a light for signaling, a head-up display, a fully transparent display, a partially transparent display, a flexible display, a rollable display, a foldable display, a stretchable display, smart glasses, a head-mounted display, a smart watch, a laser printer, a telephone, a mobile phone, a tablet, a phablet, a personal digital assistant, a wearable device, a laptop computer, a digital camera, a camcorder, a viewfinder, a micro display, a three-dimensional (3D) display, a virtual reality display, an augmented reality display, a vehicle dashboard, a center information display, a vehicle head-up display, a rear-view mirror display, a video wall comprising multiple displays that are tiled together, a theater screen, a stadium screen, a light therapy device, or a signage.
